# EUROPEAN PATENT SPECIFICATION

(11) **EP 1 324 326 B1**
(45) Date of publication and mention of the grant of the patent: **30.11.2005**
(21) Application number: 02027377.7
(22) Date of filing: 09.12.2002
(51) Int. Cl.: G11B 7/24

(54) **Information recording medium and method for producing the same**
Informationsaufzeichnungsmedium und Verfahren zu dessen Herstellung
Milieu d' enregistrement d' information, et procédé pour sa fabrication

(30) Priority: 18.12.2001 JP 2001384306; 22.02.2002 JP 2002045661; 01.03.2002 JP 2002055872
(43) Date of publication of application: 02.07.2003
(73) Proprietor: MATSUSHITA ELECTRIC INDUSTRIAL CO., LTD., Kadoma-shi, Osaka-fu (JP)
(72) Inventor: Kojima, Rie, Kadoma-shi, Osaka-fu (JP); Nishihara, Takashi, Hirakata-shi, Osaka-fu (JP); Habuta, Haruhiko, Osaka-shi, Osaka-fu (JP); Yamada, Noboru, Hirakata-shi, Osaka-fu (JP)
(74) Representative: Ehlers, Jochen

(56) References cited:
- US-A- 4 763 139
- DATABASE WPI Section Ch, Week 199112 Derwent Publications Ltd., London, GB; Class A12, AN 1991-083936 XP002235835 & JP 03 030133 A (NEC CORP), 8 February 1991 (1991-02-08)
- DATABASE WPI Section Ch, Week 198745 Derwent Publications Ltd., London, GB; Class A12, AN 1987-316032 XP002235836 & JP 62 222454 A (SEIKO EPSON), 30 September 1987 (1987-09-30)

## Description

### BACKGROUND OF THE INVENTION

### Field of the Invention

This invention relates to an information recording medium which is used for optically or electrically recording, erasing, overwriting and reproducing information, and a method for producing the same.

### Description of Related Art

The inventors developed 4.7GB DVD-RAM which is a large capacity rewritable phase-change type information recording medium and can be used as a datafile and an image file. This has been already commercialized.

This 4.7GB DVD-RAM is disclosed, for example, in Japanese Patent Kokai (Laid-Open) Publication No. 2001-322357. The constitution of DVD-RAM disclosed in this publication is shown in Figure 10. The information recording medium 31 shown in Figure 10 has a seven-layer structure where a first dielectric layer 102, a first interface layer 103, a recording layer 4, a second interface layer 105, a second dielectric layer 106, an optical compensation layer 7, and a reflective layer 8 are formed on one surface of a substrate 1 in this order. In this information recording medium, the first dielectric layer exists in a position closer to an incident laser beam than the second dielectric layer. The same relationship exists between the first interface layer and the second interface layer. Thus, in this specification, when the information recording medium contains two or more layers having the same function, "first" "second" "third" ... is given to the beginning of the name of each layer in the order of the layer which is closer to the incident laser beam.

The first dielectric layer 102 and the second dielectric layer 106 have the function which adjusts an optical path length so as to enhance the optical absorption efficiency of the recording layer 4, and enlarges the difference between the reflectance of crystal phase and the reflectance of amorphous phase so as to enlarge a signal amplitude. ZnS-20 mol % SiO₂ (i.e. (SiO₂)₈₀(ZnS)₂₀) conventionally used as a material for the dielectric layer is amorphous material. It has low thermal conductivity, is transparent, and has a high refractive index. Moreover, ZnS-20 mol % SiO₂ exhibits a high film-forming speed at the time of the film formation, and good mechanical characteristic and moisture resistance. Thus, ZnS-20 mol % SiO₂ is an excellent material suitable for forming the dielectric layer.

If the thermal conductivity of the first dielectric layer 102 and the second dielectric layer 106 is low, the heat can diffuse from the recording layer 4 to the reflective layer 8 quickly in the thickness direction when a laser beam enters the recording layer 4, and therefore, in-plane heat diffusion in the dielectric layers 102 or 106 is suppressed. That is, the recording layer 4 is cooled by the dielectric layer for a shorter time, and therefore, an amorphous mark (record mark) can be easily formed. When a record mark is hard to form, a high peak power is necessary for recording. When a record mark is easy to form, recording can be conducted with a low peak power. When the thermal conductivity of the dielectric layer is low, recording can be conducted with a low peak power, and therefore, the recording sensitivity of the information recording medium becomes higher. On the other hand, when the thermal conductivity of the dielectric layer is high, recording is conducted with a high peak power, and therefore the recording sensitivity of the information recording medium becomes lower. The dielectric layer in the information recording medium exists in a form of such thin film that thermal conductivity cannot be measured accurately. For this reason, the inventors employ the recording sensitivity of the information recording medium as a relative judgment reference for learning the degree of the thermal conductivity of the dielectric layer.

The recording layer 4 is formed using the material containing Ge-Sn-Sb-Te which crystallizes at a high speed. The information recording medium which contains such material as the recording layer 4, not only has excellent initial recording characteristic, but also has excellent archival characteristic and an excellent archival overwrite characteristic. In a phase-change type information recording medium, information is recorded, erased and overwritten by utilizing reversible phase change between crystal phase and amorphous phase of the recording layer 4. When the recording layer 4 is irradiated with a high power (i.e. peak power) laser beam, and then cooled rapidly, the irradiated part turns into an amorphous phase and a record mark is formed. When the recording layer is irradiated with a low power (i.e. bias power) laser beam to raise its temperature and then cooled gradually, the irradiated part turns into a crystal phase and recorded information is erased. By irradiating the recording layer with the laser beam of which power is modulated between the peak power level and the bias power level, it is possible to overwrite new information while erasing information already recorded. Overwrite cyclability is expressed with the maximum number which corresponds to repeatable overwrite number on the condition that the jitter value does not cause a problem in a practical use. It can be said that the better overwrite cyclability is, the larger this number is. Particularly, an information recording medium for datafiles is expected to have excellent overwrite cyclability.

The first interface layer 103 and the second interface layer 105 have the function which prevents a material transfer caused between the first dielectric layer 102 and the recording layer 4, and between the second dielectric layer 106 and the recording layer 4, respectively. The material transfer here means the phenomenon which S of ZnS-20 mol % SiO₂ of the first and second dielectric layers diffuses into the recording layer while the recording the layer is irradiated with a laser beam and information is repeatedly overwritten. If a lot of S diffuses into the recording layer, a reduction of the reflectance of the recording layer is caused, and overwrite cyclability deteriorates. This phenomenon has already been known (See N. Yamada et al. Japanese Journal of Applied Physics Vol.37 (1998) pp.2104- 2110). Moreover, Japanese Patent Kokai (Laid-Open) Publication No. 10-275360 and International Publication No. WO 97/34298 disclose that the interface layer which prevents this phenomenon is formed using a nitride containing Ge.

The optical compensation layer 107 adjusts the ratio Ac/Aa where Ac is optical absorptance of the recording layer 4 in a crystalline state, and Aa is optical absorptance Aa of the recording layer 4 in an amorphous state, and serves to suppress distortion of overwritten marks. The reflective layer 8 optically serves to increase the light quantity absorbed by the recording layer 4, and thermally serves to diffuse the heat generated in the recording layer 4 to cool the recording layer quickly and to facilitate amorphization of the recording layer. The reflective layer 8 also serves to protect a multilayered film from the operation environment.

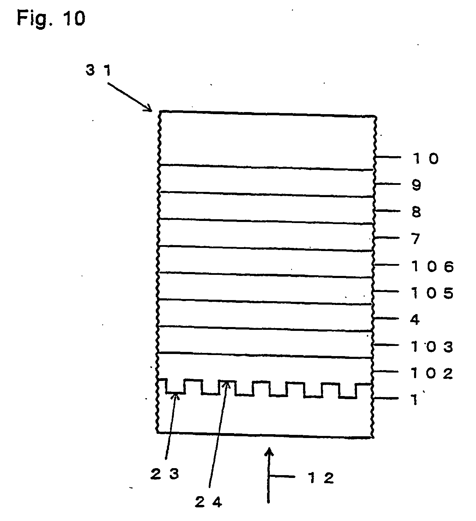

Thus, the information recording medium shown in Figure 10 ensures excellent overwrite cyclability and high reliability with a large capacity of 4.7GB by using the structure including the seven layers each of which functions as mentioned above, and thereby has been commercialized.

As material suitable for the dielectric layer of the information recording medium, various materials have already been proposed. For example, in Japanese Patent Kokai (Laid-Open) Publication No. 5-109115, it is disclosed that a heat-resistance protective layer is formed from a mixture of a high melting point element with a melting point above 1600K and low alkali glass in an optical information recording medium. In this publication, Nb, Mo, Ta, Ti, Cr, Zr, and Si are mentioned as the element with a high melting point. Further, in this publication, it is disclosed that the low alkali glass essentially consists of SiO₂, BaO, B₂O₃, or Al₂O₃.

In Japanese Patent Kokai (Laid-Open) Publication No. 5-159373, it is disclosed that the heat-resistance protective layer is formed from a mixture of at least one compound selected from nitride, carbide, oxide and sulfide with a melting point higher than that of Si, and low alkali glass in an optical information recording medium. In this publication, the carbide, oxide, and sulfide of Nb, Zr, Mo, Ta, Ti, Cr, Si, Zn, and Al, are illustrated as the high melting point compound. Moreover, in the publication, it is disclosed that the low alkali glass essentially consists of SiO₂, BaO, B₂O₃, and Al₂O₃.

In Japanese Patent Kokai (Laid-Open) Publication No. 8-77604, it is disclosed that a dielectric layer of a read-only information recording medium is formed from the oxide of at least one element selected from the group which consists of Ce, La, Si, In, Al, Ge, Pb, Sn, Bi, Te, Ta, Sc, Y, Ti, Zr, V, Nb, Cr, and W, the sulfide of at least one element selected from the group which consists of Cd, Zn, Ga, In, Sb, Ge, Sn, Pb, and Bi, or selenide and so on.

In Japanese Patent Kokai (Laid-Open) Publication No. 2001-67722, it is disclosed that the first interface control layer and the second interface control layer of an optical recording medium are selected from the nitride, oxide, carbide, and sulfide which contain at least one element selected from the element group consisting of Al, Si, Ti, Co, Ni, Ga, Ge, Sb, Te, In, Au, Ag, Zr, Bi, Pt, Pd, Cd, P, Ca, Sr, Cr, Y, Se, La, and Li.

### SUMMARY OF THE INVENTION

As mentioned above, when forming the first and the second dielectric layers by using ZnS-20 mol % SiO₂, the interface layer is inevitably needed between the recording layer and the dielectric layer for preventing the diffusion of S. However, when considering price of the medium, it is desirable that the number of the layers which compose the medium is as small as possible. If the number of layers is small, reduction of the cost of materials, miniaturization of manufacturing apparatus, and the increase in the throughput due to reduction in manufacture time can be realized, which results in the reduction of the price of the medium.

The inventors examined a possibility of eliminating at least one of the first interface layer and second interface layer as one method of reducing the number of layers. The inventors considered that in this case, a dielectric layer needs to be made from material other than ZnS-20 mol % SiO₂ so that the diffusion of S from the dielectric layer into the recording layer due to overwriting may not be caused. Further, the followings are desired as to the material for the dielectric layer:
The adhesiveness of the material to the recording layer which is of chalcogenide material is good;
The material realizes that recording sensitivity which is equivalent to or higher than that of the above seven-layer structure;
The material is transparent; and
The material has a high melting point so that it may not melt when recording.

It is an object of the present invention to provide an information recording medium which is provided with a dielectric layer having favorable adhesiveness to a recording layer, in which medium a substance does not transfer from the dielectric layer to the recording layer even when the dielectric layer is formed in direct contact with the recording layer without forming the interface layer, and excellent overwrite cyclability is ensured.

The above-mentioned publications do not refer to the problem that a substance transfers from the dielectric layer to the recording layer. Therefore, it should be noted that these publications do not teach the problem which this invention solves, and means to solve the problem, i.e. a specific composition of the material for the dielectric layer.

The inventors formed the dielectric layer by using various compounds and evaluated the adhesiveness of the dielectric layer to the recording layer and overwrite cyclability of the information recording medium, as explained in the below-mentioned Example. As a result, it was found that, when providing a dielectric on both sides of the recording layer directly, without an interface layer, the adhesiveness of the dielectric layer to the recording layer is good in the case where the dielectric layer is formed from a material which is easy to diffuse in the recording layer, for example, the conventional ZnS-20 mol % SiO₂, although, overwrite cyclability of the medium is inferior. Moreover, for example, ZrO₂ has low thermal conductivity and a high melting point. Therefore, if ZrO₂ is used for a dielectric layer, the recording sensitivity of the information recording medium can be high and excellent overwrite cyclability can be ensured. However, when forming a dielectric layer using ZrO₂, the result was that the adhesiveness of the dielectric layer to the recording layer is inferior. With respect to the information recording medium in which the dielectric layer is formed in contact with the recording layer using other various oxides, nitrides, sulfides and selenides, the adhesiveness of the dielectric layer to the recording layer and overwrite cyclability were evaluated. However, when forming the dielectric layer using one kind of oxide, nitride, sulfide or selenide, favorable adhesiveness and favorable overwrite cyclability could not be obtained together.

The inventors examined forming a dielectric layer with a combination of two or more kinds of compounds not containing S. As a result, it was found that the combination of ZrO₂ and Cr₂O₃ is suitable as a constitutive material for the dielectric layer which contacts with the recording layer. Further, it was found that the interface layer does not need to be formed when the content of Zr and Cr in the dielectric layer is within a specific range, which led to this invention.

That is, the present invention provides an information recording medium which includes a substrate and a recording layer wherein a phase change between a crystal phase and an amorphous phase is generated by irradiation of light or application of an electric energy, and which further includes a Zr-Cr-O-based material layer comprising Zr, Cr, and O wherein the content of Zr is 30 atomic % or less and the content of Cr is in the range of 7 atomic % to 37 atomic %.

The information recording medium of the present invention is a medium on or from which information is recorded or reproduced by irradiation of light or by application of an electric energy. Generally, irradiation of light is carried out by irradiation of a laser light (that is, laser beam), and application of an electric energy is carried out by applying a voltage to a recording layer. Hereafter, the Zr-Cr-O-based material layer which constitutes the information recording medium of this invention is described in detail. In addition, it should be noted that, in the following description, when the term "Zr-Cr-O-based material layer" is used, it refers to the layer in which Zr and Cr are contained at the above-mentioned ratio, respectively.

More specifically, the information recording medium of this invention includes the Zr-Cr-O-based material layer which consists essentially of the material expressed with the formula (1):

Zr_{Q}Cr_{R}O_{100-Q-R} (atomic %) (1)

wherein Q and R are respectively within the range of 0 < Q ≤ 30, and 7 ≤ R ≤ 37, and satisfy 20 ≤ Q+R ≤ 60, as a constituent element. The "atomic %" here shows that the formula (1) is a compositional formula of which basis (i.e. 100 %) is the sum of the numbers of Zr, Cr and O atoms. Also in the following formulae, the indication of "atomic %" is used for showing the same meaning.

In the formula (1), it does not matter what compound each atom of Zr, Cr, and O forms. The reason why the material is specified by this formula is that it is difficult to determine the composition represented with ratio of each compound when analyzing the composition of a layer formed into a thin film, and actually only an elementary composition (that is, ratio of each atom) is often determined. In the material expressed with the formula (1), it is considered that most Zr exists as ZrO₂ with O, and most Cr exists as Cr₂O₃ with O.

Preferably, the Zr-Cr-O-based material layer which consists essentially of the material expressed with above-mentioned formula (1) exists as either dielectric layer of the two dielectric layers adjacent to the recording layer in the information recording medium. More preferably, it exists as both of the two dielectric layers. The dielectric layer which contains Zr, Cr, and O in the above-mentioned range has a high melting point, and is transparent. Moreover, in this layer, ZrO₂ ensures excellent overwrite cyclability and Cr₂O₃ ensures adhesiveness to the recording layer which is of chalcogenide material. Therefore, even when this information recording medium does not have an interface layer, exfoliation does not occur between the recording layer and the dielectric layer, and excellent overwrite cyclability is exhibited. Alternatively, the layer of the material expressed with the formula (1) may be an interface layer which is located between the recording layer and a dielectric layer in an information recording medium.

In the information recording medium of this invention, the Zr-Cr-O-based material layer may be the layer which substantially consists of the material expressed with the formula (11):

(ZrO₂)_{M}(Cr₂O₃)_{100-M} (mol %) (11)

wherein M is in the range of 20 ≤ M ≤ 80. The formula (11) expresses the preferable ratio of the two compounds when the Zr-Cr-O-based material layer consists of a mixture of ZrO₂ and Cr₂O₃. The term "mol %" here shows that the formula (11) is a compositional formula of which basis (i.e. 100 %) is the total of each compound. Also in the following formulae, the indication of "mol %" is used for showing the same meaning.

Preferably, the layer which substantially consists of the material expressed with the formula (11) also exists as either dielectric layer of the two dielectric layers adjacent to the recording layer. More preferably, it exists as both of the two dielectric layers. The effect by using the layer which substantially consists of the material expressed with the formula (11) as a dielectric layer is the same as described in relation to the material expressed with the formula (1).

In the information recording medium of this invention, the Zr-Cr-O-based material layer may further contains Si, and substantially consist of the material expressed with the formula (2):

Zr_{U}Cr_{V}Si_{T}O_{100-U-V-T} (atomic %) (2)

wherein U, V, and T are respectively in the range of 0 < U ≤ 30, 7 ≤ V ≤ 37, and 0 < T ≤ 14, and satisfy 20 ≤ U+V+T ≤ 60.

Also in the formula (2), it does not matter what compound each atom of Zr, Cr, Si, and O forms. The reason why the material is specified by this formula is the same as the reason for employing the formula (1). In the material expressed with the formula (2), it is considered that most Si exists as SiO₂ with O.

Preferably, the layer which substantially consists of the material expressed with the formula (2) exists as either dielectric layer of the two dielectric layers adjacent to the recording layer. More preferably, it exists as both of the two dielectric layers. In the information recording medium in which the Zr-Cr-O-based material layer containing Si is employed as the dielectric layer, favorable adhesiveness of the dielectric layer to the recording layer and excellent overwrite cyclability are ensured, and higher recording sensitivity is realized. It is considered that the higher recording sensitivity is realized because the thermal conductivity of the layer becomes low by containing Si. Alternatively, the layer substantially consisting of the material expressed with the formula (2) may be an interface layer which is located between the recording layer and a dielectric layer in an information recording medium.

The Zr-Cr-O-based material layer containing Si may be the layer which substantially consists of the material expressed with the formula (21):

(ZrO₂)_{X}(Cr₂O₃)_{Y}(SiO₂)_{100-X-Y} (mol %) (21)

wherein X and Y are respectively within the range of 20 ≤ X ≤ 70, and 20 ≤ Y ≤ 60, and satisfy 60 ≤ X+Y ≤ 90. The formula (21) shows the preferable ratio of three compounds when the Zr-Cr-O-based material layer containing Si consists of a mixture of ZrO₂, Cr₂O₃, and SiO₂. Preferably, the layer which consists essentially of the material expressed with the formula (21) exists as either dielectric layer of the two dielectric layers adjacent to the recording layer. More preferably, it exists as both of the two dielectric layers. Alternatively, the layer of the material expressed with the formula (21) may be an interface layer which is located between the recording layer and a dielectric layer in an information recording medium.

When using the layer which substantially consists of the material expressed with the formula (21) as a dielectric layer, SiO₂ serves to enhance the recording sensitivity of the information recording medium. When using this material, favorable adhesiveness of the layer to the recording layer is ensured by setting X+Y at between 60 and 90 in the formula (21). The ratio of SiO₂ is adjusted by varying X+Y in this range. Therefore, by selecting the ratio of SiO₂ appropriately, the recording sensitivity can be adjusted. Further, ZrO₂ and Cr₂O₃ can exist in the layer at a suitable ratio by setting X at between 20 and 70, and setting Y at between 20 and 60 in the formula (21). Therefore, the dielectric layer which substantially consists of the material expressed with the formula (21) is transparent, and is excellent in adhesiveness to the recording layer, and further ensures that the information recording medium has favorable recording sensitivity and favorable overwrite cyclability.

The material expressed with the formula (21) may contain ZrO₂ and SiO₂ at a substantially equal ratio. In this case, this material is expressed with the following formula (22):

(ZrSiO₄)_{Z}(Cr₂O₃)_{100-Z} (mol %) (22)

wherein Z is within the range of 25 ≤ Z ≤ 67. When ZrO₂ and SiO₂ are contained at a substantially equal ratio, ZrSiO₄ with stable structure is formed. Preferably, the layer which substantially consists of the material expressed with the formula (22) exists as either dielectric layer of the two dielectric layers adjacent to the recording layer. More preferably, it exists as both of the two dielectric layers. In the formula (22), ZrSiO₄ and Cr₂O₃ exist in the layer at a suitable ratio by setting Z into the range of 25 ≤ Z ≤ 67. Therefore, the dielectric layer which substantially consists of the material expressed with the formula (22) is transparent, and is excellent in adhesiveness to the recording layer, and further ensures that the information recording medium has a favorable recording sensitivity and favorable overwrite cyclability. Alternatively, the layer which substantially consists of the material expressed with the formula (22) may be an interface layer which is located between the recording layer and a dielectric layer in an information recording medium.

This invention also provides an information recording medium which includes a substrate and a recording layer wherein a phase change between a crystal phase and an amorphous phase is generated by irradiation of light or application of an electric energy, and which further includes a layer which consists essentially of a Zr-Cr-Zn-O-based material expressed with the formula (3):

(ZrO₂)_{C}(Cr₂O₃)_{E}(D)_{F}(SiO₂)_{100-C-E-F} (mol %) (3)

wherein D is ZnS, ZnSe or ZnO, C, E and F are respectively in the range of 20 ≤ C ≤ 60, 20 ≤ E ≤ 60, and 10 ≤ F ≤ 40, and satisfy 60 ≤ C+E+F ≤ 90. In the following description, the layer which substantially consists of the material expressed with the formula (3) may be referred to merely as "a Zr-Cr-Zn-O-based material layer".

Preferably, the layer which substantially consists of the material expressed with the formula (3) exists as either dielectric layer of the two dielectric layers adjacent to the recording layer. More preferably, it exists as both of the two dielectric layers. The material expressed with the formula (3) contains ZrO₂, Cr₂O₃ and SiO₂ like the material expressed with the formula (21). Therefore, this material makes the dielectric layer excellent in transparency and adhesiveness to the recording layer. Moreover, the information recording medium including this dielectric layer has favorable recording sensitivity and favorable overwrite cyclability. Since the material expressed with the formula (3) contains ZnS, ZnSe, or ZnO as the component D, the dielectric layer formed from this material has further improved adhesiveness to the recording layer consisting of chalcogenide material. Further, the recording sensitivity can be further improved by adding ZnS or ZnSe which tends to be in a crystalline state into the ZrO₂-Cr₂O₃-SiO₂-based material which tends to be in an amorphous state in the form of a thin film. Alternatively, the layer which substantially consists of the material expressed with the formula (3) may be used as an interface layer which is located between the recording layer and a dielectric layer in an information recording medium.

ZrO₂ and Cr₂O₃ can exist in the layer at a suitable ratio by setting C at between 20 and 60, and setting E at between 20 and 60 in the formula (3). The effects of the component D (for example, improvement in adhesiveness etc.) are accomplished without deteriorating the overwrite cyclability of the information recording medium by setting F at between 10 and 40 in the formula (3). Moreover, in formula (3), by varying C+E+F in the range of 60 to 90, the ratio of SiO₂ can be adjusted appropriately and therefore, recording sensitivity can be adjusted.

The material expressed with the formula (3) may contain ZrO₂ and SiO₂ at a substantially equal ratio. In this case, this material is expressed with the following formula (31):

(ZrSiO₄)_{A}(Cr₂O₃)_{B}(D)_{100-A-B} (mol %) (31)

wherein D is ZnS, ZnSe or ZnO, and A and B are respectively in the range of 25 ≤ A ≤ 54, and 25 ≤ B ≤ 63, and satisfy 50 ≤ A+B ≤ 88. ZrSiO₄ of a stable structure is formed when ZrO₂ and SiO₂ are contained at a substantially equal ratio as mentioned above. Preferably, the layer which substantially consists of the material expressed with the formula (31) exists as either dielectric layer of the two dielectric layers adjacent to the recording layer. More preferably, it exists as both of the two dielectric layers. ZrSiO₄ and Cr₂O₃ exist in the layer at a suitable ratio by setting A at between 25 and 54, and setting B at between 25 and 63 in the formula (31). Therefore, the dielectric layer which substantially consists of the material expressed with the formula (31) is transparent, and is excellent in adhesiveness to the recording layer, and ensures that the information recording medium has favorable recording sensitivity and favorable overwrite cyclability. Moreover, when the material expressed with the formula (31) is contained in the dielectric layer, SiO₂ and the component D make the recording sensitivity of the information recording medium high, and the component D enhances the adhesiveness of the dielectric layer to the recording layer. Alternatively, the layer which substantially consists of the material expressed with the formula (31) may be an interface layer which is located between the recording layer and a dielectric layer in an information recording medium.

The information recording medium of the present invention preferably has a recording layer in which a phase change is generated reversibly. That is, the information recording medium of this invention is preferably provided as an rewritable information recording medium.

Specifically, the recording layer where a phase change occurs reversibly preferably contains any one material selected from Ge-Sb-Te, Ge-Sn-Sb-Te, Ge-Bi-Te, Ge-Sn-Bi-Te, Ge-Sb-Bi-Te, Ge-Sn-Sb-Bi-Te, Ag-In-Sb-Te and Sb-Te. Each of these is a rapid crystallization material. Therefore, when a recording layer is formed from these materials, it is possible to record information at a high density and a high transfer rate, and to obtain the information recording medium excellent in reliability (specifically archival characteristic or archival overwrite characteristic).

The information recording medium of this invention may have two or more recording layers. For example, such information recording medium has a single-sided dual-layer structure, in which two recording layers are formed on one surface of a substrate with a dielectric layer and an intermediate layer therebetween. As to the information recording medium of the single-sided dual-layer structure, information is recorded in two recording layers by irradiation of light from one side. By employing this structure, the recording capacity can be made large. Alternatively, an information recording medium of this invention may include a recording layer on both surfaces of a substrate.

In the information recording medium of this invention, it is desirable that the film thickness of the recording layer is 15 nm or less. If it exceeds 15 nm, the heat applied to the recording layer will diffuse in the planar direction, and will be difficult to diffuse in the thickness direction.

The information recording medium of this invention may have a constitution in which a first dielectric layer, a recording layer, a second dielectric layer, and a reflective layer are formed in this order on one surface of a substrate. The information recording medium of this constitution is a medium on which information is recorded by irradiation of light. In this specification, the "first dielectric layer" means the dielectric layer which is in the position closer to the incident light, and the "second dielectric layer" means the dielectric layer which is in the position farther from the incident light. That is, the incident light passes through the first dielectric layer and the recording layer in this order, and then reaches the second dielectric layer. The information recording medium of this constitution is used, for example, when recording and reproducing by the laser beam of which wavelength is about 660 nm.

When the information recording medium of this invention has this constitution, at least one of the first dielectric layer and the second dielectric layer is the above Zr-Cr-O-based material layer (specifically, the layer which consists essentially of any one of the materials expressed with the above formulae (1), (11), (2), (21), and (22)), or the above Zr-Cr-Zn-O-based material layer (specifically, the layer which consists essentially of the material expressed with the above formula (3) or (31)). Preferably, both of the dielectric layers are the above Zr-Cr-O-based material layer or the above Zr-Cr-Zn-O-based material layer. In this case, the compositions of both dielectric layers may be the same or different from each other.

The information recording medium of this invention may have a constitution in which a reflective layer, a second dielectric layer, a recording layer, and a first dielectric layer are formed in this order on one surface of a substrate. This constitution is employed when the thickness of the substrate to which a light is applied needs to be thin. Specifically, the information recording medium of this constitution is used, when information is recorded and reproduced by a short-wavelength laser beam of which wavelength is about 405 nm, and the numerical aperture NA of an objective lens is made as large as, for example, 0.85 in order to set a focal position shallow. In order to use such a wavelength and numerical aperture NA, the thickness of the substrate to which light is applied needs to be set at between about 60 and 120 µm, for example. It is difficult to form a layer on the surface of such thin substrate. Therefore, the information recording medium of this constitution is identified as an medium formed by using a substrate to which a light is not applied as a support substrate, and stacking a reflective layer and so on in the order on one surface of the substrate.

When the information recording medium of this invention has this constitution, at least one of the first dielectric layer and the second dielectric layer is the above Zr-Cr-O-based material layer or the above Zr-Cr-Zn-O-based material layer. Preferably, both of the dielectric layers are the above Zr-Cr-O-based material layer or the above Zr-Cr-Zn-O-based material layer. In this case, the compositions of both dielectric layers may be the same or different from each other.

This invention also provides a method for producing the information recording medium of this invention which includes the process of forming the above-mentioned Zr-Cr-Q-based material layer by a sputtering method. According to the sputtering method, the Zr-Cr-O-based material layer of which composition is substantially the same as that of a sputtering target, can be formed. Therefore, according to this producing method, the Zr-Cr-O-based material layer of a desired composition can be easily formed by selecting a sputtering target appropriately.

Specifically, a sputtering target which substantially consists of the material expressed with the following formula (10):

Zr_{J}Cr_{K}O_{100-J-K} (atomic %) (10)

wherein, J and K are respectively within the range of 3 ≤ J ≤ 24, and 11 ≤ K ≤ 36, and satisfy 34 ≤ J+K ≤ 40 can be used. The formula (10) is equivalent to an elementary composition formula of the material expressed with the formula (110) mentioned below. Therefore, by using this target, the layer which substantially consists of the material expressed with the above-mentioned formula (10) can be formed.

The elementary composition of the layer formed by sputtering may differ from the elementary composition of a sputtering target depending on a sputtering device, sputtering conditions, and the size of the sputtering target and so on. Even when such difference occurs upon using the sputtering target consisting of the material expressed with the above-mentioned formula (10), the elementary composition of the layer to be formed is expressed at least with the above-mentioned formula (1).

In the producing method of the information recording medium of this invention, a sputtering target which substantially consists of the material expressed with the formula (110):

(ZrO₂)ₘ(Cr₂O₃)₁₀₀₋ₘ (mol %) (110)

wherein, m is within the range of 20 ≤ m ≤ 80, may be used. This is equivalent to the formula which expresses the composition of a sputtering target with the ratio of ZrO₂ and Cr₂O₃. The reason why the sputtering target is thus specified is that the sputtering target consisting of the material which contains Zr, Cr and O is usually provided with the indication of the composition based on these two compounds. Further, the inventors have confirmed that, according to analysis with an X-ray microanalyser, the elementary composition of a commercially available sputtering target becomes substantially equal to the elementary composition calculated from the indicated composition (that is, the indicated composition (i.e. nominal composition) is correct). Therefore, this sputtering target makes it possible to form the layer which substantially consists of the material expressed with the formula (11).

In the producing method of the information recording medium of this invention, in order to form the Zr-Cr-O-based material layer containing Si, a sputtering target which substantially consists of the material expressed with the formula (20):

Zr_{G}Cr_{H}Si_{L}O_{100-G-H-L} (atomic %) (20)

wherein G, H, and L are within the range of 4 ≤ G ≤ 21, 11 ≤ H ≤ 30, and 2 ≤ L ≤ 12, and satisfy 34 ≤ G+H+L ≤ 40, may be used. When this sputtering target is used, the layer which substantially consists of the material expressed with the formula (21) or the formula (2) is formed.

In the producing method of the information recording medium of this invention, a sputtering target which substantially consists of the material expressed with the formula (210):

(ZrO₂)ₓ (Cr₂O₃)_{y}(SiO₂)_{100-x-y} (mol %) (210)

wherein x and y are respectively within the range of 20 ≤ x ≤ 70, and 20 ≤ y ≤ 60, and satisfy 60 ≤ x+y ≤ 90, may be used. The reason why the sputtering target is thus specified is that the sputtering target consisting of the material containing Zr, Cr, Si and O is usually provided with the indication of the composition based on ZrO₂, Cr₂O₃ and SiO₂. The inventors have confirmed that also the indicated composition (i.e. nominal composition) of the target whose composition is indicated with the formula (210) is correct. Therefore, this sputtering target makes it possible to form the layer which substantially consists of the material expressed with the formula (21).

The sputtering target expressed with the above-mentioned formula (210) may contain ZrO₂ and SiO₂ at a substantially equal ratio. In that case, the sputtering target which substantially consists of the material expressed with the formula (220):

(ZrSiO₄)_{z}(Cr₂O₃)_{100-z} (mol %) (220)

wherein z is within the range of 25 ≤ z ≤ 67, may be used. This sputtering target makes it possible to form the layer which consists of the material shown by the formula (22).

This invention also provides a method for producing the information recording medium of this invention which includes the process of forming the above-mentioned Zr-Cr-Zn-O-based material layer by sputtering. According to the sputtering method, the Zr-Cr-Zn-O-based material layer which has the substantially same composition as the sputtering target can be formed. Specifically, a sputtering target which substantially consists of the material expressed with the following formula (30):

(ZrO₂)_{c}(Cr₂O₃)ₑ(D)_{f}(SiO₂)_{100-c-e-f} (mol %) (30)

wherein, D is ZnS, ZnSe, or ZnO, c, e, and f are respectively within the range of 20 ≤ c ≤ 60, 20 ≤ e ≤ 60, and 10 ≤ f ≤ 40, and satisfy 60 ≤ c+e+f ≤ 90, may be used. The reason why the sputtering target is thus specified is that the target which contains component D in addition to Zr, Cr, Si, and O is provided with the composition based on ZrO₂, Cr₂O₃, SiO₂ and component D indicated. The sputtering target makes it possible to form the layer which substantially consists of the material shown by the formula (3).

The sputtering target shown by the above formula (30) may contain ZrO₂ and SiO₂ at a substantially equal ratio In this case, the sputtering target which substantially consists of the material expressed with the formula (310):

(ZrSiO₄)ₐ(Cr₂O₃)_{b}(D)_{100-a-b} (mol %) (310)

wherein D is ZnS, ZnSe, or ZnO, a and b are respectively within the range of 25 ≤ a ≤ 54 and 25 ≤ b ≤ 63, and satisfy 50 ≤ a+b ≤ 88, may be used. This sputtering target makes it possible to form the layer which substantially consists of the material shown by the formula (31).

Preferably, thiss invention is characterized in that the dielectric layer is formed from ZrO₂-Cr₂O₃-based material, ZrO₂-Cr₂O₃-SiO₂-based material, or the material which is a mixture of ZrO₂-Cr₂O₃-SiO₂ and one of ZnS, ZnSe and ZnO, in direct contact with the recording layer. According to this characteristic, by eliminating the interface layer which is provided between the recording layer and the dielectric layer in the prior art optical information recording medium, the number of layers can be reduced, while the optical information recording medium which has high reliability, and ensures excellent overwrite cyclability and high recording sensitivity, can be realized. When the layer of any one of these materials is used as a dielectric layer for insulating a recording layer in the information recording medium to which an electric energy is applied, the phase change of the recording layer can be generated with a small electric energy.

### BRIEF DESCRIPTION OF THE DRAWINGS

A more complete appreciation of the invention and many of the attendant advantages thereof will become readily apparent with reference to the following detailed description, particularly when considered in conjunction with the accompanying drawings, in which:
Figure 1 is a fragmentary sectional view which shows an example of the optical information recording medium of the invention;
Figure 2 is a fragmentary sectional view which shows another example of the optical information recording medium of the invention;
Figure 3 is a fragmentary sectional view which shows further another example of the optical information recording medium of the invention;
Figure 4 is a fragmentary sectional view which shows further another example of the optical information recording medium of the invention;
Figure 5 is a fragmentary sectional view which shows further another example of the optical information recording medium of the invention;
Figure 6 is a fragmentary sectional view which shows further another example of the optical information recording medium of the invention;
Figure 7 is a triangular diagram which shows the composition range of the material expressed with the formula (21);
Figure 8 is a schematical view which shows an example of the information recording medium of the invention on which information is recorded by application of an electric energy;
Figure 9 is a schematical view which shows an example of a system for the information recording medium shown in Figure 8; and
Figure 10 is a fragmentary sectional view which shows an example of the prior art information recording medium.

### DETAILED DESCRIPTION OF THE INVENTION

Hereafter, the embodiments of the present invention are described with reference to the accompanying drawings. The following embodiments are illustrative, and the present invention is not limited to the following embodiments.

### (Embodiment 1)

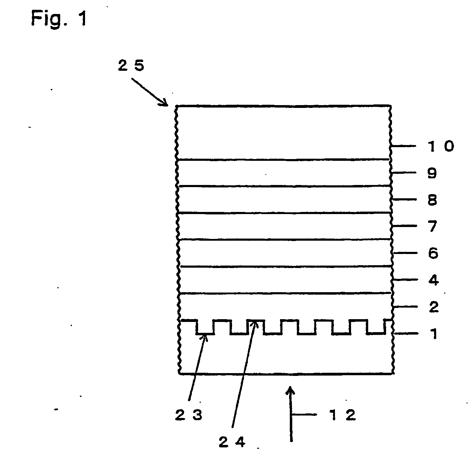

As Embodiment 1 of this invention, an example of the optical information recording medium on or from which information is recorded or reproduced by a laser beam, is described. Figure 1 shows the partial cross section of the optical information recording medium.

The information recording medium 25 shown in Figure 1 has a construction in which a first dielectric layer 2, a recording layer 4, a second dielectric layer 6, an optical compensation layer 7, and a reflective layer 8 are formed on one surface of a substrate 1 in this order, and a dummy substrate 10 is bonded with an adhesive layer 9. The information recording medium of this constitution can be used as a 4.7GB DVD-RAM on or from which information is recorded or reproduced by a laser beam with a wavelength of about 660 nm in a red wavelength region. A laser beam 12 is applied to the information recording medium of this constitution from the substrate 1 side, and thereby, information is recorded and reproduced. The information recording medium 25 is different from the prior art information recording medium 31 shown in Figure 10 in that it does not have the first interface layer 103 and the second interface layer 105.

In Embodiment 1, both of the first dielectric layer 2 and the second dielectric layer 6 are a Zr-Cr-O-based material layer or a Zr-Cr-Zn-O-based material layer.

Generally, it is required that the material for a dielectric layer 1) is transparent; 2) has a high melting point and does not melt at the time of recording; and 3) has good adhesiveness to the recording layer which is of chalcogenide material. Transparency is a characteristic necessary for allowing the laser beam 12 applied from the substrate 1 side to pass through the dielectric layer and to reach the recording layer 4. Particularly, this characteristic is required for the first dielectric layer on the laser incident side. The high melting point is a characteristic necessary for ensuring that the material of the dielectric layer is not immixed in the recording layer when applying the laser beam of a peak power level. If the material of the dielectric layer is immixed in the recording layer, overwrite cyclability deteriorates remarkably. Good adhesiveness to the recording layer which is of chalcogenide material is a characteristic necessary for ensuring reliability of the information recording medium. Further, it is necessary to select the material for the dielectric layer so that the information recording medium has recording sensitivity equivalent to or higher than the conventional information recording medium (that is, a medium wherein an interface layer is located between the dielectric layer consisting of ZnS-20 mol % SiO₂ and the recording layer).

It is preferable that the Zr-Cr-O-based material layer is a layer which substantially consists of a mixture of ZrO₂ and Cr₂O₃. ZrO₂ is transparent and has a high melting point (about 2700 °C), and low thermal conductivity among oxides. Cr₂O₃ has good adhesiveness to the recording layer which is of chalcogenide material. Therefore, the information recording medium 25 which is excellent in overwrite cyclability with favorable adhesiveness between the recording layer and the dielectric layer can be realized by forming the first and the second dielectric layers 2 and 6 from the mixture of these two kinds of oxides in contact with the recording layer 4 as illustrated. The mixture of ZrO₂ and Cr₂O₃ is expressed with the above-mentioned formula (11), i.e. (ZrO₂)_{M}(Cr₂O₃)_{100-M} (mol %). It is preferable that the Cr₂O₃ content (that is, 100-M) is 20 mol % or more in this mixture. When Cr₂O₃ content is too much, the recording sensitivity of the information recording medium becomes low. Therefore, the Cr₂O₃ content is preferably 80 mol % or less, and more preferably in the range of 30 mol % to 50 mol %.

The first and the second dielectric layers 2 and 6 may be a Zr-Cr-O-based material layer containing Si. Preferably, the Zr-Cr-O-based material layer containing Si substantially consists of a mixture of ZrO₂, Cr₂O₃ and SiO₂. This mixture is expressed with the above-mentioned formula (21), i.e. (ZrO₂)_{X}(Cr₂O₃)Y(SiO₂)_{100-X-Y} (mol %). In this formula, X and Y are respectively within the range of 20 ≤ X ≤ 70, and 20 ≤ Y ≤ 60, and satisfy 60 ≤ X+Y ≤ 90.

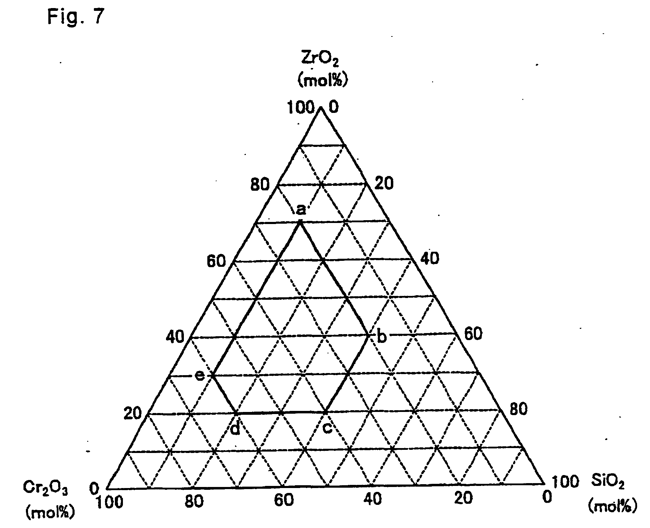

The composition range of material expressed with the formula (21) is shown in Figure 7. The coordinate is (ZrO₂, Cr₂O₃, SiO₂) in Figure 7. In this figure, the material expressed with the formula (21) is within the range (including the place on the line) surrounded by a(70, 20, 10), b(40, 20, 40), c(20, 40, 40), d(20, 60, 20), and e(30, 60, 10).

The Zr-Cr-O-based material layer containing SiO₂ enhances the recording sensitivity of the information recording medium. Moreover, the recording sensitivity can be adjusted by adjusting the ratio of SiO₂. In order to make the recording sensitivity higher by using SiO₂, the SiO₂ content in the mixture is preferably 10 mol % or more. On the other hand, since the adhesiveness to the recording layer is reduced in the case where the SiO₂ content is high, the SiO₂ content is preferably 40 mol % or less. The function of ZrO₂ and Cr₂O₃ is as described above. By mixing ZrO₂ and Cr₂O₃ at a suitable ratio, the performance of the information recording medium is made suitable. In the case of the ZrO₂-Cr₂O₃-SiO₂ mixture, the Cr₂O₃ content is preferably in the range of 20 mol % to 60 mol %, and the ZrO₂ content is preferably in the range of 20 mol % to 70 mol %. The first dielectric layer 2 and the second dielectric layer 6 may be layers consisting of different mixtures whose SiO₂ contents are different from each other. For example, the first dielectric layer 2 may be (ZrO₂)₅₀(Cr₂O₃)₃₀ (SiO₂)₂₀ (mol %), and the second dielectric layer 6 may be (ZrO₂)₄₀(Cr₂O₃)₂₀(SiO₂)₄₀ (mol %).

In the ZrO₂-Cr₂O₃-SiO₂ mixture, when ZrO₂ content and SiO₂ content are substantially equal, ZrSiO₄ is preferably contained. ZrSiO₄ is a complex compound with a stable stoichiometric composition. The mixture in which ZrSiO₄ is formed is expressed with above-mentioned formula (22), i.e. (ZrSiO₄)_{Z}(Cr₂O₃)_{100-Z} (mol %). In this formula, Z is within the range of 25 ≤ Z ≤ 67. When ZrO₂ and SiO₂ are contained in the mixture at a substantially equal ratio, ZrSiO₄ is formed, and thereby a ZrO₂-SiO₂-system with a stronger bond is obtained. In order to make adhesiveness of the layer to the recording layer better, and to ensure overwrite cyclability and high recording sensitivity of the information recording medium, Z is more preferably within the range of 33 ≤ Z ≤ 50.

A Zr-Cr-Zn-O-based material layer is a layer which substantially consists of a mixture which further contains ZnS, ZnSe or ZnO in the mixture of ZrO₂, Cr₂O₃ and SiO₂. This mixture is expressed with above-mentioned formula (3), i.e. (ZrO₂)_{C}(Cr₂O₃)_{E}(D)_{F}(SiO₂)_{100-C-E-F} (mol %). In this formula, C, E, and F are respectively within the range of 20 ≤ C ≤ 60, 20 ≤ E ≤ 60, and 10 ≤ F ≤ 40, and satisfy 60 ≤ C+E+F ≤ 90. When the mixture contains component D, the layer consisting of this mixture exhibits better adhesiveness to the recording layer 4. Moreover, ZnS and ZnSe have a strong crystallinity even in the form of a thin film. Therefore, when it is added into the amorphous ZrO₂-Cr₂O₃-SiO₂ mixture, the thermal conductivity of the mixture is further reduced. Therefore, if the first and the second dielectric layers 2 and 6 are formed from the mixture containing ZnS and ZnSe, the recording sensitivity of the information recording medium can be made higher. In this manner, by mixing four kinds of material, it is possible to realize the information recording medium which has recording sensitivity suitable for recording and erasing conditions (for example, the linear velocity of the medium and the wavelength of the laser beam), and which is excellent in overwrite cyclability and in adhesiveness of the dielectric layer to the recording layer.

The mixture shown by the above-mentioned formula (3) may also contain ZrO₂ and SiO₂ at a substantially equal ratio. Such mixture is expressed with the above-mentioned formula (31), i.e. (ZrSiO₄)_{A}(Cr₂O₃)_{B}(D)_{100-A-B} (mol %). In this formula, A and B are respectively within the range of 25 ≤ A ≤ 54 and 25 ≤ B ≤ 63, and satisfy 50 ≤ A+B ≤ 88. When ZrO₂ and SiO₂ are contained in the mixture at a substantially equal ratio, ZrSiO₄ is formed, and thereby a ZrO₂-SiO₂-system with a stronger bond is obtained. Thereby, it is possible to realize the information recording medium which has the recording sensitivity more suitable for the conditions of recording and erasing of information, and which is excellent in overwrite cyclability and in adhesiveness of the dielectric layer to the recording layer.

By changing each optical path length (that is, the product "nd" of refractive index n of a dielectric layer and the film thickness d of a dielectric layer), the first dielectric layer 2 and the second dielectric layer 6 serve to adjust optical absorptance Ac (%) of the recording layer 4 in a crystalline state and optical absorptance Aa (%) of the recording layer 4 in an amorphous state, adjust the optical reflectance Rc (%) of the information recording medium 25 when the recording layer 4 is in a crystalline state and the optical reflectance Ra (%) of the information recording medium 25 when the recording layer 4 is in an amorphous state, and adjust the phase difference Δφ of the light of the information recording medium 25 between the portions where the recording layer 4 is in a crystalline state and an amorphous state. In order to improve signal quality by increasing the reproduced-signal amplitude of a record mark, it is desirable that a reflectance difference (|Rc-Ra|) or a reflectance ratio (Rc/Ra) is large. Further, it is desirable that Ac and Aa are also large so that the recording layer 4 may absorb a laser beam. The optical path length of each of the first dielectric layer 2 and the second dielectric layer 6 is determined so as to satisfy these conditions simultaneously. The optical path length which satisfies those conditions can be determined accurately, for example, by calculation based on a matrix method (for example, see "Wave Optics" by Hiroshi Kubota et al., Section 3, Iwanami Shinsho, 1971).

The Zr-Cr-O-based material and the Zr-Cr-Zn-O-based material described above have the refractive index which differs depending on the composition. In general, these materials have a refractive index within the range of 1.8 to 2.5. When setting the refractive index of a dielectric layer at n, the film thickness at d (nm), and the wavelength of the laser beam 12 at λ(nm), the optical path length "nd" is expressed with nd=aλ, wherein "a" is a positive number. In order to improve the signal quality by increasing the reproduced-signal amplitude of the record mark of the information recording medium 25, for example, it is preferable that Rc, and Ra satisfy 15 % ≤ Rc and Ra ≤ 2 %, respectively. Moreover, in order to eliminate the mark distortion by overwriting, or to make it small, it is preferable that Ac and Aa satisfy 1.1 ≤ Ac/Aa. The optical path length (aλ) of each of the first dielectric layer 2 and the second dielectric layer 6 was accurately calculated based on the matrix method so that these preferable conditions might be satisfied simultaneously. From the obtained optical path length (aλ), λ and n, the thickness d of each dielectric layer was calculated. As a result, it was found that the thickness of the first dielectric layer 2 is preferably in the range of 100 nm to 200 nm, and more preferably from 130 nm to 170 nm. Further, it was found that the thickness of the second dielectric layer 6 is preferably in the range of 20 nm to 70 nm, and more preferably from 30 nm to 60 nm.

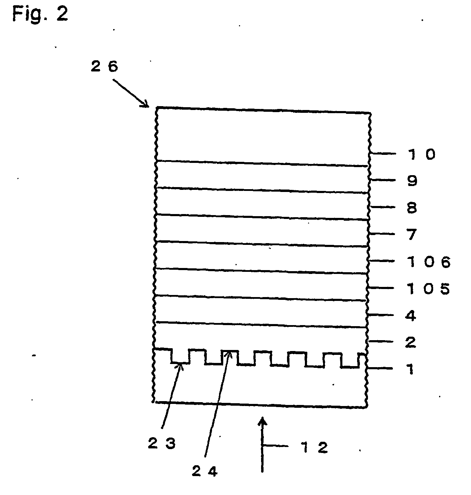

The substrate 1 is usually a transparent disc-shaped plate. A guide groove for guiding a laser beam may be formed in the surface where the dielectric layer, the recording layer and so on may be formed. In the case where the guide groove is formed on the substrate, groove portions and land portions are formed, when the substrate is viewed in cross section. It can be said that a groove portion is located between two adjacent land portions. Therefore, the surface wherein the guide groove is formed has a top surface and a bottom surface which are connected by side walls. In this specification, the bottom surface is referred to as a "groove surface", whereas a top surface is referred to as a "land surface." Therefore, in Figures 1 to 6, the surface 23 corresponds to the "groove surface" and the surface 24 corresponds to the "land surface." When viewed from the direction of the laser beam 12, the groove surface is always located closer to the laser beam 12, whereas the land surface is always located away from the laser beam 12. Record marks are formed in the recording layer on the surface of the recording layer corresponding to the groove surface of the guide groove (groove recording), or on the surface of the recording layer corresponding to the land surface of the guide groove (land recording), or on both surfaces of the recording layer (land-groove recording). In the embodiment shown in Figure 1, the distance in the thickness direction between the groove surface 23 and the land surface 24 (i.e. the depth of groove) is preferably in the range of 40 nm to 60 nm. The below-mentioned embodiments shown in Figures 2, 3 and 6, the distance in the thickness direction between the groove surface 23 and the land surface 24 is preferably in this range. Moreover, it is desirable that the surface where a layer is not formed is flat. As material for the substrate 1, a resin like a polycarbonate, amorphous polyolefin, or PMMA, or glass can be employed. Considering moldability, price and mechanical strength, a polycarbonate resin is preferably used. In the embodiment shown in Figure 1, the thickness of the substrate 1 is in the range of about 0.5 to 0.7 mm.

The recording layer 4 is a layer where a phase change between a crystal phase and an amorphous phase is generated by irradiation of light or application of an electric energy, and record marks are formed. The erasure and overwrite can be carried out if the phase change is reversible. It is preferable to use Ge-Sb-Te or Ge-Sn-Sb-Te which is a rapid crystallization material, as a reversible phase change material. Specifically, GeTe-Sb₂Te₃ pseudo-binary composition is preferably used as Ge-Sb-Te. In this case, the composition preferably satisfy 4Sb₂Te₃ ≤ GeTe ≤ 50Sb₂Te₃. In case of GeTe < 4Sb₂Te₃, the variation in the amount of reflected light before and after recording is small, resulting in deterioration of the quality of a read-out signal. In case of 50Sb₂Te₃ < GeTe, the volume variation between a crystal phase and an amorphous phase is large, resulting in deterioration of overwrite cyclability. Ge-Sn-Sb-Te has a crystallization speed higher than Ge-Sb-Te. Ge-Sn-Sb-Te is, for example, a material in which Sn is substituted for part of Ge of GeTe-Sb₂Te₃ pseudo-binary composition. It is preferable that the content of Sn is 20 atomic % or less in the recording layer 4. If it exceeds 20 atomic %, the crystallization speed is too high and therefore, the stability of an amorphous phase is impaired, which results in deterioration of reliability of record marks. The content of Sn can be adjusted depending on the recording conditions.

The recording layer 4 may be formed from a material containing Bi such as Ge-Bi-Te, Ge-Sn-Bi-Te, Ge-Sb-Bi-Te, or Ge-Sn-Sb-Bi-Te. Bi more easily crystallizes than Sb. Therefore, the crystallization speed of the recording layer can be increased by substituting Bi for part of Sb.

Ge-Bi-Te is a mixture of GeTe and Bi₂Te₃. In this mixture, it is preferable that 8Bi₂Te₃ ≤ GeTe ≤ 25Bi₂Te₃. In case of GeTe < 8Bi₂Te₃, the crystallization temperature is reduced, resulting in deterioration of archival characteristic. In case of 25Bi₂Te₃ < GeTe, the volume variation between a crystal phase and an amorphous phase is large, resulting in deterioration of overwrite cyclability.

Ge-Sn-Bi-Te is obtained by substituting Sn for part of Ge of Ge-Bi-Te. The crystallization speed can be controlled depending on the recording conditions by adjusting the content of Sn introduced by substitution. Substitution by Sn is suitable for fine adjustment of the crystallization speed compared with substitution by Bi. In the recording layer, the content of Sn is preferably 10 atomic % or less. If the content of Sn is more than 10 atomic %, the crystallization speed becomes too high, which reduces the stability of an amorphous phase, and therefore, the archival characteristic of record marks is deteriorated.

Ge-Sn-Sb-Bi-Te is obtained by substituting Sn for part of Ge of Ge-Sb-Te, and Bi for part of Sb of Ge-Sb-Te. This corresponds to a mixture of GeTe, SnTe, Sb₂Te₃ and Bi₂Te₃. As to this mixture, the crystallization speed can be controlled depending on the recording conditions, by adjusting the content of Sn and Bi introduced by substitution. In Ge-Sn-Sb-Bi-Te, it is preferable that 4(Sb-Bi)₂Te₃ ≤ (Ge-Sn)Te ≤ 25(Sb-Bi)₂Te₃. In case of (Ge-Sn)Te < 4(Sb-Bi)₂Te₃, the variation in the amount of reflected light before and after recording is small, resulting in deterioration of the quality of a read-out signal. In case of 25(Sb-Bi)₂Te₃ < (Ge-Sn)Te, the volume variation between a crystal phase and an amorphous phase is large, resulting in deterioration of overwrite cyclability. In the recording layer, the content of Bi is preferably 10 atomic % or less and the content of Si is preferably 20 atomic % or less. These Bi content and Si content make the archival characteristic of record marks good.

As the material in which a phase change is generated reversibly, Ag-In-Sb-Te, Ag-In-Sb-Te-Ge, and Ge-Sb-Te containing Sb in an amount of 70 atomic % or more may be employed.

As an irreversible phase change material, it is preferable to use TeOₓ+α (a is Pd, Ge, or the like) as disclosed in Japanese Patent Publication No. 7-025209 B2. The information recording medium whose recording layer is of an irreversible phase change material is a so-called write-once type in which recording can be conducted only once. Also in such information recording medium, there are problems that the atom in the dielectric layer diffuses into the recording layer with heat at the time of recording, which results in the deterioration of the signal quality. Therefore, this invention is preferably applied to the write-once type information recording medium as well as the rewritable information recording medium.

As mentioned above, the recording layer 4 preferably has a thickness of 15 nm or less, and more preferably 12 nm or less.

The optical compensation layer 7 adjusts the ratio Ac/Aa of the optical absorptance Ac when the recording layer 4 is in a crystalline state, and the optical absorptance Aa when the recording layer 4 is in an amorphous state, and serves to suppress the distortion of the mark shape at the time of overwriting. It is preferable to form the optical compensation layer 7 from the material which has a high refractive index and absorbs a light moderately. For example, the optical compensation layer 7 may be formed using the material whose refractive index n is in the range of 3 to 6, and whose extinction coefficient k is in the range of 1 to 4. Specifically, it is preferable to use material selected from amorphous Ge alloys, such as Ge-Cr and Ge-Mo, amorphous Si alloys, such as Si-Cr, Si-Mo and Si-W, telluride, and crystalline metal, such as Ti, Zr, Nb, Ta, Cr, Mo, W, SnTe, PbTe and so on, semimetals, and semiconductor material. The film thickness of the optical compensation layer 7 is preferably in the range of 20 nm to 80 nm, and more preferably from 30 nm to 50 nm.

The reflective layer 8 has an optical function of increasing the quantity of light absorbed by the recording layer 4, and a thermal function of diffusing the heat generated in the recording layer 4 quickly to quench the recording layer 4, and thereby facilitate the amorphization of the recording layer 4. Further, the reflective layer 8 protects the multilayered film including the recording layer 4 and the dielectric layers 2 and 6 from the operation environment. As the material for the reflective layer 8, for example, the single-metal material with high thermal conductivity, such as Al, Au, Ag and Cu, is used. The reflective layer 8 may be formed from the material which contains another one or more elements in addition to one or more elements selected from the above-mentioned metallic material for the purpose of improving the moisture resistance and/or the purpose of adjusting thermal conductivity or an optical characteristic (for example, an optical reflectance, an optical absorptance or transmissivity). Specifically, an alloy material, such as Al-Cr, Al-Ti, Ag-Pd, and Ag-Pd-Cu, Ag-Pd-Ti, or Au-Cr, may be used. Each of these materials is excellent in corrosion resistance and has a quenching function. The similar purpose may be accomplished also by forming the reflective layer 8 in two or more layers. The thickness of the reflective layer 8 is preferably in the range of 50 to 180 nm, and more preferably from 60 nm to 100 nm.

In the illustrated information recording medium 25, the adhesive layer 9 is provided in order to adhere the dummy substrate 10 to the reflective layer 8. The adhesive layer 9 may be formed using a highly heat-resistant and highly adhesive material, for example, a bonding resin such as an ultraviolet-curing resin. Specifically, the adhesive layer 9 may be formed from an acrylic resin based material, or an epoxy resin based material. Moreover, if necessary, before forming the adhesive layer 9, a protective layer which consists of an ultraviolet-curing resin and has a thickness of 5 to 20 µm may be provided on the surface of the reflective layer 8. The thickness of the adhesive layer 9 is preferably in the range of 15 to 40 µm, and more preferably in the range of 20 to 35 µm.

The dummy substrate 10 enhances the mechanical strength of the information recording medium 25 and protects the multilayered body consisting of the layers from the first dielectric layer 2 to the reflective layer 8. The preferable material for the dummy substrate 10 is the same as that for the substrate 1. In the information recording medium 25 which includes the dummy substrate 10, it is preferable that the dummy substrate 10 and the substrate 1 are formed from the substantially same material and have the same thickness so as not to cause mechanical curvature and distortion.

The information recording medium of Embodiment 1 is a single-sided structure disc which has one recording layer The information recording medium of this invention may have two recording layers. For example, an information recording medium of the double-sided structure is obtained by bonding two laminated pieces in which the layers up to the reflective layer 8 are stacked. The two pieces are bonded through an adhesive layer with the reflective layers 8 facing each other. In this case, the bonding of two pieces are carried out by forming the adhesive layer from a slow-acting resin and applying heat and pressure. In the case where the protective layer is provided on the reflective layer 8, an information recording medium of the double-sided structure is obtained by bonding two layered pieces in which the layers up to the protective layer are formed, with the protective layers facing each other.

Next, the method for producing the information recording medium 25 of Embodiment 1 is described. The information recording medium 25 is produced by carrying out the process in which the substrate 1 where the guide groove (the groove surface 23 and the land surface 24) is formed is set in a film-forming device, and then the first dielectric layer 2 is formed on the surface of the substrate 1 where the guide groove is formed (Process a), the process in which the recording layer 4 is formed (Process b), the process in which the second dielectric layer 6 is formed (Process c), the process in which the optical compensation layer 7 is formed (Process d), and the process in which the reflective layer 8 is formed (Process e) in this order, and further carrying out the process in which the adhesive layer 9 is formed on the surface of the reflective layer 8, and the process in which the dummy substrate 10 is bonded. In this specification including the following description, unless otherwise indicated, the "surface" of each layer means the surface (vertical to the thickness direction) which is exposed when each layer is formed.

First, Process a in which the first dielectric layer 2 is formed on the surface of the substrate 1 in which the guide groove is formed is carried out. Process a is carried out by sputtering. The sputtering is conducted in Ar gas atmosphere or in a mixed-gas atmosphere of Ar gas and oxygen using a high frequency electric power unit.

As the sputtering target used in Process a, the target which substantially consists of material which is expressed with the above formula (110), i.e. (ZrO₂)ₘ(Cr₂O₃)₁₀₀₋ₘ (mol %) wherein m is within the range of 20 ≤ m ≤ 80, may be used. By using this target, the layer which substantially consists of the material expressed with the above-mentioned formula (11) is formed.

The sputtering target may substantially consist of material which is expressed with the formula (210), i.e. (ZrO₂)ₓ(Cr₂O₃)_{y}(SiO₂)_{100-x-y} (mol %) wherein x and y are respectively within the range of 20 ≤ x ≤ 70 and 20 ≤ y ≤ 60, and satisfy 60 ≤ x+y ≤ 90. By using this target, the layer which substantially consists of the material expressed with the above-mentioned formula (21) is formed.

The sputtering target may substantially consist of material which is expressed with the above-mentioned formula (220) i.e. (ZrSiO₄)_{z}(Cr₂O₃)_{100-z} (mol %) wherein z is within the range of 25 ≤ z ≤ 67. By using this target, the layer which substantially consists of the material expressed with the formula (22) is formed.

The sputtering target may substantially consist of material which is expressed with the above-mentioned formula (30), i.e. (ZrO₂)_{c}(Cr₂O₃)ₑ(D)_{f}(SiO₂)_{100-c-e-f} (mol %) wherein D is ZnS, ZnSe or ZnO, c, e, and f are respectively within the range of 20 ≤ c ≤ 60, 20 ≤ e ≤ 60, and 10 ≤ f ≤ 40, and satisfy 60 ≤ c+e+f ≤ 90. By using this target, the layer which substantially consists of the material expressed with the formula (3) is formed.

The sputtering target may substantially consist of material which is expressed with the above-mentioned formula (310), i.e. (ZrSiO₄)ₐ(Cr₂O₃)_{b}(D)_{100-a-b} (mol %) wherein D is ZnS, ZnSe or ZnO, a and b are respectively within the range of 25 ≤ a ≤ 54, and 25 ≤ b ≤ 63, and satisfy 50 ≤ a+b ≤ 88. By using this target, the layer which substantially consists of the material expressed with the formula (31) is formed.

Next, Process b is carried out by forming the recording layer 4 on the surface of the first dielectric layer 2. Process b is also carried out by sputtering. The sputtering is conducted in Ar gas atmosphere or in a mixed-gas atmosphere of Ar gas and N₂ gas using a direct-current power source. A sputtering target which contains any one material selected from Ge-Sb-Te, Ge-Sn-Sb-Te, Ge-Bi-Te, Ge-Sn-Bi-Te, Ge-Sb-Bi-Te, Ge-Sn-Sb-Bi-Te, Ag-In-Sb-Te, and Sb-Te is used. The recording layer 4 after film formation is in an amorphous state.

Next, Process c is conducted by forming the second dielectric layer 6 on the surface of the recording layer 4. Process c is carried out in the same manner as Process a. The second dielectric layer 6 may be formed using a sputtering target consisting of a material which differs from that of the first dielectric layer 2.

Next, Process d is carried out by forming the optical compensation layer 7 on the surface of the second dielectric layer 6. In Process d, the sputtering is carried out using a direct-current power source or a high frequency electric power unit. A sputtering target which consists of a material selected from amorphous Ge alloys, such as Ge-Cr and Ge-Mo, amorphous Si alloys, such as Si-Cr and Si-Mo, telluride, and crystalline metal, such as Ti, Zr, Nb, Ta, Cr, Mo, W, SnTe and PbTe, semimetal, semiconductor material and so on, is used. Generally, the sputtering is conducted in Ar gas atmosphere.

Next, Process e is conducted by forming the reflective layer 8 on the surface of the optical compensation layer 7. Process e is carried out by sputtering. The sputtering is conducted in Ar gas atmosphere using a direct current power source or a high frequency electric power unit. A sputtering target which consists of alloy material, such as Al-Cr, Al-Ti, Ag-Pd, Ag-Pd-Cu, Ag-Pd-Ti, or Au-Cr, may be used.

As mentioned above, Processes a-e are all sputtering processes. Therefore, Processes a-e may be conducted successively by changing the target in order in one sputtering device. Alternatively, each of Processes a-e may be conducted using an independent sputtering device.

After forming the reflective layer 8, the substrate 1 on which the layers from the first dielectric layer 2 to the reflective layer 8 are formed in order is picked out from the sputtering device. Then, an ultraviolet-curing resin is applied to the surface of the reflective layer 8, for example, by a spin coat method. The dummy substrate 10 is stuck to the applied ultraviolet-curing resin. An ultraviolet ray is applied from the dummy substrate 10 side to cure the resin, whereby the bonding process is finished.

After finishing the bonding process, an initialization process is carried out if necessary. The initialization process is a process in which the temperature of the recording layer 4 which is in an amorphous state is raised to a temperature more than the crystallization temperature so as to crystallize the layer, for example, by irradiation of a semiconductor laser. The initialization process may be carried out before the bonding process. In this manner, the information recording medium 25 of Embodiment 1 can be produced by implementing Processes a-e, the process of forming the adhesive layer, and the bonding process of the dummy substrate in order.

### (Embodiment 2)

As Embodiment 2 of the present invention, another example of the optical information recording medium on or from which information is recorded or reproduced by using a laser beam, is described. Figure 2 shows the partial cross section of the optical information recording medium.

The information recording medium 26 shown in Figure 2 has a constitution in which a first dielectric layer 2, a recording layer 4, a second interface layer 105, a second dielectric layer 106, an optical compensation layer 7, and a reflective layer 8 are formed on one surface of a substrate 1 in this order, and furthermore a dummy substrate 10 is adhered with an adhesive layer 9. The information recording medium 26 shown in Figure 2 is different from the prior art information recording medium 31 shown in Figure 10 in that it does not have the first interface layer 103. Moreover, the information recording medium 26 is different from the information recording medium 25 of Embodiment 1 shown in Figure 1 in that the second dielectric layer 106 is formed on the recording layer 4 with the second interface layer 105 therebetween. In the information recording medium 26, the first dielectric layer 2 is a Zr-Cr-O-based material layer or a Zr-Cr-Zn-O-based material layer like Embodiment 1. In addition, in Figure 2, the reference numerals which are identical to those used in Figure 1 denote identical components which are formed from the material and by the method described with reference to Figure 1. Therefore, as to the components already described in connection with Figure 1, the detailed description is omitted.

The information recording medium 26 of this embodiment has a constitution in which the second dielectric layer 106 is formed from ZnS-20 mol % SiO₂ used for the prior art information recording medium. Therefore, the second interface layer 105 is provided in order to prevent the material transfer caused between the second dielectric layer 106 and the recording layer 4 due to repeated recording. The second interface layer 105 is formed from nitride such as Si-N, Al-N, Zr-N, Ti-N, Ge-N, or Ta-N, the nitride oxide containing one or more compounds of these, or carbide such as SiC. Alternatively, the second interface layer 105 may be a Zr-Cr-O-based material layer or a Zr-Cr-Zn-O-based material. The thickness of the interface layer is preferably in the range of 1 to 10 nm, and more preferably from 2 to 7 nm. If the thickness of the interface layer is large, the recording and erasing performance is affected because of the change of the optical reflectance and the optical absorptance of the multilayered body which consists of the layers from the first dielectric layer 2 to the reflective layer 8 and is formed on the surface of the substrate 1.

Next, the method for producing the information recording medium 26 of Embodiment 2 is described. The information recording medium 26 is produced by carrying out the process in which the first dielectric layer 2 is formed on the surface of the substrate 1 on which the guide groove is formed (Process a), the process in which the recording layer 4 is formed (Process b), the process in which the second interface layer 105 is formed (Process f), the process in which the second dielectric layer 106 is formed (Process g), the process in which the optical compensation layer 7 is formed (Process d) and the process in which the reflective layer 8 is formed (Process e) in this order, and further carrying out the process in which the adhesive layer 9 is formed on the surface of the reflective layer 8, and the process in which the dummy substrate 10 is bonded. Since Processes a, b, d, and e are as described in relation to Embodiment 1, the description of these processes is omitted here. Hereafter, only the processes not carried out in the production of the information recording medium of Embodiment 1 are described.

Process f is a process which is carried out after forming the recording layer 4, in order to form the second interface layer 105 on the surface of the recording layer 4. In Process f, the sputtering is conducted using a high frequency electric power unit. The sputtering may be a reactive sputtering which is conducted, for example, in a mixed-gas atmosphere of Ar gas and N₂ gas, using a sputtering target containing Ge. According to this reactive sputtering, the interface layer containing Ge-N is formed on the surface of the recording layer 4.

Next, Process g is carried out in order to form the second dielectric layer 106 on the surface of the second interface layer 105. In Process g, the sputtering is conducted, for example, in Ar gas atmosphere or a mixed-gas atmosphere of Ar gas and O₂ gas, using a high frequency electric power unit and a sputtering target consisting of ZnS-20 mol % SiO₂. Thereby, the layer consisting of ZnS-20 mol % SiO₂ is formed. After finishing the process in which the dummy substrate 10 is bonded, the initialization process is carried out if necessary as described in relation to Embodiment 1. The information recording medium 26 is thus obtained.

### (Embodiment 3)

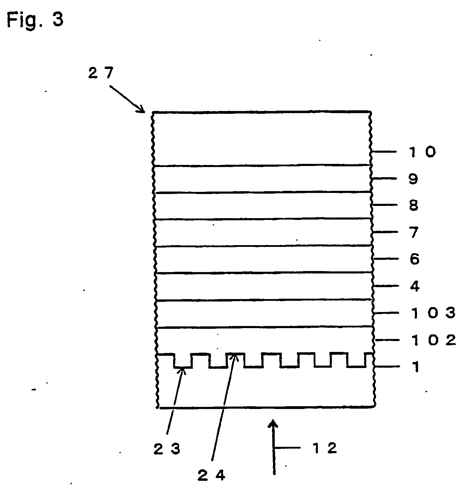

As Embodiment 3 of the present invention, another example of the optical information recording medium on or from which information is recorded or reproduced by using a laser beam, is described. Figure 3 shows the partial cross section of the optical information recording medium.

The information recording medium 27 shown in Figure 3 has a constitution in which a first dielectric layer 102, a first interface layer 103, a recording layer 4, a second dielectric layer 6, an optical compensation layer 7, and a reflective layer 8 are formed on one surface of a substrate 1 in this order, and furthermore a dummy substrate 10 is bonded with an adhesive layer 9. The information recording medium 27 shown in Figure 3 is different from the prior art information recording medium 31 shown in Figure 10 in that it does not have the second interface layer 105. Moreover, the information recording medium 27 is different from the information recording medium 25 of Embodiment 1 shown in Figure 1 in that the first dielectric layer 102 and the first interface layer 103 are formed between the substrate 1 and the recording layer 4 in this order. In the information recording medium 27, the second dielectric layer 6 is a Zr-Cr-O-based material layer or a Zr-Cr-Zn-O-based material layer like Embodiment 1. In addition, in Figure 3, the reference numerals which are identical to those used in Figure 1 denote identical components which are formed from the material and by the method described with reference to Figure 1. Therefore, the detailed description as to the components already described in connection with Figure 1, is omitted.

The information recording medium 27 of this embodiment has a constitution in which the first dielectric layer 102 is formed from ZnS-20 mol % SiO₂ used for the prior art information recording medium. Therefore, the first interface layer 103 is provided in order to prevent the material transfer caused between the first dielectric layer 102 and the recording layer 4 due to repeated recording. The preferable material and thickness of the first interface layer 103 are the same as those of the second interface layer 105 of the information recording medium 26 of Embodiment 2 described with reference to Figure 2. Therefore, detailed description about it is omitted.

Next, the method for producing the information recording medium 27 of Embodiment 3 is described. The information recording medium 27 is produced by carrying out the process in which the first dielectric layer 102 is formed on the surface of the substrate 1 where the guide groove is formed (Process h), the process in which the first interface layer 103 is formed (Process i), the process in which the recording layer 4 is formed (Process b), the process in which the second dielectric layer 6 is formed (Process c), the process in which the optical compensation layer 7 is formed (Process d), and the process in which the reflective layer 8 is formed (Process e) in this order, and further carrying out the process in which the adhesive layer 9 is formed on the surface of the reflective layer 8, and the process in which the dummy substrate 10 is bonded. Since Processes b, c, d and e are as described in relation to Embodiment 1, the description of these processes is omitted here. Hereafter, only the processes not carried out in the production of the information recording medium of Embodiment 1 are described.

Process h is a process in which the first dielectric layer 102 is formed on the surface of the substrate 1. The method is the same as that of Process g which is described in relation to the producing method of Embodiment 2. Process i is a process in which the first interface layer 103 is formed on the surface of the first dielectric layer 102. The method is the same as that of Process f described in relation to the producing method of Embodiment 2. After finishing the process in which the dummy substrate 10 is bonded, the initialization process is carried out if necessary as described in relation to Embodiment 1. The information recording medium 27 is thus obtained.

### (Embodiment 4)

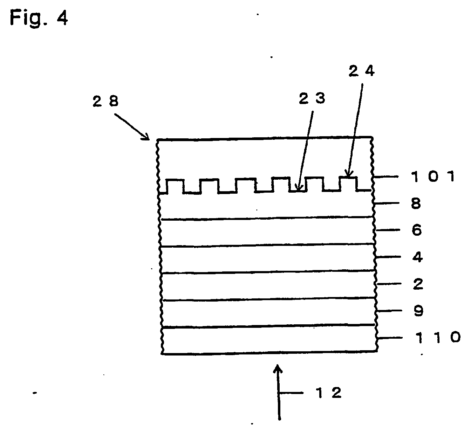

As Embodiment 4 of the present invention, another example of the optical information recording medium on or from which information is recorded or reproduced by using a laser beam, is described. Figure 4 shows the partial cross section of the optical information recording medium.

The information recording medium 28 shown in Figure 4 has a constitution in which a reflective layer 8, a second dielectric layer 6, a recording layer 4, and a first dielectric layer 2 are formed on one surface of a substrate 101 in this order, and further a dummy substrate 110 is bonded with an adhesive layer 9. This information recording medium 28 is different from the prior art information recording medium 31 shown in Figure 10 in that it does not have the first interface layer 103 and the second interface layer 105. Moreover, the information recording medium of this constitution is different from the information recording medium 25 which has the constitution shown in Figure 1 in that it does not have the optical compensation layer 7.

A laser beam 12 is applied to the information recording medium 28 of this constitution from the dummy substrate 110 side, and thereby, information is recorded or reproduced. In order to make the recording density of the information recording medium high, it is necessary to form small record marks in the recording layer by narrowing a laser beam as well as using a laser beam of short wavelength. In order to narrow the beam, it is necessary to make the numerical aperture NA of an objective lens larger. However, a focal position becomes shallow when NA becomes large. Therefore, the substrate to which a laser beam is applied needs to be made thin. In the information recording medium 28 shown in Figure 4, the thickness of the dummy substrate 110 can be made small, since the substrate 110 to which the laser beam is applied does not need to have a function as a support at the time of forming the recording layer and so on. Therefore, by employing this constitution, it is possible to obtain a large capacity information recording medium 28 on which information can be recorded with a higher density. Specifically, by employing this constitution, it is possible to obtain a 25GB information recording medium on or from which information is recorded or reproduced by using a laser beam with a wavelength of about 405 nm in a bluish-violet wavelength region.

Also in this information recording medium, the first and the second dielectric layers 2 and 6 are a Zr-Cr-O-based material layer or a Zr-Cr-Zn-O-based material layer like Embodiment 1. A Zr-Cr-O-based material layer and a Zr-Cr-Zn-O-based material layer are used as the dielectric layer irrespective of the formation order of the reflective layer and so on, and recording capacity. Since the material contained in the Zr-Cr-O-based material layer and the Zr-Cr-Zn-O-based material layer is as described in relation to Embodiment 1, detailed description thereof is omitted.

As mentioned above, this information recording medium 28 is suitable for recording and reproducing by a laser beam of a short wavelength. Therefore, the thickness of each of the first and the second dielectric layers 2 and 6 is determined from a preferable optical path length on the assumption that λ is, for example, 405 nm. In order to improve signal quality by increasing the reproduced signal amplitude of the record mark on the information recording medium 28, the optical path length "nd" of each of the first dielectric layer 2 and the second dielectric layer 6 is strictly determined by calculation based on the matrix method so as to satisfy, for example, 20 % ≤ Rc, and Ra ≤ 5 %. As a result, when the Zr-Cr-O-based material layer or the Zr-Cr-Zn-O-based material layer having the above refractive index is made into the first and the second dielectric layers 2 and 6, it was found that the thickness of the first dielectric layer 2 is preferably in the range of 30 nm to 100 nm, and more preferably from 50 nm to 80 nm. Moreover, It was found that the thickness of the second dielectric layer 6 is preferably in the range of 3 nm to 50 nm, and more preferably from 10 nm to 30 nm.

The substrate 101 is a transparent disc-shaped plate like the substrate 1 of Embodiment 1. The guide groove for guiding a laser beam may be formed in the surface of substrate 101 where the reflective layer and so on is formed. When forming the guide groove, like Embodiment 1, the surface 23 is referred to as the "groove surface", whereas the surface 24 is referred to as the "land surface." In the substrate 101, the distance in the thickness direction between the groove surface 23 and the land surface 24 (i.e. the depth of groove) is preferably in the range of 10 nm to 30 nm, and more preferably from 15 nm to 25 nm. Moreover, it is desirable that the surface where a layer is not formed is flat. The material for the substrate 1 of Embodiment 1 can be used as the material for the substrate 101. Preferably, the thickness of the substrate 101 is in the range of about 1.0 to 1.2 mm. The preferable thickness of the substrate 101 is larger than that of the substrate 1 of Embodiment 1. This is because, as mentioned below, the thickness of the dummy substrate 110 is thin, and therefore, the substrate 101 needs to ensure the strength of the information recording medium.

The dummy substrate 110 is a transparent disc-shaped plate like the substrate 101. As mentioned above, by employing the constitution shown in Figure 4, it is possible to record information with the laser beam of a short wavelength by making the thickness of the dummy substrate 110 small. Therefore, the thickness of the dummy substrate 110 is preferably in the range of 40 µm to 110 µm. More preferably, the thickness of the adhesive layer 9 and the dummy substrate 110 in total is in the range of 50 µm to 120 µm.

Since the dummy substrate 110 is thin, the substrate is preferably formed from a resin like a polycarbonate, an amorphous polyolefin, or PMMA. The polycarbonate is particularly preferable. Moreover, since the dummy substrate 110 is located so that the laser-beam 12 reaches it first, it is preferable that the substrate has an optical characteristic of small birefringence with respect to a light in a short wavelength region.

Preferably, the adhesive layer 9 is formed from a transparent ultraviolet-curing resin. The thickness of the adhesive layer 9 is preferably in the range of 5 to 15µm. The dummy substrate 110 can be omitted, when the adhesive layer 9 also provides the function of the dummy substrate 110 and is formed so as to have a thickness in the range of 50 µm to 120 µm.

In addition, the components identified with the reference numeral which is identical to those used in Embodiment 1 are as already described in relation to Embodiment 1, and therefore the description thereof is omitted.

In a variation of the information recording medium of this embodiment, for example, only the first dielectric layer is formed from a Zr-Cr-O-based material layer or a Zr-Cr-Zn-O-based material layer, and the second dielectric layer is formed from ZnS-20 mol % SiO₂, and the second interface layer is formed between the second dielectric layer and the recording layer. Moreover, in another variation of the information recording medium of this embodiment, only the second dielectric layer is formed from a Zr-Cr-O-based material or a Zr-Cr-Zn-O-based material layer, and the first dielectric layer is formed from ZnS-20 mol % SiO₂, and the first interface layer is formed between the first dielectric layer and the recording layer.

Next, the method for producing the information recording medium 28 of Embodiment 4 is described. The information recording medium 28 is produced by carrying out the process in which the substrate 101 where the guide groove (the groove surface 23 and the land surface 24) is formed is set in a film-forming device, and the reflective layer 8 is formed on the surface of the substrate 101 on which the guide groove is formed (Process e), the process in which the second dielectric layer 6 is formed (Process c), the process in which the recording layer 4 is formed (Process b), and the process in which the first dielectric layer 2 is formed (Process a) in this order, and further carrying out the process in which the adhesive layer 9 is formed on the surface of the first dielectric layer 2, and the process in which the dummy substrate (110) is bonded.

First, Process e is carried out in order to form the reflective layer 8 on the surface of the substrate 101 where the guide groove is formed. The method for carrying out Process e is as described in relation to Embodiment 1. Next, Process c, Process b, and Process a are carried out in this order. The method for carrying out Processes c, b, and a is as described in relation to Embodiment 1. In the producing method of the information recording medium of this embodiment, the order of carrying out each process differs from that in the producing method of the information recording medium of Embodiment 1.

After forming the first dielectric layer 2, the substrate 101 on which the layers from the reflective layer 8 to the first dielectric layer 2 are stacked in order is picked out from the sputtering device. Then, an ultraviolet-curing resin is applied on the first dielectric layer 2, for example, by a spin coat method. The dummy substrate 110 is stuck to the applied ultraviolet-curing resin. An ultraviolet ray is applied from the dummy substrate 110 side to cure the resin, whereby the bonding process is finished. The process for bonding the dummy substrate 110 can be omitted by forming the adhesive layer 9 into thickness of 60 µm to 120 µm and applying an ultraviolet ray thereto.

After finishing the bonding process, the initialization process is conducted if necessary. The method of the initialization process is as described in relation to Embodiment 1.

### (Embodiment 5)

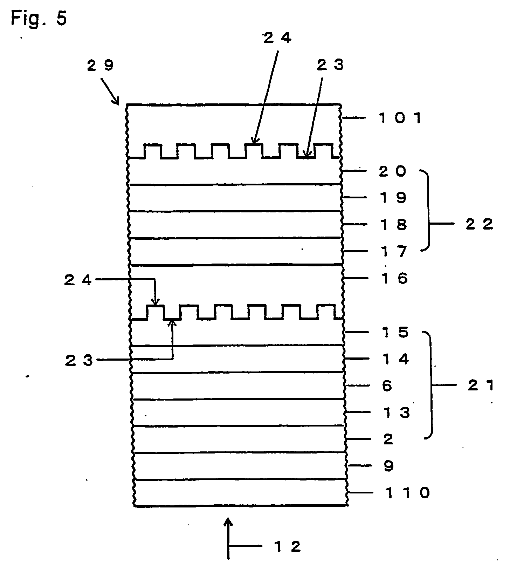

As Embodiment 5, another example of the optical information recording medium on or from which information is recorded or reproduced by using a laser beam, is described. Figure 5 shows the partial cross section of the optical information recording medium.

The information recording medium 29 shown in Figure 5 has a constitution in which a second information layer 22, an intermediate layer 16, and a first information layer 21 are formed on one surface of a substrate 101 in this order, and furthermore a dummy substrate 110 is bonded with an adhesive layer 9. In detail, the second information layer 22 is formed by stacking a second reflective layer 20, a fifth dielectric layer 19, a second recording layer 18, and a fourth dielectric layer 17 on one surface of the substrate 101 in this order. The intermediate layer 16 is formed on the surface of the fourth dielectric layer 17. The first information layer 21 is formed by stacking a third dielectric layer 15, a first reflective layer 14, a second dielectric layer 6, a first recording layer 13, and a first dielectric layer 2 on the surface of the intermediate layer 16 in this order. Also in this embodiment, a laser beam 12 is applied from the dummy substrate 110 side. Moreover, in the information recording medium of this embodiment, information can be recorded in each of the two recording layers. Therefore, by employing this constitution, the information recording medium which has about double the capacity of Embodiment 4, can be obtained. Specifically, by employing this constitution, it is possible to obtain a 50GB information recording medium in which information is recorded by a laser beam with a wavelength of about 405 nm in a bluish-violet wavelength region.

The recording in and reproducing from the first information layer 21 is conducted by the laser beam 12 which has passed through the dummy substrate 110. The recording in and reproducing from the second information layer 22 is conducted by the laser beam 12 which has passed through the dummy substrate 110, the first information layer 21, and the intermediate layer 16.

Also in the information recording medium 29 of the embodiment shown in Figure 5, the fifth dielectric layer 19, the fourth dielectric layer 17, the second dielectric layer 6, and the first dielectric layer 2 are preferably all a Zr-Cr-O-based material layer or a Zr-Cr-Zn-O-based material layer. If those material layers are used, it is not necessary to form an interface layer between the first recording layer 13 and the first dielectric layers 2, between the first recording layer 13 and the second dielectric layer 6, between the second recording layer 18 and the fourth dielectric layes 17, and between the second recording layer 18 and the fifth dielectric layer 19. Since the material for the Zr-Cr-O-based material layer or the Zr-Cr-Zn-O-based material layer is as described in relation to Embodiment 1, the detailed description thereof is omitted.

Each of the fifth dielectric layer 19 and the second dielectric layer 6 serves as a thermal insulating layer between the reflective layer and the recording layer. Therefore, each of the fifth and the second dielectric layers 19 and 6 is preferably the layer which substantially consists of material expressed with the formula (ZrO₂)_{X}(Cr₂O₃)_{Y}(SiO₂)_{100-X-Y} (i.e. the formula (21)), or the material expressed with the formula (ZrO₂)_{C}(Cr₂O₃) _{E}(D)_{F}(SiO₂)_{100-C-E-F} (i.e. the formula (3)). Moreover, the film thickness of each of the fifth and the second dielectric layers 19 and 6 is preferably in the range of 3 nm to 50 nm, and more preferably from 10 nm to 30 nm.

The fourth dielectric layer 17 and the first dielectric layer 2 are the layers through which the laser beam 12 passes before reaching the recording layers 18 and 13 in the second information layer 22 and the first information layer 21, respectively. Therefore, it is desirable that the fourth and the first dielectric layers 17 and 2 consist of a transparent material with low thermal conductivity. Such material is the material expressed with the above-mentioned formulae (21) and (3). Preferably, the film thickness of each of fourth and the first dielectric layers 17 and 2 is in the range of 30 nm to 100 nm, and more preferably from 50 nm to 80 nm.

Thus, also in the information recording medium of the single-sided dual-layer structure shown in Figure 5, the Zr-Cr-O-based material layer or the Zr-Cr-Zn-O-based material layer makes it possible to form the dielectric layer located on both sides of the recording layer in direct contact with the recording layer without the interface layer. Therefore, according to this invention, the number of the layers which compose the whole medium can be reduced, also as to the information recording medium of the single-sided dual-layer structure. Moreover, by forming the dielectric layer from the above specific material layers, the refractive index and the recording sensitivity of the medium are adjusted so as to be optimized depending on the kind of information recording medium.

The third dielectric layer 15 is located between the intermediate layer 16 and the first reflective layer 14. The third dielectric layer 15 is preferably transparent and has a high refractive index so that it may serve to enhance the transmissivity of the first information layer 21. Moreover, the third dielectric layer 15 preferably consists of the material with higher thermal conductivity so that if serves to diffuse the heat of the first recording layer 13 quickly, like the reflective layer. The material which satisfies these conditions is TiO₂ and Cr₂O₃. Further, the material expressed with (ZrO₂)_{M}(Cr₂O₃)_{100-M} (i.e. the above-mentioned formula (11)) is also preferably used. In the case of forming the third dielectric layer 15 from the material expressed with the formula (11), it is preferable to adjust thermal conductivity by varying the composition on the condition where the ratio of Cr₂O₃ is 40 mol % or more. When TiO₂ Cr₂O₃, or (ZrO₂)M(Cr₂O₃)_{100-M} is used, the large refractive index of 2.4 to 2.8 is obtained. The film thickness of the third dielectric layer 15 is preferably in the range of 10 nm to 30 nm.

The substrate 101 is the same as the substrate 101 of Embodiment 4. Therefore, the detailed description about the substrate 101 is omitted here.

The second reflective layer 20 is the same as the reflective layer 8 of Embodiment 1. Further, the second recording layer 18 is the same as the recording layer 4 of Embodiment 1. Therefore, the detailed description about the second reflective layer 20 and the second recording layer 18 is omitted here.

The intermediate layer 16 is provided in order to make the focal position of the laser beam in the first information layer 21 significantly differ from the focal position in the second information layer 22. In the intermediate layer 16, the guide groove is optionally formed on the first information layer 21 side. The intermediate layer 16 can be formed from an ultraviolet-curing resin. It is desirable that the intermediate layer 16 is transparent with respect to the light of the wavelength λ used for recording and reproducing information so that the laser beam 12 can reach the second information layer 22 efficiently. The thickness of the intermediate layer 16 needs to be equal to or more than the focal depth ΔZ determined by the numerical aperture NA of an objective lens and the laser beam wavelength λ. ΔZ can be approximated to be ΔZ=λ/{2(NA)²}. When λ is 405 nm, and NA is 0.85, ΔZ becomes ΔZ=0.28 µm. Further, since the range within ±0.3 µm of this value is included in the range of focal depth, the intermediate layer 16 needs to have a thickness of 0.8 µm or more. Furthermore, the total thickness of the intermediate layer 16 and the dummy substrate 110 is preferably set within a tolerance of substrate thickness acceptable to the objective lens to be used, so that the distance between the first recording layer 13 of the first information layer 21 and second recording layer 18 of the second information layer 22 may be within the range where the objective lens can concentrate light. Therefore, the thickness of the intermediate layer is preferably in the range of 10 µm to 40 µm.

If necessary, the intermediate layer 16 may be constituted by stacking a plurality of resin layers. Specifically, it may have a two-layer structure consisting of a layer which protects the fourth dielectric layer 17, and a layer which has a guide groove.

The first reflective layer 14 serves to diffuse the heat of the first recording layer 13 quickly. When information is recorded in or reproduced from the second information layer 22, the laser beam 12 which has passed through the first information layer 21 is used. For this reason, the first information layer 21 needs to have a high transmissivity as a whole, and preferably has a transmissivity of 45 % or more. Therefore, the first reflective layer 14 is limited in the material and the thickness, compared with the second reflective layer 20. In order to decrease optical absorption by the first reflective layer 14, it is desirable that the first reflective layer 14 has a small thickness, a low extinction coefficient, and high thermal conductivity. Specifically, it is preferable that the first reflective layer 14 is made of an alloy containing Ag, and is formed into a film whose thickness is in the range of 5 nm to 15 nm.

In order to ensure the high transmissivity of the first information layer 21, the first recording layer 13 is also limited in the material and film thickness, compared with the second recording layer 18. The first recording layer 13 is preferably formed so that the average of the transmittance of the crystal phase and the transmittance of the amorphous phase becomes 45 % or more. Therefore, the film thickness of the first recording layer 13 is preferably 7 nm or less. The material which constitutes the first recording layer 13 is selected so that even if the layer is such a thin film, it is ensured that good record marks are formed by melting and quenching, and thereby the signal with high quality is reproduced, and that record marks are erased by temperature rising and gradual cooling. Specifically, it is preferable to form the first recording layer 13 from a reversible phase change material, for example, Ge-Sb-Te such as GeTe-Sb₂Te₃-based material or Ge-Sn-Sb-Te obtained by substituting Sn for part of Ge of GeTe-Sb₂Te₃-based material. Ge-Bi-Te such as GeTe-Bi₂Te₃-based material, or Ge-Sn-Bi-Te obtained by substituting Sn for part of Ge of Ge-Bi-Te may be used.

The adhesive layer 9 is preferably formed from a transparent ultraviolet-curing resin like the adhesive layer 9 of Embodiment 4. The thickness of the adhesive layer is preferably in the range of 5 to 15 µm.

The dummy substrate 110 is the same as the dummy substrate 110 of Embodiment 4. Therefore, the detailed description about the dummy substrate is omitted here. Also in this embodiment, the dummy substrate 110 can also be omitted, when the adhesive layer 9 also serves as the dummy substrate 110 and can be formed so as to have a thickness of 50 µm to 120 µm.

The information recording medium of a constitution having two information layers each of which has a recording layer is described above. The information recording medium which has a plurality of recording layers is not limited to this constitution. The medium can also have a constitution including three or more information layers. Further, in a variation of the illustrated embodiment, for example, one of the two information layers has one recording layer in which a reversible phase change is generated, and the other has one recording layer in which an irreversible phase change is generated.

Moreover, in a variation of the information recording medium which has three information layers, one is made into the read-only information layer, another has a recording layer in which a reversible phase change is generated, and the other has a recording layer in which an irreversible phase change is generated. Thus, there are many variations of the information recording medium which has two or more information layers. Also in any form, by forming a dielectric layer from a Zr-Cr-O-based material layer or a Zr-Cr-Zn-O-based material layer, the need of providing an interface layer between the recording layer and the dielectric layer can be eliminated.

Next, the method for producing the information recording medium 29 of Embodiment 5 is described. The information recording medium 29 is produced by carrying out the process in which the second reflective layer 20 is formed on the substrate 101 (Process j), the process in which the fifth dielectric layer 19 is formed (Process k), the process in which the second recording layer 18 is formed (Process I), and the process in which the fourth dielectric layer 17 is formed (Process m) in this order, and then carrying out the process in which the intermediate layer 16 is formed on the surface of the fourth dielectric layer 17, and further carrying out the process in which the third dielectric layer 15 is formed on the surface of the intermediate layer 16 (Process n), the process in which the first reflective layer 14 is formed (Process o), the process in which the second dielectric layer 6 is formed (Process p), the process in which the first recording layer 13 is formed (Process q), and the process in which the first dielectric layer 2 is formed (Process r) in this order, and furthermore carrying out the process in which the adhesive layer 9 is formed on the surface of the first dielectric layer 2, and the process in which the dummy substrate 110 is bonded.

Processes j to m correspond to the processes for forming the second information layer 22. Process j is a process in which the second reflective layer 20 is formed on the surface of the substrate 101 where the guide groove is formed. Process j is carried out in the same manner as Process e in the production of Embodiment 1. Next, Process k is carried out in order to form the fifth dielectric layer 19 on the surface of the second reflective layer 20. Process k is carried out in the same manner as Process c in the production of Embodiment 1. Next, Process I is carried out to form the second recording layer 18 on the surface of the fifth dielectric layer 19. Process I is carried out in the same manner as Process b in the production of Embodiment 1. Finally, Process m is carried out in order to form the fourth dielectric layer 17 on the surface of the second recording layer 18. Process m is carried out in the same manner as Process a in the production of Embodiment 1.

The substrate 101 on which the second information layer 22 is formed according to Processes j to m is picked out from the sputtering device, and then the intermediate layer 16 is formed. The intermediate layer 16 is formed according to the following procedures. First, an ultraviolet-curing resin is applied to the surface of the fourth dielectric layer 17 by, for example, a spin coat method. Next, a polycarbonate substrate on which the guide groove is formed is stuck to the ultraviolet-curing resin with the guide groove side in contact with the resin. After applying an ultraviolet ray and curing the resin, the polycarbonate substrate on which the guide groove is formed is peeled. Thereby, the guide groove is transferred to the ultraviolet-curing resin, and the intermediate layer 16 which has the illustrated guide groove is formed. Alternatively, the intermediate layer 16 may be formed by forming a layer from an ultraviolet-curing resin which protects the fourth dielectric layer 17, and then forming a layer having a guide groove thereon. In this case, the intermediate layer to be obtained has a two-layer structure.

The substrate 101 on which the layers up to the intermediate layer 16 are formed is again placed in a sputtering device, and then the first information layer 21 is formed on the surface of the intermediate layer 16. The processes for forming the first information layer 21 correspond to Processes n to r.

Process n is a process in which the third dielectric layer 15 is formed on the surface of the intermediate layer 16 on which the guide groove is formed. In process n, the sputtering is conducted in Ar gas atmosphere or in a mixed-gas atmosphere of Ar gas and O₂ gas, using a high frequency electric power unit and a sputtering target consisting of TiO₂ or Cr₂O₃. Alternatively, in Process n, the sputtering may be carried out in Ar gas atmosphere using a sputtering target consisting of a mixture of ZrO₂ and Cr₂O₃. Alternatively, in Process n, a reactive sputtering may be carried out in a mixed-gas atmosphere of Ar gas and O₂ gas using a sputtering target consisting of Ti or Cr.

Next, Process o is carried out in order to form the first reflective layer 14 on the surface of the third dielectric layer 15. In Process o, the sputtering is conducted in Ar gas atmosphere, using a direct current power source and a sputtering target of the alloy containing Ag.

Then, Process p is carried out in order to form the second dielectric layer 6 on the surface of 14 of the first reflective layer 14. Process p is carried out in the same manner as Process k.

Next, Process q is carried out in order to form the first recording layer 13 on the surface of the second dielectric layer 6. In Process q, the sputtering is conducted in Ar gas atmosphere or in a mixed-gas atmosphere of Ar gas and N₂ gas, using a direct current power source and a sputtering target consisting of a material selected from Ge-Sb-Te, Ge-Sn-Sb-Te, Ge-Bi-Te, Ge-Sn-Bi-Te, Ge-Sb-Bi-Te, and Ge-Sn-Sb-Bi-Te.

Next, Process r is carried out in order to form the first dielectric layer 2 on the surface of the first recording layer 13. Process r is carried out in the same manner as Process m. Thus, the first information layer 21 is formed by carrying out Processes n to r in this order.

The substrate 101 on which the first information layer 21 are formed is picked out from the sputtering device. Then, an ultraviolet-curing resin is applied to the surface of the first dielectric layer 2, for example, by a spin coat method. The dummy substrate 110 is stuck to the applied ultraviolet-curing resin. An ultraviolet ray is applied from the dummy substrate 110 side to cure the resin, whereby the bonding process is finished. Also in the producing method of the information recording medium of Embodiment 5, the process of bonding the dummy substrate 110 can also be omitted in the same manner as the producing method of the information recording medium of Embodiment 4.

After finishing the bonding process, the initialization process of the second information layer 22 and the first information layer 21 is carried out if necessary. The Initialization process of the second information layer 22 may be carried out before or after forming the intermediate layer, and the initialization process of the first information layer 21 may be carried out before or after the bonding process of the dummy substrate 110. The method for carrying out the initialization process is as described in relation to Embodiment 1.

### (Embodiment 6)

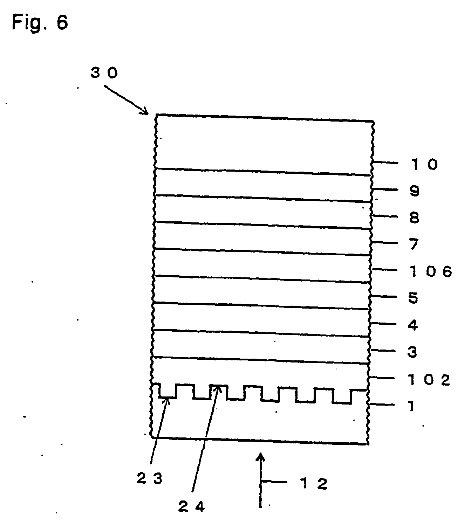

As Embodiment 6, another example of the information recording medium on or from which information is recorded or reproduced by using a laser beam, is described. Figure 6 shows the partial cross section of the optical information recording medium.

The information recording medium 30 shown in Figure 6 has a constitution in which a first dielectric layer 102, a first interface layer 3, a recording layer 4, a second interface layer 5, a second dielectric layer 106, an optical compensation layer 7, and a reflective layer 8 are formed on one surface of a substrate 1 in this order, and furthermore a dummy substrate 10 is bonded with an adhesive layer 9. In the information recording medium 30 shown in Figure 6, the first and the second interface layers 3 and 5 are a Zr-Cr-O-based material layer or a Zr-Cr-Zn-O-based material layer. In addition, in Figure 6, the reference numerals which are identical to those used in Figure 1 denote identical components which are formed from the material and by the method described with reference to Figure 1. Therefore, the detailed description is omitted as to the components already described with reference to Figure 1.

The information recording medium of this embodiment has a constitution in which the first and the second dielectric layers 102 and 106 are formed from ZnS-20 mol % SiO₂ used for the prior art information recording medium. In such constitution, a Zr-Cr-O-based material layer or a Zr-Cr-Zn-O-based material layer can be used as the first and second interface layers 3 and 5. The preferable materials for the first and the second interface layers 3 and 5 is the same as that for the first and the second dielectric layers 2 and 6 of Embodiment 1. Therefore, the detailed description about them is omitted. The thickness of the first and the second interface layers 3 and 5 is preferably in the range of 1 to 10 nm, and more preferably in the range of about 2 to 7 nm so that recording and erasing characteristic may not be affected. The interface layer which is the Zr-Cr-O-based material layer or the Zr-Cr-Zn-O-based material layer has the advantages that cost for the material is inexpensive, the extinction coefficient is low (i.e. transparency is high), and its melting point is high and then it is thermally stable, compared with the prior art interface layer consisting of the nitride containing Ge.

Next, the method for producing the information recording medium 30 of Embodiment 6 is described. The information recording medium 30 is produced by carrying out the process in which the first dielectric layer 102 is formed on the surface of the substrate 1 where the guide groove is formed (Process h), the process in which the first interface layer 3 is formed (Process s), the process in which the recording layer 4 is formed (Process b), the process in which the second interface layer 5 is formed (Process t), the process in which the second dielectric layer 106 is formed (Process g), the process in which the optical compensation layer 7 is formed (Process d), and the process in which the reflective layer 8 is formed (Process e) in this order, and further by carrying out the process in which the adhesive layer 9 is formed on the surface of the reflective layer 8, and the process in which the dummy substrate 10 is bonded. Processes b, d, and e are as described in relation to Embodiment 1, Process g is as described in relation to Embodiment 2, and Process h is as described in relation to Embodiment 3. Therefore, the description of these processes is omitted here.

Process s is a process in which the first interface layer 3 is formed on the surface of the first dielectric layer 102. Process s is carried out in the same manner as Process a in the production of Embodiment 1. Process t is a process in which the second interface layer 5 is formed on the surface of the recording layer 4. Process t is carried out in the same manner as Process c in the production of Embodiment 1.

In the above, the optical information recording media on or from which information is recorded or reproduced by a laser beam are described as embodiments of this invention with reference to Figures 1 to 6. The optical information recording medium of this invention is not limited to these embodiments. As long as a Zr-Cr-O-based material layer or a Zr-Cr-Zn-O-based material layer is provided, preferably in contact with a recording layer, as one of constitutive layers, the optical information recording medium of this invention may be embodied in other forms. Moreover, the optical information recording medium of this invention is suitable for recording with a laser beam of various wavelengths. Therefore, the optical information recording medium of this invention may be, for example, DVD-RAM or DVD-R on or from which information is recorded or reproduced by a laser beam with a wavelength between 630 and 680 nm, or a large capacity optical disk on or from which information is recorded or reproduced by a laser beam with a wavelength between 400 and 450 nm.

### (Embodiment 7)

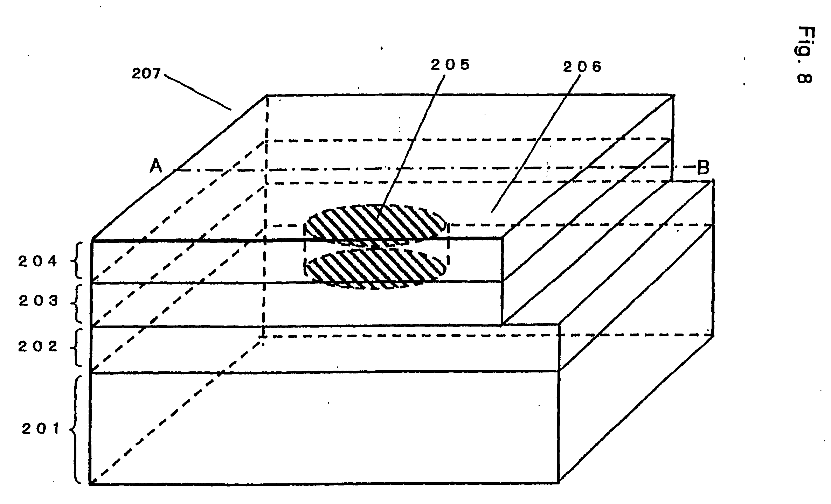

As Embodiment 7, an example of the information recording medium on or from which information is recorded or reproduced by applying an electric energy, is described. Figure 8 shows the partial cross section of the information recording medium.

Figure 8 shows a memory 207 in which a lower electrode 202, a recording part 203, and an upper electrode 204 are formed on the surface of a substrate 201 in this order. The recording part 203 of the memory 207 has a constitution including a cylinder shaped recording layer 205 and a dielectric layer 206 which encloses the recording layer 205. It differs from the optical information recording media described with reference to Figures 1 to 6. In the memory 207 of this embodiment, the recording layer 205 and the dielectric layer 206 are formed on the same surface, and they are not in the laminated relationship. However, since the recording layer 205 and the dielectric layer 206 both constitute part of the multilayered body including the substrate 201, the lower and the upper electrodes 202 and 204 in the memory 207, they can be each referred to as a "layer." Therefore, the information recording medium of this invention also includes an embodiment which has a recording layer and a dielectric layer on the same surface.

As the substrate 201, a semiconductor substrate, such as Si substrate, a polycarbonate substrate, or an insulating substrate such as a SiO₂ substrate and an Al₂O₃ substrate can be used. The lower electrode 202 and the upper electrode 204 are formed from a suitable electrically conductive material. The lower electrode 202 and the upper electrode 204 are formed by, for example, sputtering a metal such as Au, Ag, Pt, Al, Ti, W, Cr, or a mixture thereof.

The recording layer 205 which constitutes the recording part 203 consists of the material in which the phase change is generated by applying an electric energy. Therefore, the recording layer 205 can be referred to as "a phase-change part." The recording layer 205 is formed from the material in which the phase change between a crystal phase and an amorphous phase is caused by the Joule heat generated by applying an electric energy. As the material for the recording layer 205, for example, Ge-Sb-Te, Ge-Sn-Sb-Te, Ge-Bi-Te, Ge-Sn-Bi-Te, Ge-Sb-Bi-Te and Ge-Sn-Sb-Bi-Te-based material is used, and more specifically, a GeTe-Sb₂Te₃-based material or a GeTe-Bi₂Te₃-based material is used.

The dielectric layer 206 which constitutes the recording part 203 serves to prevent the current which flows the recording layer 205 by applying a voltage between the upper electrode 204 and the lower electrode 202, from escaping to the periphery part, and to insulate the recording layer 205 electrically and thermally. Therefore, the dielectric layer 206 can be also referred to as "a thermal insulating part." The dielectric layer 206 is a Zr-Cr-O-based material layer or a Zr-Cr-Zn-O-based material layer. Specifically, the layer is one which substantially consists of the material expressed with the above-mentioned formula (1), (11), (2), (21), (22), (3), or (31). The Zr-Cr-O-based material layer or the Zr-Cr-Zn-O-based material layer is preferably used because it has a high melting point, atoms in the material layer are difficult to diffuse even when the material is heated, and it has low thermal conductivity.

This memory 207 is further explained together with the operation method in the below-mentioned Example.

### EXAMPLES

### (Test 1)

First, the relationship of nominal composition of a Zr-Cr-O-based sputtering target used in the producing method of the information recording medium of this invention (in other words, the composition which a target manufacturer indicates in public when they sell it), its analyzed composition, and the analyzed composition of the Zr-Cr-O-based material layer formed by using this target, was examined.

In this test, the composition of sputtering targets consisting of ZrO₂-Cr₂O₃-based material which is one of Zr-Cr-O-based materials was analyzed in order to investigate the difference between the nominal composition and the analyzed composition. More specifically, the two kinds of sputtering targets of which nominal composition was indicated with the formula:

(ZrO₂)ₘ(Cr₂O₃)₁₀₀₋ₘ (mol %) (110).

were analyzed by a X-ray-microanalyser method. The values of "m" of the two targets were different from each other, one being m=20 and the other being m=80. The targets were powdered for the analysis. As a result, the analyzed composition of the sputtering targets was obtained not as the compound (i.e. oxide)-based composition formula that is expressed with the ratio of compounds, but as the elementary composition formula (10):

Zr_{J}Cr_{K}O_{100-J-K} (atomic %) (10).

The analyzed composition of the targets is shown in Table 1. Further, by theoretical calculation, the converted elementary composition was calculated from the nominal composition (mol %) which is oxide-based composition that is expressed with the ratio of oxide. The reduced composition (atomic %) is also shown in Table 1.

**Table 1**

| Sputtering Target | | Dielectric Layer |
|---|---|---|
| Nominal Composition (ZrO₂)ₘ(Cr₂O₃)₁₀₀₋ₘ (mol %) (= Reduced Composition (at. %)) | Analyzed Composition Zr_{J}Cr_{K}O_{100-J-K} (at. %) | Analyzed Composition Zr_{Q}Cr_{R}O_{100-Q-R} (at. %) |
| (ZrO₂)₂₀(Cr₂O₃)₈₀ (= Zr_{4.3}Cr_{34.8}O_{60.9}) | Zr₄Cr₃₅O₆₁ | Zr_{4.5}Cr_{34.5}O₆₁ |
| (ZrO₂)₈₀(Cr₂O₃)₂₀ (= Zr_{23.5}Cr_{11.8}O_{64.7}) | Zr₂₃Cr₁₂O₆₅ | Zr_{23.4}Cr_{11.8}O_{64.8} |

As shown in Table 1, as a result of analysis of the powder of the sputtering target of which nominal composition is indicated by the formula (110) i.e. (ZrO₂)ₘ(Cr₂O₃)₁₀₀₋ₘ (mol %), analyzed composition of Zr₄Cr₃₅O₆₁ (atomic %) was obtained as to the target of m= 20, and analyzed composition of Zr₂₃Cr₁₂O₆₅ (atomic %) was obtained as to the target of m=80. Each of these analyzed compositions was substantially equal to the reduced composition (atomic %) of the nominal composition (mol %). Therefore, it was found that when the target composition is indicated with the formula (110) i.e. (ZrO₂)ₘ(Cr₂O₃)₁₀₀₋ₘ (mol %) and "m" satisfies 20 ≤ m ≤ 80, its elementary composition is expressed with the formula (10), i.e. Zr_{J}Cr_{K}O_{100-J-K} (atomic %) in which j and K satisfy 3 ≤ J ≤ 24, 11 ≤ K ≤ 36, and 34 ≤ J+K ≤ 40.

Next, a Zr-Cr-O-based material layer was formed as a dielectric layer by a sputtering method using each sputtering target of which nominal composition (mol %) was as the above, and then, analyzed by a X-ray microanalyser method. Consequently, the analyzed composition of the dielectric layers was obtained as not the oxide-based composition formula (11):

(ZrO₂)_{M}(Cr₂O₃)_{100-M} (mol %) (11)

but as the elementary composition formula (1):

Zr_{Q}Cr_{R}O_{100-Q-R} (atomic %) (1).

The analyzed composition of the dielectric layers (Zr-Cr-O-based material layers) is shown in Table 1.

In this test, the dielectric layer was formed into 500 nm thick on a Si substrate by sputtering. In the sputtering process, the sputtering target (of 100 mm diameter and 6 mm thickness) of which nominal composition was as shown in Table 1 was set in a conventional film-forming device (sputtering device). The sputtering is carried out in an atmosphere of Ar gas (100 %) under conditions of a power of 500 W and a pressure of 0.13 Pa using a high frequency electric power unit.

The analyzed composition of the dielectric layer formed by sputtering using the sputtering target indicated by the formula (110), i.e. (ZrO₂)ₘ(Cr₂O₃)₁₀₀₋ₘ (mol %) was very close to both the reduced composition and the analyzed composition of the sputtering target.

Therefore, it is desirable that Q and R in the formula (1) of the analyzed composition of a dielectric layer satisfy 3 ≤ Q ≤24, 11 ≤ R ≤ 36, and 34 ≤ Q+R ≤ 40 like J and K in the formula (10) of the analyzed composition of a sputtering target. However, the composition of a dielectric layer may vary from another even when the same sputtering target is used, depending on the structure of a film-forming device, film-forming conditions, the size of a sputtering target, the composition of an atmosphere gas and so on. Considering such possibility of such variation, Q and R in the above-mentioned formula (1) preferably satisfy 0 < Q ≤ 30, 7 < R ≤ 37, and 20 ≤ Q+R ≤ 60, and more preferably 3 ≤ Q ≤ 24, 11 ≤ R ≤ 36, and 34 ≤ Q+R ≤ 40.

Generally, it is considered that Zr and Cr detected by the analysis of the dielectric layer each exist stably in the dielectric layer in the form of ZrO₂ and Cr₂O₃. Therefore, as shown in this test, when contents of Zr and Cr detected by the analysis of a sputtering target are substantially equal to the contents of Zr and Cr detected by the analysis of a dielectric layer, it is considered that the nominal composition (mol %) of a sputtering target is the same as that of the composition (mol %) of the dielectric layer formed by a sputtering method using this sputtering target. Consequently, it is considered that a dielectric layer (a Zr-Cr-O-based material layer) formed by a sputtering method using a sputtering target of which nominal composition is indicated by the formula (110), i.e. (ZrO₂)ₘ(Cr₂O₃)₁₀₀₋ₘ (mol %) is expressed with the formula (11), i.e. (ZrO₂)_{M}(Cr₂O₃)_{100-M} (mol %), and that "M" here is substantially the same as "m" in formula (110).

### (Test 2)

In this test, the composition of a sputtering target consisting of the ZrO₂-Cr₂O₃-SiO₂-based material which is one of Zr-Cr-O-based material was analyzed, and the difference between the nominal composition and the analyzed composition was investigated like the test 1. More specifically, three kinds of sputtering targets of which nominal composition was indicated with the formula (210):

(ZrO₂)ₓ(Cr₂O₃)_{y}(SiO₂)_{100-x-y} (mol %) (210).

were analyzed. The three kinds of sputtering targets have different values of x and y (x= 20 and y=60; x=70 and y=20; x=30 and y=30). The target were powdered for the analysis. As a result, the analyzed composition of the sputtering targets was not obtained as the oxide-based composition formula (210), but as the elementary composition formula (20):

Zr_{G}Cr_{H}Si_{L}O_{100-G-H-L} (atomic %) (20).

The analyzed composition of the target is shown in Table 2. Moreover, the reduced elementary composition (atomic %) calculated from the nominal composition of the sputtering targets is also shown in Table 2. In the reduced composition shown in Table 2, the total of the ratio of all elements is not 100 % for every target. This is because the reduced composition was obtained by rounding calculation.

**Table 2**

| Sputtering Target | | Dielectric Layer |
|---|---|---|
| Nominal Composition (ZrO₂)ₓ(Cr₂O₃)_{y}(SiO₂)_{100-x-y} (mol %) (= Reduced Composition (at. %)) | Analyzed Composition Zr_{G}Cr_{H}Si_{L}O_{100-G-H-L} (at. %) | Analyzed Composition Zr_{U}Cr_{V}Si_{T}O_{100-U-V-T} (at. %) |
| (ZrO₂)₂₀(Cr₂O₃)₆₀(SiO₂)₂₀ (= Zr_{4.8}Cr_{28.6}Si_{4.8}O_{61.9}) | Zr_{4.8}Cr₂₉Si_{4.5}O_{61.7} | Zr_{5.1}Cr_{28.5}Si_{4.8}O_{61.6} |
| (ZrO₂)₇₀(Cr₂O₃)₂₀(SiO₂)₁₀ (=Zr_{20.6}Cr_{11.8}Si_{2.9}O_{64.7}) | Zr_{20.6}Cr_{11.8}Si_{2.5}O_{65.1} | Zr₂₁Cr_{11.4}Si_{2.8}O_{64.8} |
| (ZrO₂)₃₀(Cr₂O₃)₃₀(SiO₂)₄₀ (= Zr_{8.3}Cr_{16.7}Si_{11.1}O_{63.9}) | Zr₈Cr₁₇Si₁₁O₆₄ | Zr_{8.3}Cr_{16.5}Si_{11.3}O_{63.9} |

As shown in Table 2, as a result of analysis of the powder of the sputtering target of which nominal composition indicated by the formula (210), i.e. (ZrO₂)ₓ(Cr₂O₃)_{y}(SiO₂)_{100-x-y} (mol %), analyzed composition of Zr_{4.8}Cr₂₉Si_{4.5}O_{61.7} (atomic %) was obtained as to the target of x=20 and y=60, and analyzed composition of Zr_{20.6}Cr_{11.8}Si_{2.5}O_{65.1} (atomic %) was obtained as to the target of x=70 and y=20, and analyzed composition of Zr₈Cr₁₇Si₁₁O₆₄ (atomic %) was obtained as to the target of x=30 and y=30. Each of these analyzed compositions was substantially equal to the reduced composition (atomic %) of the nominal composition (mol %). Therefore, it was found that when the target is indicated with the formula (210), i.e. (ZrO₂)ₓ(Cr₂O₃)_{y}(SiO₂)_{100-x-y}. (mol %) and x and y satisfy 60 ≤ x+y ≤ 90, 20 ≤ x ≤ 70, and 20 ≤ y ≤ 60, its elementary composition is expressed with the formula (20), i.e. Zr_{G}Cr_{H}Si_{L}O_{100-G-H-L} (atomic %) in which G, H and L satisfy 4 ≤ G ≤ 21, and 11 ≤ H ≤ 30, 2 ≤ L ≤ 12, and 34 ≤ G+H+L ≤ 40.

Next, a Zr-Cr-O-based material layer was formed as a dielectric layer by a sputtering method using each of three sputtering target of which nominal composition was as the above. The analysis is carried out in the same manner as the test 1. Consequently, the analyzed composition of the dielectric was obtained as not the oxide-based composition formula (21):

(ZrO₂)_{X}(Cr₂O₃)_{Y}(SiO₂)_{100-X-Y} (mol %) (21).

but as the elementary composition formula (2):

Zr_{U}Cr_{V}Si_{T}O_{100-U-V-T} (atomic %) (2).

The analyzed composition of the dielectric layers (Zr-Cr-O-based material layers) is shown in Table 2.

In this test, the dielectric layer was formed into 500 nm thick on a carbon (C) substrate by sputtering using the target with the nominal composition shown in Table 2 under the sputtering conditions as that employed in the test 1.

The analyzed composition of the dielectric layer formed by a sputtering method using the sputtering target indicated by the formula (210), i.e. (ZrO₂)ₓ(Cr₂O₃)_{y}(SiO₂)_{100-x-y} (mol %), was very close to both the reduced composition of the sputtering target, and the analyzed composition similarly to the test 1.

Therefore, it is desirable that U, V and T in the formula (2) of the analyzed composition of a dielectric layer satisfy 4 ≤ U ≤ 21 , 11 ≤ V ≤ 30, 2 ≤ T ≤ 12, and 34 ≤ U+V+T ≤ 40 like G, H and L in the formula (20) of the analyzed composition of a sputtering target. However, considering the possibility mentioned in relation to the test 1, U, V and T in above-mentioned formula (2) preferably satisfy 0 < U ≤ 30, 7 < V ≤ 37, 0 < T ≤ 14, and 20 ≤ U+V+T ≤ 60, and more preferably 4 ≤ U ≤ 21 , 11 ≤ V ≤ 30, 2 ≤ T ≤ 12, and 34 ≤ U+V+T ≤ 40.

Generally, it is considered that Zr, Cr and Si detected by the analysis of the dielectric layer exist stably in a dielectric layer in the form of ZrO₂, Cr₂O₃, and SiO₂ respectively. Therefore, by considering the same manner as the test 1, it is considered that a dielectric layer (a Zr-Cr-O-based material layer) formed by a sputtering method using a sputtering target of which nominal composition is indicated by the formula (210), i.e. (ZrO₂)ₓ(Cr₂O₃)_{y}(SiO₂)_{100-x-y} (mol %) is expressed with the formula (21) of (ZrO₂)_{X}(Cr₂O₃)_{Y}(SiO₂)_{100-X-Y} (mol %), and that X and Y are substantially the same as x and y in the formula (210).

According to the result of the tests 1 and 2, the reduced composition obtained from the nominal composition of a sputtering target was very close to an analyzed composition of the sputtering target. Moreover, the reduced composition was close to the analyzed composition of a dielectric layer as long as the Zr-Cr-O-based material layer is formed under the conditions employed by the inventors. Therefore, the reduced composition of a sputtering target (atomic %) can be substantially regarded as the composition (atomic %) of a dielectric layer which is formed by sputtering using the target. Further, as long as the Zr-Cr-O-based material layer is formed under the conditions employed by the inventors, the nominal composition of the sputtering target (mol %) can be substantially regarded as the composition (mol %) of the dielectric layer.

The tests 1 and 2 were conducted as to the Zr-Cr-O-based material layer. It is considered that the same is applicable to a Zr-Cr-Zn-O-based material layer.

Therefore, in the following examples, the composition of a sputtering target is expressed with the nominal composition (mol %). Further, unless otherwise indicated, the composition (mol %) of a Zr-Cr-O-based material layer or a Zr-Cr-Zn-O-based material layer formed by a sputtering method using a sputtering target is regarded as that of the sputtering target. In the following examples, the composition of a sputtering target, a Zr-Cr-O-based material layer and a Zr-Cr-Zn-O-based material layer is indicated only by compound-based composition formula (mol %). However, one skilled in the art will easily convert such composition (mol %) to the elementary composition (atomic %).

### (Example 1)

In Example 1, as a preliminary test leading to this invention, information recording mediums, which each had a constitution similar to the information recording medium 25 described in Embodiment 1 with reference to Figure 1, were produced while varying a material for the first and the second dielectric layers as shown in Table 3. In the mediums, the first dielectric layer and the second dielectric layer were made of a material having the same composition.

Hereafter, the producing method of the information recording medium is explained. In order to make understanding easier, the same reference numbers for the elements of the information recording medium 25 of Figure 1 are used as reference numbers of corresponding elements of that in this Example. (With respect to information recording mediums of the following Examples, please note that the same reference numbers for the elements of the corresponding information recording medium are used similarly to this Example.)

Firstly, a circular polycarbonate substrate having a diameter of 120 mm and a thickness of 0.6 mm was prepared as a substrate 1. A guide groove was previously provided on one side of the circular polycarbonate substrate with a depth of 56 nm and a track pitch (i.e. a distance between centers of a groove surface 23 and a land surface 24 in a plane parallel to the principal surface of the substrate) of 0.615 µm.

On this substrate 1, the first dielectric layer 2 of (ZnS)₈₀(SiO₂)₂₀ (mol %) with a thickness of 150 nm, a recording layer 4 of Ge₂₇Sn₈Sb₁₂Te₅₃ (atomic %) with a thickness of 9 nm, the second dielectric layer 6 of (ZnS)₈₀(SiO₂)₂₀ (mol %) with a thickness of 50 nm, an optical compensation layer 7 of Ge₈₀Cr₂₀ (atomic %) with a thickness of 40 nm, and a reflective layer 8 of Ag-Pd-Cu with a thickness of 80 nm were formed into films in order by a sputtering method as follows.

In a process for forming the first dielectric layer 2, a sputtering target (a diameter of 100 mm and a thickness of 6 mm) which had a composition of (ZnS)₈₀(SiO₂)₂₀ (mol %) was attached to a film-forming device, and then a high frequency sputtering was carried out with a power of 400 W while introducing a mixed gas of Ar gas (97 %) and O₂ gas (3 %). A pressure during the sputtering was set at about 0.13 Pa.

In a process for forming the recording layer 4, a sputtering target (a diameter of 100 mm, a thickness of 6 mm) made of a Ge-Sn-Sb-Te based material resulted by substituting Sn for a part of Ge in a GeTe-Sb₂Te₃ pseudo-binary system composition was attached to the film-forming device, and then a DC (direct current) sputtering was carried out with a power of 100 W while introducing a mixed gas of Ar gas (97 %) and N₂ gas (3 %). A pressure during the sputtering was set at about 0.13 Pa.

A process for forming the second dielectric layer 6 was carried out similarly to the process for forming the first dielectric layer except for its thickness so that the first dielectric layer 2 and the second dielectric layer 6 had the substantially same composition.

In a process for forming the optical compensation layer 7, a sputtering target (a diameter of 100 mm, a thickness of 6 mm) which material had a composition of Ge₈₀Cr₂₀ (atomic %) was attached to the film-forming device, and then a DC sputtering was carried out with a power of 300 W while introducing Ar gas (100 %). The pressure during the sputtering was set at about 0.4 Pa.

In a process for forming the reflective layer 8, a sputtering target (a diameter of 100 mm, a thickness of 6 mm) which material had a composition of Ag-Pd-Cu was attached to the film-forming device and then a DC sputtering was carried out with a power of 200 W while introducing Ar gas (100 %). The pressure during the sputtering was set at about 0.4 Pa.

After the first dielectric layer 2, the recording layer 4, the second dielectric layer 6, the optical compensation layer 7, and the reflective layer 8 were formed into films in order on the substrate 1 as described above to obtain a multilayered structure, an ultraviolet-curing resin was applied on the reflective layer 8. A circular polycarbonate substrate of a diameter of 120 mm and a thickness of 0.6 mm as a dummy substrate 10 was stuck on the applied ultraviolet-curing resin. Then, an ultraviolet ray was applied from the dummy substrate 10 to cure the resin. Thereby, an adhesive layer 9 consisting of the cured resin was formed at a thickness of 30 µm. The dummy substrate 10 was laminated to the multilayered structure with the adhesive layer 9.

In an initialization process following the lamination, the recording layer 4 of the information recording medium 25 was crystallized in the substantially all of an annular area ranging from 22 to 60 mm in a radial direction by using a semiconductor laser with a wavelength of 810 nm. Thereby, the initialization process was finished and the information recording medium 25 of Sample No. 1-1 was produced.

Furthermore, information recording mediums 25 of Sample Nos. 1-2 to 1-16, which each had a constitution similar to the information recording medium 25 of Sample No. 1-1, except that a material for the first dielectric layer 2 and the second dielectric layer 6 was a material shown in Table 3, were produced. These information recording mediums 25 were produced as in the case of the information recording medium 25 of Sample No. 1-1 described above but a process for forming the first dielectric layer and the second dielectric layer was changed.

In order to produce the information recording mediums 25 of Sample Nos. 1-2 to 1-16, sputtering targets (a diameter of 100 mm and a thickness of 6 mm for each) which material had a composition of SiO₂, ZnS, (ZnSe)₈₀(SiO₂)₂₀ (mol %), ZnSe, (ZnO)₈₀(SiO₂)₂₀ (mol %), ZnO, Cr₂O₃, (Cr₂O₃)₅₀(SiO₂)₅₀ (mol %), ZrO₂, ZrSiO₄, (ZrO₂)₈₀(SiO₂)₂₀ (mol %). Ge₉₀Cr₁₀ (atomic %), (Bi₂O₃)₈₀(SiO₂)₂₀ (mol %), TeO₂, or (TeO₂)₈₀(SiO₂)₂₀ (mol %) were respectively used in the processes for forming the first dielectric layer 2 and the second dielectric layer 6.

In addition, a power was adjusted depending on the melting point of a material used as the sputtering target. More specifically, it was set at 1 kW for Sample No. 1-2. For Sample Nos. 1-3 to 1-7, it was set at 400 W like in the case of Sample No. 1-1. It was set at 500 W for Sample Nos. 1-8 to 1-12. It was set at 300 W for Sample No. 1-13. It was set at 200 W for Sample Nos. 1-14 to 1-16. A pressure during the sputtering was set at about 1.33 Pa for Sample No. 1-13, and it was set at about 0.13 Pa for other samples like in the case of Sample No. 1-1. As a gas which was introduced to the film-forming device, a mixed gas of Ar gas (97 %) and O₂ gas (3 %) was used for No. 1-2 and 1-14 to 1-16 like in the case of Sample No. 1-1, and Ar gas (100 %) was used for Sample Nos. 1-3 to 1-12, and a mixed gas of Ar gas (60 %) and N₂ gas (40 %) was used for No. 1-13.

In the case of the information recording medium of Sample No. 1-13, the dielectric layer of Ge-Cr-N was formed in the processes for forming the first and the second dielectric layers by reacting N₂ in the mixed gas with Ge and Cr which were sputtered from the sputtering target. In the case of other samples, the formed dielectric layer was considered to have the substantially same composition as that of the used sputtering target.

For the purpose of comparison, an information recording medium 31 having the structure in the prior art as shown in Figure 10, which has the first interface layer 103 and the second interface layer 105 respectively between the first dielectric layer 102 and the recording layer 4, and between the second dielectric layer 106 and the recording layer 4, was produced. Both of the first interface layer 103 and the second interface layer 105 consist of Ge-Cr-N and were formed at 5 nm in thickness.

The information recording medium 31 having the structure in the prior art was produced under a condition similar to the information recording medium of Sample No. 1-1 except that the first interface layer 103 and the second interface layer 105 were formed. In a process for forming the first interface layer 103, a sputtering target (a diameter of 100 mm, a thickness of 6 mm) which material had a composition of Ge₉₀Cr₁₀ (atomic %) was attached to the film-forming device, and then a high frequency sputtering was carried out with a power of 300 W under a pressure of about 1.33 Pa while introducing a mixed gas of Ar gas (60 %) and N₂ gas (40 %). As a result, the first interface layer 103 of Ge-Cr-N was formed by reacting N₂ in the mixed gas with Ge and Cr which were sputtered from the sputtering target. A process for forming the second interface layer 105 was also conducted under a condition similar to this.

As to the information recording mediums 25 of Sample Nos. 1-1 to 1-16 and the information recording medium 31 of Comparative Sample (prior art) thus obtained, adhesiveness of the dielectric layer and overwrite cyclability of the information recording medium were evaluated. As mentioned below, adhesiveness was evaluated based on the occurrence of delamination. Overwrite cyclability was evaluated based on the number of overwrite cycles. These results are shown in Table 3. Please note that neither the information recording mediums 25 of Sample Nos. 1-1 to 1-16, nor the information recording medium 31 of Comparative Sample were in the scope of this invention.

The evaluation of adhesiveness of the dielectric layer in the case of the information recording medium 25 was based on the delamination under a condition of a high humidity and a high temperature. Specifically, the information recording medium 25 after the initialization process was located for 100 hours in a high humidity/high temperature-tank under a condition of a relative humidity of 80 % at the temperature of 90 °C. Then, the medium 25 was investigated by observation using a light microscope whether the delamination occurred between the recording layer and the adjacent dielectric layer, more specifically, between the recording layer 4 and at least one of the first dielectric layer 2 and the second dielectric layer 6. Of course, adhesiveness was high when no peeling occurred; on the other hand, adhesiveness was low when peeling occurred.

The evaluation of overwrite cyclability of the information recording medium 25 was based on the number of overwrite cycles as an index. The number of overwrite cycles was determined as described below.

In order to record information to the information recording medium 25, an information recording system having a general constitution was used. The system was provided with a spindle motor for rotating the information recording medium 25, an optical head including a semiconductor laser which can emit a laser beam 12, and an objective lens for condensing the laser beam 12 on the recording layer 4 of the information recording medium 25. On evaluating the information recording medium 25, recording which was equivalent to a capacity of 4.7 GB was conducted by using the semiconductor laser with a wavelength of 660 nm and the objective lens with a numerical aperture of 0.6. A linear velocity of rotation of the information recording medium 25 was set at 8.2 m/second. A time interval analyzer was used for a measurement of a jitter in order to obtain an average of jitters as mentioned below.

Firstly, in order to determine a measurement condition for obtaining the number of overwrite cycles, a peak power (Pp) and a bias power (Pb) were determined according to a following procedure. Using the system described above, the information recording medium 25 was irradiated with a laser beam 12 while modulating its power between a peak power (mW) in a high power level and a bias power (mW) in a low power level to record a random signal with a mark length of 0.42 µm (3T) to 1.96 µm (14T) ten times on the same groove surface of the recording layer 4 (by groove recording). Then, a jitter between front ends and a jitter between rear ends were measured. A jitter-average was calculated as the mean values of these jitters. Such jitter-average was measured on each recording condition with the bias power being fixed while the peak power was varied. A power that was 1.3 times as large as a peak power at which the jitter-average for the random signal became 13 % by gradually increasing the peak power was determined as Pp1 temporarily. Next, a jitter-average was measured on each recording condition with the peak power being fixed at Pp1 while the bias power was varied. The mean value of upper and lower bias powers at which the jitter-average for the random signal became 13 % or less was determined as Pb. Then, the jitter-average was measured on each recording condition with the bias power being fixed at Pb while the peak power was varied. A power that was 1.3 times as large as a peak power at which the jitter-average for the random signal became 13 % by gradually increasing the peak power was determined Pp. When the recording was conducted under the condition of thus determined Pp and Pb, 8 to 9 % of the average of the jitters was obtained in the case of, for example, 10 times of overwrite. Considering the upper limit of the laser power of the system, it is desirable to satisfy Pp ≤ 14 mW and Pb ≤ 8 mW.

The number of overwrite cycles used as the index of overwrite cyclability was determined in this Example based on a jitter-average. The information recording medium 25 was irradiated with the laser beam while modulating its power between Pp and Pb thus determined to continuously record a random signal with a mark length of 0.42 µm (3T) to 1.96 µm (14T) in the same groove surface while repeating this predetermined times (by groove recording). After that, jitter-average was measured. The repeating times, i.e. the number of overwrite cycles, was 1, 2, 3, 5, 10, 100, 200, and 500 times, every 1000 times in a range from 1000 to 10000 times, and every 10000 times in a range from 20000 to 100000 times. The limit of overwrite was defined when the jitter-average became 13 %. Overwrite cyclability was evaluated based on the number of overwrite cycles at this limit. Of course, the larger number of overwrite cycles, the higher overwrite cyclability. When an information recording medium is used as an external memory of a computer, the number of overwrite cycles is preferably not less than 100000 times. For the use of an audio-visual recorder, it is preferably not less than 10000 times.

**Table 3**

| Sample No. | Material of First and Second Dielectric Layers (mol %) | Delamination | Number of Overwrite Cycles |
|---|---|---|---|
| 1-1 | (ZnS)₈₀(SiO₂)₂₀ | No | 1000 |
| 1-2 | SiO₂ | Yes | ≥ 100000 |
| 1-3 | ZnS | No | 1000 |
| 1-4 | (ZnSe)₈₀(SiO₂)₂₀ | No | 1000 |
| 1-5 | ZnSe | No | 1000 |
| 1-6 | (ZnO)₈₀(SiO₂)₂₀ | No | 1000 |
| 1-7 | ZnO | No | 1000 |
| 1-8 | Cr₂O₃ | No | 10000 |
| 1-9 | (Cr₂O₃)₅₀(SiO₂)₅₀ | No | 20000 |
| 1-10 | ZrO₂ | Yes | ≥ 100000 |
| 1-11 | ZrSiO₄ | Yes | ≥ 100000 |
| 1-12 | (ZrO₂)₈₀(SiO₂)₂₀ | Yes | ≥ 100000 |
| 1-13 | Ge-Cr-N | No | Not Appreciable* |
| 1-14 | (Bi₂O₃)₈₀(SiO₂)₂₀ | Yes | Not Appreciable* |
| 1-15 | TeO₂ | Yes | Not Appreciable ** |
| 1-16 | (TeO₂)₈₀(SiO₂)₂₀ | Yes | Not Appreciable ** |
| Comparative Sample | (ZnS)₈₀(SiO₂)₂₀ (Prior Art) | No | ≥ 100000 |

| | | | |
|---|---|---|---|
| *Not Writable at Pp ≤ 14 mW | | | |
| **Not Overwritable | | | |

As shown in Table 3, tendency described below can be observed. As to the information recording mediums without delamination (having a high adhesiveness) (that is, Sample Nos. 1-1 and 1-3 to 1-9) among the information recording mediums of Sample Nos. 1-1 to 1-12, the number of overwrite cycles did not reach 100000 times at all. (Overwrite cyclability thereof was low.) As to the information recording mediums with delamination (having a low adhesiveness) (that is, Sample Nos. 1-2 and 1-10 to 1-12) on the other hand, the number of overwrite cycles exceeded 100000 times. (Overwrite cyclability thereof was high.)

Moreover, as to the information recording mediums of Sample Nos. 1-13 and 1-14, a sufficient recorded mark could not be formed when the peak power was not larger than 14 mW. Thus, they showed a low recording sensitivity. As this reason, it was expected that the thermal conductivity of the material for the dielectric layers in these samples was higher than that of other samples.

Moreover, the overwriting could not be made in the information recording mediums of Sample Nos. 1-15 and 1-16. The material for the dielectric layers melted and contaminated in the recording layer during the recording. This was considered because the melting point of the material for the dielectric layers in these samples was lower than that of other materials.

On the other hand, with the information recording medium of Comparative Example in the prior art (which had the interface layers), there was no delamination, and the number of overwrite cycles was not less than 100000 times. That is, both adhesiveness and overwrite cyclability were high.

According to the result of the preliminary tests described above, there was no information recording medium satisfying a high adhesiveness and a high overwrite cyclability at the same time among the information recording mediums of Sample Nos. 1-1 to 1-16 in which oxide, nitride, selenide, sulfide, or a mixture of one of them and SiO₂ was used as the material for the dielectric layers adjacent to the recording layer. However, what was determined in this Example was that the information recording mediums (Sample Nos. 1-10 to 1-12) in which a material containing ZrO₂ was used as the material for the dielectric layers showed an excellent overwrite cyclability, and that the information recording mediums (Sample Nos. 1-1 and 1-3 to 1-9) in which a material containing ZnS, ZnO, ZnSe, or Cr₂O₃ was used as the material for the dielectric layers showed an excellent adhesiveness with the recording layer. Particularly in the case of the information recording medium (Sample No. 1-8) which a material consisting of Cr₂O₃ was used as the material for the dielectric layers, the number of overwrite cycles of 10000 times was obtained with respect to overwrite cyclability. Thus, it was expected that a high adhesiveness and a high overwrite cyclability could be accomplished at the same time by using a mixture of ZrO₂ and Cr₂O₃ as a material for a dielectric layer.

### (Example 2)

In Example 2, for the purpose of accomplishing a high adhesiveness and a high overwrite cyclability at the same time, information recording mediums were produced. In these mediums, a mixture of a material with an excellent adhesiveness and a material with an excellent overwrite cyclability was used as a material for dielectric layers. More specifically, the mixture of two in any combination selected from the oxide, selenide, and sulfide of Example 1 (see Table 4) was used as the material for the dielectric layers. Also in this Example, the information recording medium 25 of which the first dielectric layer and the second dielectric layer were made of a material having the same composition was produced similarly to Example 1 while varying the material for these dielectric layers as shown in Table 4.

The information recording mediums of this Example, similarly to Example 1, each had a constitution which was similar to the information recording medium 25 except that the material for the first and the second dielectric layers was made of the material shown in Table 4. The mediums were produced as in Example 1 except that the processes for forming the first and the second dielectric layers were changed. In order to produce the information recording mediums of Sample Nos. 2-1 to 2-8, in the processes of the first dielectric layer and the second dielectric layer, sputtering targets (a diameter of 100 mm, a thickness of 6 mm) which material had a certain composition shown in Table 4 were respectively used. Additionally, in the processes for forming the first dielectric layer and the second dielectric layer, a power was set at 500 W for Sample Nos. 2-1 and 2-2, and at 400 W for Sample Nos. 2-3 to 2-8. A pressure was set at about 0.13 Pa for all samples. A gas to be introduced to a film-forming device was Ar gas (100 %) for all samples.

The dielectric layers formed into films by the sputtering method were regarded to have the substantially same composition as the used sputtering target for each. Please note that this is applicable to the following Examples unless otherwise indicated.

With respect to the information recording mediums of Sample Nos. 2-1 to 2-8 thus obtained, adhesiveness of the dielectric layers and overwrite cyclability of the information recording medium were evaluated similarly to Example 1. These results are shown in Table 4. Please note that the information recording mediums of Sample Nos. 2-1 and 2-2 were in the scope of this invention among the information recording mediums of Sample Nos. 2-1 to 2-8.

**Table 4**

| Sample No. | Material of First and Second Dielectric Layers (mol %) | Delamination | Number of Overwrite Cycles |
|---|---|---|---|
| 2-1 | (ZrO₂)₈₀(Cr₂O₃)₂₀ | No | ≥ 100000 |
| 2-2 | (ZrO₂)₅₀(Cr₂O₃)₅₀ | No | ≥ 100000 |
| 2-3 | (ZrO₂)₈₀(ZnS)₂₀ | No | 50000 |
| 2-4 | (ZrO₂)₅₀(ZnS)₅₀ | No | 10000 |
| 2-5 | (ZrO₂)₈₀(ZnO)₂₀ | No | 30000 |
| 2-6 | (ZrO₂)₅₀(ZnO)₅₀ | No | 10000 |
| 2-7 | (ZrO₂)₈₀(ZnSe)₂₀ | No | 50000 |
| 2-8 | (ZrO₂)₅₀(ZnSe)₅₀ | No | 10000 |

As shown in Table 4, delamination did not occur in all of the information recording mediums of Sample Nos. 2-1 to 2-8, and therefore adhesiveness was improved. Among these information recording mediums, as to the mediums in which a ZrO₂-Cr₂O₃ based material was used as the material for the dielectric layers (Sample Nos. 2-1 and 2-2), the number of overwrite cycles was large, and overwrite cyclability was very excellent. According to this result, when a layer consisting of a material of mixture of ZrO₂ and Cr₂O₃ (a Zr-Cr-O based material-layer) was used as the dielectric layers adjacent to the recording layer, a high adhesiveness and a high overwrite cyclability were accomplished at the same time in the information recording medium having a constitution which was not provided with a interface layer(s) between the recording layer and the dielectric layer.

In addition, in order to quickly diffuse an amount of heat to the reflective layer from the recording layer in a direction along its thickness, it is preferable that the dielectric layer shows a low thermal conductivity. In Example 2, the information recording mediums (Sample Nos. 2-1 and 2-2) in which a ZrO₂-Cr₂O₃ based material was used as the material for the dielectric layer showed a very excellent overwrite cyclability. When comparing peak powers (Pp) of these information recording mediums, the higher Pp, the larger content ratio of Cr₂O₃ (an oxide basis) since Pp of the information recording medium of Sample No. 2-1 was 13 mW and the information recording medium of Sample No. 2-2 was 13.5 mW. On the other hand, as to the information recording mediums (Sample Nos. 2-3 to 2-8) in which ZrO₂-ZnS, ZrO₂-ZnO and ZrO₂-ZnSe based materials were used as the material for the dielectric layers, though these showed a less overwrite cyclability, these showed a high recording sensitivity since each Pp was within the range of 11 mW to 12 mW. It was expected that the ZrO₂-ZnS, ZrO₂-ZnO and ZrO₂-ZnSe based materials had a lower thermal conductivity than that of the ZrO₂-Cr₂O₃ based material. From this result, a high recording sensitivity in addition to a high adhesiveness and a high overwrite cyclability can be accomplished at the same time by using a mixture ZrO₂-Cr₂O₃ based material and any of ZrO₂-ZnS, ZrO₂-ZnO and ZrO₂-ZnSe based materials as the material for a dielectric layer. Moreover, in order to reduce or restrain a crystal growth of ZnS and ZnSe which are highly crystalline, mixing of these material with SiO₂ of amorphous was also examined.

### (Example 3)

In Example 3, for the purpose of realizing an information recording medium having a high recording sensitivity, information recording mediums were produced. In these mediums, a material of a ZrO₂-Cr₂O₃ based material mixed with any of ZrO₂-ZnS, ZrO₂-ZnO and ZrO₂-ZnSe based materials was used as a material for dielectric layers, or a material further mixed with amorphous SiO₂ in order to reduce or restrain a crystal growth of ZnS and ZnSe being high crystalline was used as a material for dielectric layers. Also in this Example, the information recording medium 25 of which the first dielectric layer and the second dielectric layer were made of a material having the same composition was produced similarly to Example 1 while varying the material for these dielectric layers as shown in Table 5.

The information recording mediums of this Example, similarly to Example 2, each had a constitution which was similar to the information recording medium 25 of Example 1 except that the material for the first and the second dielectric layers was made of the material shown in Table 5. The mediums were produced as in Example 2 except that processes for forming the first and the second dielectric layers were changed. In order to produce the information recording mediums of Sample Nos. 3-1 to 3-9, in the processes of the first dielectric layer and the second dielectric layer, sputtering targets (a diameter of 100 mm, a thickness of 6 mm) which material had a certain composition shown in Table 5 were respectively used. Additionally, in the processes for forming the first dielectric layer and the second dielectric layer, a power was set at 500 W for Sample Nos. 3-1, 3-2 and 3-6, and at 400 W for Sample Nos. 3-3 to 3-5 and 3-7 to 3-9. A pressure was set at about 0.13 Pa for all samples. A gas to be introduced to a film-forming device was Ar gas (100 %) for all samples.

With respect to the information recording mediums of Sample Nos. 3-1 to 3-9 thus obtained, adhesiveness of the dielectric layers and overwrite cyclability of the information recording medium were evaluated similarly to Example 1. These results are shown in Table 5 together with a peak power (Pp) obtained on evaluating overwrite cyclability. In the purpose of comparison, the result as to the information recording medium 31 in the prior art of Figure 10 which was produced in Example 1 is also shown in Table 5. (This result is also shown in Table 6 to 10 relating to the following Examples.) Please note that all of the information recording mediums of Sample Nos. 3-1 to 3-9 were in the scope of this invention.

**Table 5**

| Sample No. | Material of First and Second Dielectric Layers (mol %) | Delamination | Number of Overwrite Cycles | Peak Power Pp (mW) |
|---|---|---|---|---|
| 3-1 | (ZrO₂)₇₀(Cr₂O₃)₃₀ | No | ≥ 100000 | 13.2 |
| 3-2 | (ZrO₂)₄₀(Cr₂O₃)₃₀(SiO₂)₃₀ | No | ≥ 100000 | 12.5 |
| 3-3 | (ZrO₂)₄₀(Cr₂O₃)₂₀(ZnS)₁₀(SiO₂)₃₀ | No | ≥ 100000 | 11.5 |
| 3-4 | (ZrO₂)₄₀(Cr₂O₃)₂₀(ZnSe)₁₀(SiO₂)₃₀ | No | ≥ 100000 | 11.8 |
| 3-5 | (ZrO₂)₄₀(Cr₂O₃)₂₀(ZnO)₁₀(SiO₂)₃₀ | No | ≥ 100000 | 12.2 |
| 3-6 | (ZrSiO₄)₅₄(Cr₂O₃)₄₆ | No | ≥ 100000 | 12.0 |
| 3-7 | (ZrSiO₄)₅₄(Cr₂O₃)₃₁(ZnS)₁₅ | No | ≥ 100000 | 11.0 |
| 3-8 | (ZrSiO₄)₅₄(Cr₂O₃)₃₁(ZnSe)₁₅ | No | ≥ 100000 | 11.2 |
| 3-9 | (ZrSiO₄)₅₄(Cr₂O₃)₃₁(ZnO)₁₅ | No | ≥ 100000 | 11.7 |
| Comparative Sample | (ZnS)₈₀(SiO₂)₂₀ (Prior Art) | No | ≥ 100000 | 11.0 |

As shown in Table 5, delamination did not occur and the number of overwrite cycles was not less than 100000 times in the information recording mediums of Sample Nos. 3-1 and 3-2. As to the information recording medium of Sample No. 3-1 in which a ZrO₂-Cr₂O₃ based material was used as the material for the dielectric layers, Pp was 13.2 mW. On the other hand, as to the information recording medium of Sample No. 3-2 in which a mixture of a ZrO₂-Cr₂O₃ based material and SiO₂ was used as the material for the dielectric layers, Pp was able to be lowered to 12.5 mW. As to the information recording mediums of Sample Nos. 3-3 to 3-5 in which a material resulted by substituting ZnS, ZnSe, or ZnO for a 10 mol % portion of Cr₂O₃ contained in the material for the dielectric layers of Sample No. 3-2 was used as the material for the dielectric layers, Pp was able to further lowered. Pp was as low as 11.5 mW in the information recording medium of Sample No. 3-3.

Moreover in the information recording mediums of Sample Nos. 3-6 to 3-9, a material for the dielectric layer was a ZrSiO₄ based material which contains ZrO₂ and SiO₂ at a substantially equal ratio. The composition of the material for the dielectric layers was expressed on the basis of an oxide by a unit of mol %. For example, (ZrO₂)₃₅(Cr₂O₃)₃₀(SiO₂)₃₅ (mol %) corresponds to (ZrSiO₄)₃₅(Cr₂O₃)₃₀ (molar ratio) and reduced into (ZrSiO₄)₅₄(Cr₂O₃)₄₆ (mol %) (a material for the dielectric layers of Sample No. 3-6) with a percentage expression. Also in these information recording mediums of Sample No. 3-6 to 3-9, Pp was as low as 11-12 mW. Especially in the information recording medium of Sample No. 3-7 in which a material resulted by substituting ZnS for a part of Cr₂O₃ was used as the material for the dielectric layers, adhesiveness (delamination), overwrite cyclability (the number of overwrite cycles), and Pp was substantially equal to those of the information recording medium 31 in the prior art of Comparative Sample. In the information recording mediums of Sample Nos. 3-1 to 3-9 produced in this Example, measured Rc values were in the range of 15 % to 17 %, and measured Ra values were not larger than 2 % (at an unrelieved flat surface thereof).

As described above, when the layer consisting of the ZrO₂-Cr₂O₃ based material or the ZrO₂-Cr₂O₃-SiO₂ based material (a Zr-Cr-O based material-layer) or the layer consisting of the material of ZrO₂-Cr₂O₃-SiO₂ mixed with ZnS, ZnSe, or ZnO (a Zr-Cr-Zn-O based material-layer) was used as dielectric layers adjacent to the recording layer, the performance of the information recording medium 25 of Figure 1 which did not contain the first and second interface layers (and therefore had a less number of layers in its constitution) was in a substantially equal level of the information recording medium 31 in the prior art of Figure 10 which contained with the first and the second interface layers.

Please note that the materials for the first and the second dielectric layers had the same composition in this Example. However, the first and the second dielectric layers can be a layer having a different composition from each other which are selected from the Zr-Cr-O based material and the Zr-Cr-Zn-O based material. Also in such a case, an acceptable performance of a medium as high as this Example was obtained.

### (Example 4)

In Example 4, for the purpose of studying a composition range of a ZrO₂-Cr₂O₃ based material which was suitable for a dielectric layer, information recording mediums were produced while varying the content ratios (mol %) of ZrO₂ and Cr₂O₃ in a material for the second dielectric layer as shown in Table 6. The information recording mediums of this Example each had a constitution similar to the information recording medium 27 described in Embodiment 3 with reference to Figure 3. In the mediums, the first dielectric layer and the second dielectric layer were made of materials having a different composition from each other, and the first interface layer was contained between the first dielectric layer and a recording layer.

The information recording medium 27 of this Example was produced as follows. Firstly, a substrate 1 as that in Example 1 was prepared. On this substrate 1, the first dielectric layer 102 of (ZnS)₈₀(SiO₂)₂₀ (mol %) with a thickness of 150 nm, the first interface layer 103 of Ge-Cr-N with a thickness of 5 nm, the recording layer 4 of Ge₂₇Sn₈Sb₁₂Te₅₃ (atomic %) with a thickness of 9 nm, and the second dielectric layer 6 of ZrO₂ with a thickness of 50 nm, an optical compensation layer 7 of Ge₈₀Cr₂₀ (atomic %) with a thickness of 40 nm, a reflective layer 8 of Ag-Pd-Cu with a thickness of 80 nm were formed into films in order by a sputtering method. Each material for the first dielectric layer 102 and the first interface layer 103 was substantially the same as that in the information recording medium 31 described above while referring to Figure 10.

The information recording medium 27 of this Example was produced as in the case of the information recording medium of Sample No. 1-1 of Example 1 except that a process for forming the first interface layer 103 was added between the process for forming the first dielectric layer 102 and the process for forming the recording layer 4, and that the process for forming the second dielectric layer 6 was changed. The process for forming the first interface layer 103 was conducted similarly to the process for forming the first interface layer in the production method of the information recording medium 31 in the prior art of Comparative Sample described in Example 1. The process for forming the second dielectric layer 6 was conducted as follows. In order to produce the information recording mediums of Sample Nos. 4-1 to 4-11, sputtering targets (a diameter of 100 mm, a thickness of 6 mm) which material had a certain composition shown in Table 6 were respectively used. For all samples, a gas to be introduced to a film-forming device was Ar gas (100%), a power was at 500 W, and a pressure was at about 0.13 Pa. Please note that the process for forming the first dielectric layer 102 was similar to the process for forming the first dielectric layer 2 in the production method of the information recording medium 25 of Sample No. 1-1 described in Example 1, and also similar to the process for forming the first dielectric layer 2 in the production method of the information recording medium 31 in the prior art.

With respect to the information recording mediums 27 of Sample Nos. 4-1 to 4-11 thus obtained, adhesiveness of the dielectric layer and overwrite cyclability of the information recording medium were evaluated similarly to Example 1. However, in this Example, the evaluation of adhesiveness was conducted by investigating whether delamination occurred between the recording layer 4 and the second dielectric layer 6 adjacent to it. These results are shown in Table 6 together with a peak power (Pp) obtained on evaluating overwrite cyclability. Please note that the information recording mediums of Sample Nos. 4-3 to 4-9 were in the scope of this invention among the information recording mediums of Sample Nos. 4-1 to 4-11.

**Table 6**

| Sample No. | Material of Second Dielectric Layer (ZrO₂)_{M}(Cr₂O₃)_{100-M} (mol %) | Delamination | Number of Overwrite Cycles | Peak Power Pp(mW) |
|---|---|---|---|---|
| 4-1 | ZrO₂ | Yes | ≥ 100000 | 11.5 |
| 4-2 | (ZrO₂)₉₀(Cr₂O₃)₁₀ | Yes | ≥ 100000 | 11.9 |
| 4-3 | (ZrO₂)₈₀(Cr₂O₃)₂₀ | No | ≥ 100000 | 12.2 |
| 4-4 | (ZrO₂)₇₀(Cr₂O₃)₃₀ | No | ≥ 100000 | 12.5 |
| 4-5 | (ZrO₂)₆₀(Cr₂O₃)₄₀ | No | ≥ 100000 | 12.8 |
| 4-6 | (ZrO₂)₅₀(Cr₂O₃)₅₀ | No | ≥ 100000 | 13.1 |
| 4-7 | (ZrO₂)₄₀(Cr₂O₃)₆₀ | No | ≥ 100000 | 13.4 |
| 4-8 | (ZrO₂)₃₀(Cr₂O₃)₇₀ | No | ≥ 100000 | 13.7 |
| 4-9 | (ZrO₂)₂₀(Cr₂O₃)₈₀ | No | ≥ 100000 | 14.0 |
| 4-10 | (ZrO₂)₁₀(Cr₂O₃)₉₀ | No | 70000 | 14.4 |
| 4-11 | Cr₂O₃ | No | 20000 | 15.0 |
| Comparative Sample | (ZnS)₈₀(SiO₂)₂₀(Prior Art) | No | ≥ 100000 | 11.0 |

As shown in Table 6, delamination did not occur in the information recording mediums of Sample Nos. 4-3 to 4-11 in which a material for the second dielectric layer contained ZrO₂ at a ratio of 80 mol % or less. Further, in the information recording mediums of Sample Nos. 4-1 to 4-9 in which a material for the second dielectric layer contained ZrO₂ at a ratio of 20 mol % or more, the number of overwrite cycles of 100000 times or more was obtained, and Pp ≤ 14.0 mW. Therefore, a low peak power, in addition to a high adhesiveness and a high overwrite cyclability, was obtained for the information recording mediums of Sample Nos. 4-3 to 4-9. From the result of this Example, it was confirmed that a ZrO₂-Cr₂O₃ based material being in a composition range which contains ZrO₂ at a ratio of 20-80 mol % was preferable as the material for the dielectric layer.

### (Example 5)

In Example 5, for the purpose of studying a composition range of a ZrO₂-Cr₂O₃-SiO₂ based material which was suitable for a dielectric layer, information recording mediums were produced while varying the content ratios of (mol %) of ZrO₂, Cr₂O₃, and SiO₂ in a material for the second dielectric layer as shown in Table 7. The information recording mediums of this Example each had a constitution similar to the information recording medium of Example 4. The mediums were produced as in Example 4 except that in order to produce the information recording mediums of Sample Nos. 5-1 to 5-12, sputtering targets of which material had a certain composition shown in Table 7 were respectively used. Concerning the result of Example 4, the content ratio of SiO₂ was changed in a range so that the content ratio of ZrO₂ was not less than 20 mol % and the content ratio of Cr₂O₃ was not less that 20 mol %.

With respect to the information recording mediums of Sample Nos. 5-1 to 5-12 thus obtained, adhesiveness of the dielectric layers and overwrite cyclability of the information recording medium were evaluated similarly to Example 4. These results are shown in Table 7 together with a peak power (Pp) obtained on evaluating overwrite cyclability. Please note that the information recording mediums of Sample Nos. 5-1 to 5-4 and 5-7 to 5-12 were in the scope of this invention among the information recording mediums of Sample Nos. 5-1 to 5-12.

**Table 7**

| Sample No. | Material of Second Dielectric Layer (ZrO₂)_{X}(Cr₂O₃)_{Y}(SiO₂)_{100-X-Y} (mol %) | Delamination | Number of Overwrite Cycles | Peak Power Pp (mW) |
|---|---|---|---|---|
| 5-1 | (ZrO₂)₇₀(Cr₂O₃)₂₀(SiO₂)₁₀ | No | ≥ 100000 | 12.3 |
| 5-2 | (ZrO₂)₆₀(Cr₂O₃)₂₀(SiO₂)₂₀ | No | ≥ 100000 | 12.2 |
| 5-3 | (ZrO₂)₅₀(Cr₂O₃)₂₀(SiO₂)₃₀ | No | ≥ 100000 | 12.1 |
| 5-4 | (ZrO₂)₄₀(Cr₂O₃)₂₀(SiO₂)₄₀ | No | ≥ 100000 | 12.0 |
| 5-5 | (ZrO₂)₃₀(Cr₂O₃)₂₀(SiO₂)₅₀ | Yes | ≥ 100000 | 11.9 |
| 5-6 | (ZrO₂)₂₀(Cr₂O₃)₂₀(SiO₂)₆₀ | Yes | ≥ 100000 | 11.8 |
| 5-7 | (ZrO₂)₅₀(Cr₂O₃)₄₀(SiO₂)₁₀ | No | ≥ 100000 | 12.9 |
| 5-8 | (ZrO₂)₄₀(Cr₂O₃)₄₀(SiO₂)₂₀ | No | ≥ 100000 | 12.8 |
| 5-9 | (ZrO₂)₃₀(Cr₂O₃)₄₀(SiO₂)₃₀ | No | ≥ 100000 | 12.7 |
| 5-10 | (ZrO₂)₂₀(Cr₂O₃)₄₀(SiO₂)₄₀ | No | ≥ 100000 | 12.6 |
| 5-11 | (ZrO₂)₃₀(Cr₂O₃)₆₀(SiO₂)₁₀ | No | ≥ 100000 | 13.5 |
| 5-12 | (ZrO₂)₂₀(Cr₂O₃)₆₀(SiO₂)₂₀ | No | ≥ 100000 | 13.4 |
| Comparalive Sample | (ZnS)₈₀(SiO₂)₂₀ (Prior Art) | No | ≥ 100000 | 11.0 |

As shown to Table 7, delamination did not occur in the information recording mediums of Sample Nos. 5-1 to 5-4 and 5-7 to 5-12 in which a material for the second dielectric layer contained SiO₂ at a ratio of 10 mol % to 40 mol %, and a low peak power together with a high adhesiveness and a high overwrite cyclability was obtained for these samples. From the result of this Example, it was confirmed that a ZrO₂-Cr₂O₃-SiO₂ based material being in a composition range which contains ZrO₂ at a ratio of 20 to 70 mol %, Cr₂O₃ at a ratio of 20 to 60 mol %, SiO₂ at a ratio of 10 to 40 mol % was preferable as the material for the dielectric layer.

### (Example 6)

In Example 6, for the purpose of studying a composition range of a ZrSiO₄-Cr₂O₃ based material containing ZrO₂ and SiO₂ at a substantially equal ratio which was suitable for a dielectric layer, information recording mediums were produced while varying the content ratios (mol %) of ZrSiO₄ and Cr₂O₃ in a material for the second dielectric layer as shown in Table 8. The information recording mediums of this Example, similarly to Example 5, each had a constitution similar to the information recording medium of Example 4. The description of the production method of them is omitted in the specification since it was substantially the same as in the case of Example 5. The content ratio of Cr₂O₃ was changed in a range so that the content ratios of ZrO₂ and SiO₂ were not less than 20 mol % and not larger than 50 mol % (in other words, the content ratio of ZrSiO₄ was not less than 25 mol % and not larger than 100 mol %).

With reference to Table 8, the information recording mediums of Sample Nos. 5-4, 5-9 and 5-12 were corresponded to the information recording mediums in Example 5 described above. As to the materials for the second dielectric layer of the information recording mediums of Sample Nos. 5-4, 5-9 and 5-12 in Table 7, (ZrO₂)₄₀(Cr₂O₃)₂₀(SiO₂)₄₀ (mol %) is reduced (or converted) into (ZrSiO₄)₆₇(Cr₂O₃)₃₃ (mol %); (ZrO₂)₃₀(Cr₂O₃)₄₀(SiO₂)₃₀ (mol %) is reduced into (ZrSiO₄)₄₃(Cr₂O₃)₅₇ (mol %); (ZrO₂)₂₀(Cr₂O₃)₆₀(SiO₂)₂₀ (mol %) is reduced into (ZrSiO₄)₂₅(Cr₂O₃)₇₅ (mol %).

With respect to the information recording mediums of Sample Nos. 5-4, 5-9, 5-12 and 6-1 to 6-4 thus obtained, adhesiveness of the dielectric layers and overwrite cyclability of the information recording medium were evaluated similarly to Example 4. These results are shown in Table 8 with a peak power (Pp) obtained on evaluating overwrite cyclability. Please note that the information recording mediums of Sample Nos. 5-4, 5-9, 5-12 and 6-1 to 6-4 were in the scope of this invention among the information recording mediums of Sample Nos. 5-4, 5-9, 5-12, 6-3, and 6-4.

**Table 8**

| Sample No. | Material of Second Dielectric Layer (ZrSiO₄)_{Z}(Cr₂O₃)_{100-Z} (mol %) | Delamination | Number of Overwrite Cycles | Peak Power Pp (mW) |
|---|---|---|---|---|
| 6-1 | ZrSiO₄ | Yes | ≥ 100000 | 11.4 |
| 6-2 | (ZrSiO₄)₈₂(Cr₂O₃)₁₈ | Yes | ≥ 100000 | 11.7 |
| 5-4 | (ZrSiO₄)₆₇(Cr₂O₃)₃₃ | No | ≥ 100000 | 12.0 |
| 6-3 | (ZrSiO₄)₅₄(Cr₂O₃)₄₆ | No | ≥ 100000 | 12.3 |
| 5-9 | (ZrSiO₄)₄₃(Cr₂O₃)₅₇ | No | ≥ 100000 | 12.7 |
| 6-4 | (ZrSiO₄)₃₃(Cr₂O₃)₆₇ | No | ≥ 100000 | 13.0 |
| 5-12 | (ZrSiO₄)₂₅(Cr₂O₃)₇₅ | No | ≥ 100000 | 13.4 |
| Comparative Sample | (ZnS)₈₀(SiO₂)₂₀ (Prior Art) | No | ≥ 100000 | 11.0 |

As shown in Table 8, delamination did not occur in the information recording mediums except for Sample Nos. 6-1 and 6-2, and a low peak power together with a high adhesiveness and a high overwrite cyclability was obtained for these samples. From the result of this Example, it was confirmed that a ZrSiO₄-Cr₂O₃ based material being in a composition range which contains ZrSiO₄ at a ratio of 25 to 67 mol % was preferable as the material for the dielectric layer.

### (Example 7)

In Example 7, for the purpose of studying a composition range of a ZrO₂-Cr₂O₃-ZnS-SiO₂ based material which was suitable for a dielectric layer, information recording mediums were produced while varying the content ratios (mol %) of ZrO₂, Cr₂O₃, ZnS, and SiO₂ in a material for the second dielectric layer as shown in Table 9. The information recording mediums of this Example, similarly to Example 5, each had a constitution similar to the information recording medium of Example 4. The production method of them is omitted in the specification since it was substantially the same as in the case of Example 5 except that a power was set at 400 W in the process for forming the second dielectric layer. Concerning the result of Example 4, the content ratios of ZnS and SiO₂ were changed in a range so that the content ratio of ZrO₂ was not less than 20 mol % and the content ratio of Cr₂O₃ was not less that 20 mol %.

With respect to the information recording mediums of Sample Nos. 7-1 to 7-16 thus obtained, adhesiveness of the dielectric layers and overwrite cyclability of the information recording medium were evaluated similarly to Example 4. These results are shown in Table 9 together with a peak power (Pp) obtained on evaluating overwrite cyclability. Please note that the information recording mediums of Sample Nos. 7-2 to 7-4 and 7-6 to 7-16 were in the scope of this invention among the information recording mediums of Sample Nos. 7-1 to 7-16.

**Table 9**

| Sample No. | Material of Second Dielectric Layer (ZrO₂)_{C}(Cr₂O₃)_{E}(ZnS)_{F}(SiO₂)_{100-C-E-F} (mol %) | Delamination lamination | Number of Overwrite Cycles | Peak Power Pp (mW) |
|---|---|---|---|---|
| 7-1 | (ZrO₂)₂₀(Cr₂O₃)₂₀(ZnS)₅₀(SiO₂)₁₀ | No | 1000 | 10.2 |
| 7-2 | (ZrO₂)₂₀(Cr₂O₃)₂₀(ZnS)₄₀(SiO₂)₂₀ | No | ≥ 100000 | 10.4 |
| 7-3 | (ZrO₂)₂₀(Cr₂O₃)₂₀(ZnS)₃₀(SiO₂)₃₀ | No | ≥ 100000 | 10.6 |
| 7-4 | (ZrO₂)₂₀(Cr₂O₃)₂₀(ZnS)₂₀(SiO₂)₄₀ | No | ≥ 100000 | 10.8 |
| 7-5 | (ZrO₂)₂₀(Cr₂O₃)₂₀(ZnS)₁₀(SiO₂)₅₀ | Yes | ≥ 100000 | 11.0 |
| 7-6 | (ZrO₂)₂₀(Cr₂O₃)₃₀(ZnS)₄₀(SiO₂)₁₀ | No | ≥ 100000 | 10.7 |
| 7-7 | (ZrO₂)₂₀(Cr₂O₃)₃₀(ZnS)₁₀(SiO₂)₄₀ | No | ≥ 100000 | 11.3 |
| 7-8 | (ZrO₂)₂₀(Cr₂O₃)₄₀(ZnS)₃₀(SiO₂)₁₀ | No | ≥ 100000 | 11.2 |
| 7-9 | (ZrO₂)₂₀(Cr₂O₃)₄₀(ZnS)₁₀(SiO₂)₃₀ | No | ≥ 100000 | 11.6 |
| 7-10 | (ZrO₂)₂₀(Cr₂O₃)₅₀(ZnS)₂₀(SiO₂)₁₀ | No | ≥ 100000 | 11.5 |
| 7-11 | (ZrO₂)₂₀(Cr₂O₃)₅₀(ZnS)₁₀(SiO₂)₂₀ | No | ≥ 100000 | 11.7 |
| 7-12 | (ZrO₂)₂₀(Cr₂O₃)₆₀(ZnS)₁₀(SiO₂)₁₀ | No | ≥ 100000 | 11.9 |
| 7-13 | (ZrO₂)₄₀(Cr₂O₃)₂₀(ZnS)₃₀(SiO₂)₁₀ | No | ≥ 100000 | 10.7 |
| 7-14 | (ZrO₂)₄₀(Cr₂O₃)₂₀(ZnS)₁₀(SiO₂)₃₀ | No | ≥ 100000 | 11.1 |
| 7-15 | (ZrO₂)₄₀(Cr₂O₃)₄₀(ZnS)₁₀(SiO₂)₁₀ | No | ≥ 100000 | 12.0 |
| 7-16 | (ZrO₂)₆₀(Cr₂O₃)₂₀(ZnS)₁₀(SiO₂)₁₀ | No | ≥ 100000 | 11.3 |
| Comparative Sample | (ZnS)₈₀(SiO₂)₂₀(Prior Art) | No | ≥ 100000 | 11.0 |

As shown in Table 9, the number of overwrite cycles was 1000 times as to the information recording mediums of Sample Nos. 7-1 in which a material for the second dielectric layer contained ZnS at a ratio of 50 mol %. Further, delamination occurred in the information recording medium of Sample No. 7-5 in which a material for the second dielectric layer contained SiO₂ at a ratio of 50 mol %. Delamination did not occur in the information recording mediums of other samples, and a low peak power together with a high adhesiveness and a high overwrite cyclability was obtained for these samples. From the result of this Example, it was confirmed that a ZrO₂-Cr₂O₃-ZnS-SiO₂ based material being in a composition range which contains ZrO₂ at a ratio of 20 to 60 mol %, Cr₂O₃ at a ratio of 20 to 60 mol %, ZnS at a ratio of 10 to 40 mol %, and SiO₂ at a ratio of 10 to 40 mol % was preferable as the material for the dielectric layer.

### (Example 8)

In Example 8, for the purpose of studying a composition range of a ZrO₂-Cr₂O₃-ZnSe-SiO₂ based material which was suitable for a dielectric layer, information recording mediums were produced while varying the content ratios (mol %) of ZrO₂, Cr₂O₃, ZnSe, and SiO₂ in a material for the second dielectric layer. This material contained ZnSe in place of ZnS in the material studied in Example 7. As a result of evaluation as to the information recording mediums similarly to Example 7, it was confirmed that a ZrO₂-Cr₂O₃-ZnSe-SiO₂ based material being in a composition range which contains ZrO₂ at a ratio of 20 to 60 mol %, Cr₂O₃ at a ratio of 20 to 60 mol %, ZnSe at a ratio of 10 to 40 mol %, and SiO₂ at a ratio of 10 to 40 mol % was preferable as the material for the dielectric layer.

### (Example 9)

In Example 9, for the purpose of studying a composition range of a ZrO₂-Cr₂O₃-ZnO-SiO₂ based material which was suitable for a dielectric layer, information recording mediums were produced while varying the content ratios (mol %) of ZrO₂, Cr₂O₃, ZnO, and SiO₂ in a material for the second dielectric layer. This material contained ZnO in place of ZnS in the material studied in Example 7. As a result of evaluation as to the information recording mediums similarly to Example 7, it was confirmed that a ZrO₂-Cr₂O₃-ZnO-SiO₂ based material being in a composition range which contains ZrO₂ at a ratio of 20 to 60 mol %, Cr₂O₃ at a ratio of 20 to 60 mol %, ZnO at a ratio of 10 to 40 mol %, and SiO₂ at a ratio of 10 to 40 mol % was preferable as the material for the dielectric layer.

### (Example 10)

In Example 10, for the purpose of studying a composition range of a ZrSiO₄-Cr₂O₃-ZnS based material which was suitable for a dielectric layer, information recording mediums were produced while varying the content ratios (mol %) of ZrSiO₄, Cr₂O₃, and ZnS in a material for the second dielectric layer as shown in Table 10. The information recording mediums of this Example, similarly to Example 5, each had a constitution similar to the information recording medium of Example 4. The production method of them is omitted in the specification since it was substantially the same as in the case of Example 5 except that a power was set at 400 W in the process for forming the second dielectric layer. The content ratio of ZnS was changed in a range so that the content ratio of ZrSiO₄ was not less than 25 mol % and the content ratio of Cr₂O₃ was not less that 25 mol %.

With respect to the information recording mediums of Sample Nos. 8-1 to 8-10 thus obtained, adhesiveness of the dielectric layers and overwrite cyclability of the information recording medium were evaluated similarly to Example 4. These results are shown in Table 10 together with a peak power (Pp) obtained on evaluating overwrite cyclability. Please note that all of the information recording mediums of Sample Nos. 8-1 to 8-10 were in the scope of this invention.

**Table 10**

| Sample No. | Material of Second Dielectric Layer (ZrSiO₄)_{A}(Cr₂O₃)_{B}(ZnS)_{100-A-B} (mol %) | Delamination lamination | Number of Overwrite Cycles | Peak Power Pp (mW) |
|---|---|---|---|---|
| 8-1 | (ZrSiO₄)₂₅(Cr₂O₃)₂₅(ZnS)₅₀ | No | ≥ 100000 | 10.0 |
| 8-2 | (ZrSiO₄)₂₅(Cr₂O₃)_{37.5}(ZnS)_{37.5} | No | ≥ 100000 | 10.2 |
| 8-3 | (ZrSiO₄)₂₅(Cr₂O₃)₅₀(ZnS)₂₅ | No | ≥ 100000 | 10.4 |
| 8-4 | (ZrSiO₄)₂₅(Cr₂O₃)_{62.5}(ZnS)_{12.5} | No | ≥ 100000 | 10.6 |
| 8-5 | (ZrSiO₄)₃₃(Cr₂O₃)₂₇(ZnS)₄₀ | No | ≥ 100000 | 10.1 |
| 8-6 | (ZrSiO₄)₃₃(Cr₂O₃)₄₀(ZnS)₂₇ | No | ≥ 100000 | 10.3 |
| 8-7 | (ZrSiO₄)_{33.5}(Cr₂O₃)_{53.5}(ZnS)₁₃ | No | ≥ 100000 | 10.5 |
| 8-8 | (ZrSiO₄)₄₃(Cr₂O₃)_{28.5}(ZnS)_{28.5} | No | ≥ 100000 | 10.2 |
| 8-9 | (ZrSiO₄)₄₃(Cr₂O₃)₄₃(ZnS)₁₄ | No | ≥ 100000 | 10.4 |
| 8-10 | (ZrSiO₄)₅₄(Cr₂O₃)₃₁(ZnS)₁₅ | No | ≥ 100000 | 10.6 |
| Comparative Sample | (ZnS)₈₀(SiO₂)₂₀ (Prior Art) | No | ≥ 100000 | 11.0 |

As shown in Table 10, delamination did not occur in all of the information recording mediums of Sample Nos. 8-1 to 8-10, and a low peak power together with a high adhesiveness and a high overwrite cyclability was obtained for these samples. From the result of this Example, it was confirmed that a ZrSiO₄-Cr₂O₃-ZnS based material being in a composition range which contains ZrSiO₄ at a ratio of 25 to 54 mol %, Cr₂O₃ at a ratio of 25 to 63 mol %, ZnS at a ratio of 12 to 50 mol % was preferable as the material for the dielectric layer.

### (Example 11)

In Example 11, for the purpose of studying a composition range of a ZrSiO₄-Cr₂O₃-ZnSe based material which was suitable for a dielectric layer, information recording mediums were produced while varying the content ratios (mol %) of ZrSiO₄, Cr₂O₃, and ZnSe in a material for the second dielectric layer. This material contained ZnSe in place of ZnS in the material studied in Example 10. As a result of evaluation as to the information recording mediums similarly to Example 10, it was confirmed that a ZrSiO₄-Cr₂O₃-ZnSe based material being in a composition range which contains ZrSiO₄ at a ratio of 25 to 54 mol %, Cr₂O₃ at a ratio of 25 to 63 mol %, ZnSe at a ratio of 12 to 50 mol % was preferable as the material for the dielectric layer.

### (Example 12)

In Example 12, for the purpose of studying a composition range of a ZrSiO₄-Cr₂O₃-ZnO based material which was suitable for a dielectric layer, information recording mediums were produced while varying the content ratios (mol %) of ZrSiO₄, Cr₂O₃, and ZnO in a material for the second dielectric layer. This material contained ZnO in place of ZnS in the material studied in Example 10. As a result of evaluation as to the information recording mediums similarly to Example 10, it was confirmed that a ZrSiO₄-Cr₂O₃-ZnO based material being in a composition range which contains ZrSiO₄ at a ratio of 25 to 54 mol %, Cr₂O₃ at a ratio of 25 to 63 mol %, ZnO at a ratio of 12 to 50 mol % was preferable as the material for the dielectric layer.

### (Example 13)

In Example 13, an information recording medium which had a constitution similar to the information recording medium 26 described in Embodiment 2 with reference to Figure 2 was produced. In the medium, the first dielectric layer and the second dielectric layer were made of materials having a different composition from each other.

The information recording medium 26 of this Example was produced as follows. Firstly, a circular polycarbonate substrate having a diameter of 120 mm and a thickness of 0.6 mm was prepared as a substrate 1. A guide groove was previously provided on one side of the circular polycarbonate substrate with a depth of 56 nm and a track pitch (i.e. a distance between centers of a groove surface 23 and a land surface 24 in a plane parallel to the principal surface of the substrate) of 0.615 µm.

On this substrate 1, the first dielectric layer 2 of (ZrSiO₄)₃₃(Cr₂O₃)₄₀(ZnS)₂₇ (mol %) with a thickness of 150 nm, a recording layer 4 of Ge₂₇Sn₈Sb₁₂Te₅₃ (atomic %) with a thickness of 9 nm, the second interface layer 105 of Ge-Cr-N with a thickness of 3 nm, the second dielectric layer 106 of (ZnS)₈₀(SiO₂)₂₀ (mol %) with a thickness of 50 nm, an optical compensation layer 7 of Ge₈₀Cr₂₀ (atomic %) with a thickness of 40 nm, and a reflective layer 8 of Ag-Pd-Cu with a thickness of 80 nm were formed into films in order by a sputtering method. Each material for the second interface layer 105 and the second dielectric layer 106 was substantially the same as that in the information recording medium 31 described above while referring to Figure 10.

The information recording medium 26 of this Example was produced as in the case of the information recording medium of Sample No. 1-1 of Example 1 except that a process for forming the first dielectric layer 2 was changed, and that a process for forming the second interface layer 105 was added between a process for forming the recording layer 4 and a process for forming the second dielectric layer 106. In the process for forming the first dielectric layer 2, a sputtering target (a diameter of 100 mm, a thickness of 6 mm) which had a composition of (ZrSiO₄)₃₃(Cr₂O₃)₄₀(ZnS)₂₇ (mol %) was attached to a film-forming device, and then a high frequency sputtering was carried out with a power of 400 W under a pressure of about 0.13 Pa while introducing Ar gas (100 %). The process for forming the second interface layer 105 was conducted similarly to the process for forming the second interface layer 105 in the production method of the information recording medium 31 in the prior art of Comparative Sample described in Example 1. Please note that the process for forming the second dielectric layer 106 was similar to the process for forming the second dielectric layer 6 in the production method of the information recording medium 25 of Sample No. 1-1 described in Example 1, and also similar to the process for forming the second dielectric layer 106 in the production method of the information recording medium 31 in the prior art.

With respect to the information recording medium 26 of Sample No. 9-1 thus obtained, adhesiveness of the dielectric layer and overwrite cyclability of the information recording medium were evaluated similarly to Example 1. However, such evaluations in this Example were different from Example 1 in the following points. The evaluation of adhesiveness was conducted by investigating whether delamination occurred between the recording layer 4 and the first dielectric layer 2 adjacent to it. The evaluation of overwrite cyclability was conducted not only by groove recording but also by land recording (i.e. by land-groove recording) and measuring numbers of overwrite as to each of the groove recording and the land recording. These results are shown in Table 11 together with a peak power (Pp) and a bias power (Pb) obtained on evaluating overwrite cyclability. In the purpose of comparison, the result as to the information recording medium in the prior art shown in Figure 10 which was produced in Example 1 is also shown in Table 11.

**Table 11**

| | | Groove Recording | | | Land Recording | | |
|---|---|---|---|---|---|---|---|
| Sample No. | Delamination | Number of Overwrite Cycles | Power (mW) | | Number of Overwrite Cycles | Power (mW) | |
| | | | Pp | Pb | | Pp | Pb |
| 9-1 | No | ≥ 100000 | 10.8 | 4.9 | ≥ 100000 | 11.1 | 5.0 |
| Comparative Sample | No | ≥ 100000 | 11.0 | 5.0 | ≥ 100000 | 11.3 | 5.2 |

As shown in Table 11, adhesiveness, the number of overwrite cycles, a peak power and a bias power of the information recording medium 26 of Sample No. 9-1 of this Example in which (ZrSiO₄)₃₃(Cr₂O₃)₄₀(ZnS)₂₇ (mol %) was used only as a material for the first dielectric layer 2 and of which total number of layers was 6 were in a substantially equal level of the information recording medium 31 in the prior art of which total number of layers was 7. The total number of layers is referred to as the number of layers formed on the substrate by a sputtering method (that is, up to the reflective layer 8). Though a layer consisting of material which had a composition of (ZrSiO₄)₃₃(Cr₂O₃)₄₀(ZnS)₂₇ (mol %) (a Zr-Cr-Zn-O based material-layer) was used as the first dielectric layer 2 in this Example, such composition is an exemplary one. With respect to a ZrSiO₄-Cr₂O₃-ZnS based material, acceptable results were obtained as in this Example over the whole composition range as shown in Example 10. Furthermore, a Zr-Cr-Zn-O based material-layer other than this or a Zr-Cr-O based material-layer may be used as the first dielectric layer 2.

### (Example 14)

In Example 14, an information recording medium which had a constitution similar to the information recording medium 28 described in Embodiment 4 with reference to Figure 4 was produced.

The information recording medium 28 of this Example was produced as follows. Firstly, a circular polycarbonate substrate having the diameter of 120 mm and the thickness of 1.1 mm was prepared as a substrate 101. A guide groove was previously provided on one side of the circular polycarbonate substrate with a depth of 21 nm and a track pitch (i.e. a distance between centers of adjacent groove surfaces 23 in a plane parallel to the principal surface of the substrate) of 0.32 µm.

On this substrate 101, a reflective layer 8 of Ag-Pd-Cu with a thickness of 80 nm, the second dielectric layer 6 of (ZrSiO₄)₅₄(Cr₂O₃)₄₆ (mol %) with a thickness of 16 nm, a recording layer 4 of Ge_{37.5}Sb₁₁Te_{51.5} (atomic %) with a thickness of 11 nm, and the first dielectric layer 2 of (ZrSiO₄)₅₄(Cr₂O₃)₄₆ (mol %) with a thickness of 68 nm were formed into films in order by a sputtering method.

A process for forming the reflective layer 8 was conducted under a condition similar to that in the production method of the information recording medium of Sample No. 1-1 of Example 1.

In a process for forming the second dielectric layer 6, a sputtering target (a diameter of 100 mm, a thickness of 6 mm) which material had a composition of (ZrSiO₄)₅₄(Cr₂O₃)₄₆ (mol %) was attached to a film-forming device, and then a high frequency sputtering was carried out with a power of 500 W under a pressure of about 0.13 Pa while introducing Ar gas (100 %).

In a process for forming the recording layer 4, a sputtering target (a diameter of 100 mm, a thickness of 6 mm) made of a Ge-Sb-Te based material was attached to a film-forming device, and then a DC sputtering was carried out with a power of 100 W under a pressure of about 0.13 Pa while introducing a mixed gas of Ar gas (97 %) and N₂ gas (3 %).

A process for forming the first dielectric layer 2 was conducted similarly to the process for forming the second interface layer 6 described above except for the thickness of the layer so that the first dielectric layer 2 and the second dielectric layer 6 had the substantially same composition.

After the reflective layer 8, the second dielectric layer 6, the recording layer 4, and the first dielectric layer 2 were formed into films in order on the substrate 101 as described above to obtain a multilayered structure, an ultraviolet-curing resin was applied on the first dielectric layer 2. A circular polycarbonate substrate of a diameter of 120 mm and a thickness of 90 µm as a dummy substrate 110 was stuck on the applied ultraviolet-curing resin. Then, an ultraviolet ray was applied from the dummy substrate 110 to cure the resin. Thereby, an adhesive layer 9 consisting of the cured resin was formed at a thickness of 10 µm. The dummy substrate 110 was laminated to the multilayered structure with the adhesive layer 9.

In an initialization process following the lamination, the recording layer 4 of the information recording medium 28 was crystallized in the substantially all of an annular area ranging from 22 to 60 mm in a radial direction by using a semiconductor laser with a wavelength of 670 nm. Thereby, the initialization process was finished and the information recording medium 28 of Sample No. 10-1 was produced.

For the purpose of comparison, an information recording medium of Comparative Example was produced (not shown). This medium had a constitution similar to the information recording medium of this Example described above except that the first interface layer 103 and the second interface layer 105 of Ge-Cr-N were each provided between the first dielectric layer 2 and the recording layer 4 and between the second dielectric layer 6 and the recording layer 4, and that it contained the first dielectric layer 102 and the second dielectric layer 106 of (ZnS)₈₀(SiO₂)₂₀ (mol %) in place of the first dielectric layer 2 and the second dielectric layer 6. The first interface layer 103 and the second interface layer 105 were each formed at a thickness of 5 mm.

The information recording medium of this Comparative Example was produced as in the production method of the information recording medium of this Example except that the processes forming the first interface layer 103 and the second interface layer 105 as well as the first dielectric layer 102 and the second dielectric layer 106 were conducted similarly to in the production method of the information recording medium 31 in the prior art as another Comparative Example which was produced in Example 1.

As to the information recording medium 28 of Sample No. 10-1 and the information recording medium of Comparative Sample thus obtained, adhesiveness of the dielectric layer and overwrite cyclability of the information recording medium were evaluated. These results are shown in Table 12 together with a peak power (Pp) obtained on evaluating overwrite cyclability.

In this Example, adhesiveness of the dielectric layer in the information recording medium 28 was evaluated based on the occurrence of delamination in a similar manner in Example 1. On the other hand, overwrite cyclability was evaluated based on a different condition from in the case of Example 1, though it overlapped in the point of using the number of overwrite cycles as an index similarly to Example 1.

On evaluating overwrite cyclability of the information recording medium 28, recording which was equivalent to a capacity of 23 GB was conducted by using a semiconductor laser with a wavelength of 405 nm and an objective lens with numerical aperture of 0.85 in a system as that used in Example 1. A linear velocity of rotation of the information recording medium 28 was set at 5 m/second. A spectrum analyzer was used for measurements of CNR (Carrier-to-Noise Ratio, i.e. a ratio of an amplitude of a signal to a noise) and an erase ratio.

In order to determine a measurement condition for obtaining the number of overwrite cycles, a peak power (Pp) and a bias power (Pb) were determined according to the following procedure. The information recording medium 28 was irradiated with a laser beam 12 while modulating its power between a peak power (mW) in a high power level and a bias power (mW) in a low power level to record a 2T signal with a mark length of 0.16 µm ten times on the same groove surface of the recording layer 4. CNR was measured after the 2T signal was recorded ten times. This CNR was measured on each condition with the bias power being fixed at a certain value while the peak power was varied during ten times-recording of the 2T signal. A power that was 1.2 times as large as a minimum peak power at which the amplitude of the signal was saturated was determined as Pp1. After the 2T signal was recorded ten times as described above, the recorded signal was reproduced and the amplitude of the 2T signal was measured. Further, a 9T signal was recorded one time on the same groove surface to overwrite it. Then, the recorded signal was reproduced and the amplitude of the 2T signal was measured, and the erase ratio was obtained as a decrement of the 2T signal on the basis of the amplitude measured after ten times-recording. This erase ratio defined as above was obtained on each condition with the peak power being fixed at Pp determined above while the bias power was varied during ten times-recording of the 2T signal and one time-recording of the 9T signal. The center value of the range of the bias power at which the erase ratio was not less than 25 dB was determined as Pb. Considering the upper limit of the laser power of the system, it is desirable to satisfy Pp ≤ 7 mW and Pb ≤ 3.5 mW.

The number of overwrite cycles used as the index of overwrite cyclability was determined in this Example based on CNR and the erase ratio. The information recording medium 28 was irradiated with the laser beam while modulating its power between Pp and Pb thus determined to continuously record a 2T signal in the same groove surface while repeating this to overwrite predetermined times. After that, CNR was measured and an erase ratio was obtained. The erase ratio was obtained as a decrement of a 2T signal as described above. More specifically, the 2T signal was measured after recording the 2T signal predetermined times and after overwriting the 9T signal on it, the erase ratio was obtained as a decrement of the measured amplitude of the 2T signal after recording of the predetermined times on the basis of the measured amplitude of the 2T signal after overwriting of the 9T signal. The repeating times, i.e. the number of overwrite cycles, was 1, 2, 3, 5, 10, 100, 200, 500, 1000, 2000, 3000, 5000, 7000, and 10000 times. The limit of overwriting was defined when CNR dropped by 2 dB or when the erase ratio dropped by 5 dB, on the basis of CNR and the erase ratio in the case of the number of overwrite cycles of 10. Overwrite cyclability was evaluated based on the number of overwrite cycles at this limit. Of course, the larger number of overwrite cycles, the higher overwrite cyclability. The number of overwrite cycles of the information recording medium 28 is preferably not less than 10000 times.

**Table 12**

| Sample No. | Delamination | Groove Recording | | |
|---|---|---|---|---|
| | | Number of Overwrite Cycles | Power (mW) | |
| | | | Pp | Pb |
| 10-1 | No | ≥ 10000 | 5.0 | 2.3 |
| Comparative Sample | No | ≥ 10000 | 5.0 | 2.4 |

According to the information recording medium 28 of Sample No. 10-1 of this Example, an acceptable performance was obtained without providing an interface layer(s) by using layers of which material had a composition of (ZrSiO₄)₅₄(Cr₂O₃)₄₆ (mol %) (a Zr-Cr-O based material-layer) as the first dielectric layer 2 and the second dielectric layer 6, irrespective of reversing the order for forming the layers on the substrate, using a different condition for recording (such as the wavelength of the laser and the numerical aperture of the lens), and increasing the recording capacity to about 5 times when compared with the information recording medium 25 as shown in Figure 1. In the information recording medium 28 of Sample No. 10-1 produced in this Example, a measured Rc value was 20 %, and a measured Ra value was 3 % (at an unrelieved flat surface thereof). From Table 12, it was confirmed that the performance of the information recording medium 28 of Sample No. 10-1 was in a substantially equal level of the information recording medium of Comparative Sample which contained the first and the second interface layers.

In the information recording medium 28 of Sample No. 10-1 of this Example, the layer consisting of the ZrSiO₄-Cr₂O₃ based material was used for both of the first and the second dielectric layers. However, a Zr-Cr-O based material-layer other than this or a Zr-Cr-Zn-O based material-layer may be used.

Furthermore, in the information recording medium 28 of this Example, a Zr-Cr-O based material-layer (or Zr-Cr-Zn-O based material-layer) was used as both of the first and the second dielectric layers. However, this invention is not limited to this. As an example, a Zr-Cr-O based material-layer (or a Zr-Cr-Zn-O based material-layer) can be used as one of the first and the second dielectric layers, and a material having the composition of, for example, (ZnS)₈₀(SiO₂)₂₀ (mol %) as described in the prior art can be used for the other dielectric layer, and an interface layer can be provided between the other dielectric layer and the recording layer. Also in such case, the similar result as in this Example was obtained. Therefore, by using a Zr-Cr-O based material-layer or a Zr-Cr-Zn-O based material-layer as a dielectric layer, at least one of, and preferably both of the two interface layers provided between the first and the second dielectric layer and the recording layer in the prior art can be omitted, and a performance equivalent to the information recording medium of Comparative Example can be ensured.

### (Example 15)

In Example 15, an information recording medium which had a constitution similar to the information recording medium 29 described in Embodiment 5 with reference to Figure 5 was produced.

The information recording medium 29 of this Example was produced as follows. Firstly, a substrate 101 as that in Example 14 was prepared. On this substrate 101, the second reflective layer 20 of Ag-Pd-Cu with a thickness of 80 nm, the fifth dielectric layer 19 of (ZrSiO₄)₅₄(Cr₂O₃)₄₆ (mol %) with a thickness of 16 nm, the second recording layer 18 of Ge₄₅Sb₄Te₅₁ (atomic %) with a thickness of 11 nm, and the fourth dielectric layer 17 of (ZrSiO₄)₅₄(Cr₂O₃)₄₆ (mol %) with a thickness of 68 nm were formed into films in order by a sputtering method. Thereby, the second information layer 22 was formed on the substrate 101.

Processes for forming the second reflective layer 20, the fifth dielectric layer 19, and the fourth dielectric layer 17 were conducted under conditions similar to the process for forming the reflective layer 8, the second dielectric layer 6, and the first dielectric layer 2 in the production method of the information recording medium 28 of Example 14, respectively. A process for forming the second recording layer 18 was conducted under a condition similar to the process for forming the recording layer 4 in the production method of the information recording medium 28 of Example 14 except that a sputtering target (a diameter of 100 mm, a thickness of 6 mm) which material had a different composition was used.

Next, an ultraviolet-curing resin was applied on the second information layer 22 by, for example, a spin coat. A polycarbonate substrate on which surface a guide groove was provided was located on the applied ultraviolet-curing resin so that the guide groove stuck on it. Then, an ultraviolet ray was applied from the polycarbonate substrate to cure the resin. The polycarbonate substrate was removed from an intermediate layer 16. Thereby, the intermediate layer 16 consisted of the cured resin to which the groove was transferred was formed at a thickness of 30 µm.

In the first initialization process following this, the second recording layer 18 of the second information layer 22 was crystallized in the substantially all of an annular area ranging from 22 to 60 mm in a radial direction by using a semiconductor laser with a wavelength of 670 nm.

Next, on the intermediate layer 16 of a multilayered structure thus obtained, the third dielectric layer 15 of TiO₂ with a thickness of 15 nm, the first reflective layer 14 of Ag-Pd-Cu with a thickness of 10 nm, the second dielectric layer 6 of (ZrSiO₄)₄₃(Cr₂O₃)₅₇ (mol %) with a thickness of 12 nm, the first recording layer 13 of Ge₄₀Sn₅Sb₄Te₅₁ (atomic %) with a thickness of 6 nm, and the first dielectric layer 2 of (ZrSiO₄)₄₃(Cr₂O₃)₅₇ (mol %) with a thickness of 45 nm were formed into films in order by a sputtering method. Thereby, the first information layer 21 was formed.

In a process for forming the third dielectric layer 15, a sputtering target (a diameter of 100 mm and a thickness of 6 mm) which had a composition of TiO₂ was attached to a film-forming device, and then a high frequency sputtering was carried out with a power of 400 W under a pressure of about 0.13 Pa while introducing a mixed gas of Ar gas (97 %) and O₂ gas (3 %).

A process for forming the first reflective layer 14 was conducted similarly to the process for forming the second reflective layer 20 described above except for the thickness of the layer.

In a process for forming the second dielectric layer 6, a sputtering target (a diameter of 100 mm and a thickness of 6 mm) which had a composition of (ZrSiO₄)₄₃(Cr₂O₃)₅₇ was attached to the film-forming device, and then a high frequency sputtering was carried out with a power of 500 W under a pressure of about 0.13 Pa while introducing Ar gas (100 %).

In a process for forming the first recording layer 13, a sputtering target (a diameter of 100 mm and a thickness of 6 mm) made of a Ge-Sn-Sb-Te based material was attached to the film-forming device, and then a DC sputtering was carried out with a power of 50 W while introducing Ar gas (100 %). A pressure during the sputtering was set at about 0.13 Pa.

A process for forming the first dielectric layer 2 was conducted similarly to the process for forming the second interface layer 6 described above except for the thickness of the layer so that the first dielectric layer 2 and the second dielectric layer 6 had the substantially same composition.

After the layers up to the first dielectric layer 2 were formed into films on the substrate 101 as described above to obtain a multilayered structure, an ultraviolet-curing resin was applied on the first dielectric layer 2. A circular polycarbonate substrate of a diameter of 120 mm and a thickness of 65 µm as a dummy substrate 110 was stuck on the applied ultraviolet-curing resin. Then, an ultraviolet ray was applied from the dummy substrate 110 to cure the resin. Thereby, an adhesive layer 9 consisting of the cured resin was formed at a thickness of 10 µm. The dummy substrate 110 was laminated to the multilayered structure with the adhesive layer 9.

In the second initialization process following the lamination, the first recording layer 13 of the first information layer 21 was crystallized in the substantially all of an annular area ranging from 22 to 60 mm in a radial direction by using a semiconductor laser with a wavelength of 670 nm. Thereby, the information recording medium 29 of Sample No. 11-1 was produced.

With respect to the information recording medium 29 of Sample No. 11-1 thus obtained, adhesiveness of the dielectric layers and overwrite cyclability of the information recording medium were evaluated for each of the first information layer 21 and the second information layer 22. These results are shown in Table 13 together with a peak power (Pp) and a bias power (Pb) obtained on evaluating overwrite cyclability.

In this Example, the evaluation of adhesiveness for the information recording medium 29 was conducted under a condition similarly to Example 1. However, it was different from Example 1 in that the investigation of delamination was carried out with respect to both of the first information layer 21 and the second information layer 22. Moreover, the evaluation of overwrite cyclability of the information recording medium 29 was conducted under a condition similarly to Example 14. However, it was different from Example 14 in that recording which was equivalent to a capacity of 23 GB was conducted on each of the first information layer 21 and the second information layer 22, and that the number of overwrite cycles was obtained with respect to both of the first information layer 21 and the second information layer 22. A laser beam 12 was focused on the first recording layer 13 when recording on the first information layer 21, and on the second recording layer 18 when recording on the second information layer 22. Considering the upper limit of the laser power of the system, it is desirable to satisfy Pp ≤ 14 mW and Pb ≤ 8 mW as to the first information layer 21 (the value of about half of these Pp and Pb as to the second information layer 22 since the laser beam 12 which has passed through the first information layer 21 is to be used for the recording).

**Table 13**

| Sample No. | First Information Layer | | | Second Information Layer | | |
|---|---|---|---|---|---|---|
| | Delamination | Number of Overwrite Cycles | Peak Power Pp(mW) | Delamination | Number of Overwrite Cycles | Peak Power Pp(mW) |
| 11-1 | No | ≥ 10000 | 11 | No | ≥ 10000 | 5.5 |

As shown in Table 13, according to the information recording medium 29 of Sample No. 11-1 of this Example, an acceptable performance was obtained by using layers consisting of a ZrSiO₄-Cr₂O₃ based material as the first dielectric layer 2, the second dielectric layer 6, the fourth dielectric layer 17, and the fifth dielectric layer 19, irrespective of reversing the order for forming the layers on the substrate, using a different condition for recording, and increasing the recording capacity to about 10 times when compared with the information recording medium 25 as shown in Figure 1. In the information recording medium 29 of Sample No. 11-1 produced in this Example, a designed Rc value was 6 %, and a designed Ra value was 0.7 % for the first information layer 21 (at an unrelieved flat surface thereof). Further, a designed Rc value was 25 %, and a designed Ra value was 3 % for the second information layer 22.

In the information recording medium 29 of Sample No. 11-1 of this Example, the layer consisting of the ZrSiO₄-Cr₂O₃ based material was used for all of the first dielectric layer 2, the second dielectric layer 6, the fourth dielectric layer 17, and the fifth dielectric layer 19. However, a Zr-Cr-O based material-layer other than this (e.g. a layer consisting of a ZrO₂-Cr₂O₃-SiO₂ or ZrO₂-Cr₂O₃ based material) or a Zr-Cr-Zn-O based material-layer (e.g. a layer consisting of a material resulted by mixing ZnS, ZnSe or ZnO with a ZrO₂-Cr₂O₃-SiO₂ material) may be used as a dielectric layer(s). Also in such case, an acceptable performance was obtained.

Furthermore, in the information recording medium 29 of this Example, a Zr-Cr-O based material-layer (or Zr-Cr-Zn-O based material-layer) was used as all of the first dielectric layer 2, the second dielectric layer 6, the fourth dielectric layer 17, and the fifth dielectric layer 19. However, this invention is not limited to this. As an example, a Zr-Cr-O based material-layer (or a Zr-Cr-Zn-O based material-layer) can be used as one of the first and the second dielectric layers, and a material having the composition of, for example, (ZnS)₈₀(SiO₂)₂₀ (mol %) as in the prior art can be used for the remaining dielectric layers, and an interface layer can be provided between the other dielectric layer and the recording layer. Also in such case, the similar result as in this Example was obtained.

Moreover, in the information recording medium 29 of this Example, the layer consisting of TiO₂ was used as the third dielectric layer 15. However, a layer consisting of (ZrO₂)₃₀(Cr₂O₃)₇₀ can be used in place of it. Also in such case, the similar performance as in this Example was obtained with respect to the first information layer 21.

Furthermore, in the information recording medium 29 of this Example, materials used for the first dielectric layer 2 and the second dielectric layer 6 had the same composition, and materials used for the fourth dielectric layer 17 and the fifth dielectric layer 19 had the same composition. However, materials having a different composition can also be used for at least two of these dielectric layers. Also in such case, an acceptable performance as high as this Example was obtained.

### (Example 16)

In Example 16, an information recording medium which bad a constitution similar to the information recording medium 30 described in Embodiment 6 with reference to Figure 6 was produced. A Zr-Cr-O based material-layer was used for the first interface layer 3 and the second interface layer 5 in the information recording medium 30 of this Example, unlikely the dielectric layer in the information recording medium of Examples 1-15 described above.

The information recording medium 30 of this Example was produced as follows. Firstly, a substrate 1 as that in Example 1 was prepared. On this substrate 1, the first dielectric layer 102 of (ZnS)₈₀(SiO₂)₂₀ (mol %) with a thickness of 150 nm, the first interface layer 3 of (ZrSiO₄)₄₃(Cr₂O₃)₅₇ (mol %) with a thickness of 5 nm, a recording layer 4 of Ge₂₇Sn₈Sb₁₂Te₅₃ (atomic %) with a thickness of 9 nm, the second interface layer 5 of (ZrSiO₄)₄₃(Cr₂O₃)₅₇ (mol %) with a thickness of 5 nm, the second dielectric layer 106 of (ZnS)₈₀(SiO₂)₂₀ (mol %) with a thickness of 50 nm, an optical compensation layer 7 of Ge₈₀Cr₂₀ (atomic %) with a thickness of 40 nm, and the reflective layer 8 of Ag-Pd-Cu with a thickness of 80 nm were formed into films in order by a sputtering method. Each material for the first dielectric layer 102 and the second dielectric layer 106 was substantially the same as that in the information recording medium 31 described above while referring to Figure 10.

This information recording medium 30 had the constitution as in the case of the information recording medium 31 in the prior art which was produced in Example 1 (see Figure 10), and was produced similarly to this except for processes for forming the first interface layer 3 and the second interface layer 5. In the processes for forming the first interface layer 3 and the second interface layer 5, a sputtering target (a diameter of 100 mm, a thickness of 6 mm) which material had a composition of (ZrSiO₄)₄₃(Cr₂O₃)₅₇ (mol %) was attached to a film-forming device, and then a high frequency sputtering was carried out with a power of 500 W under a pressure of about 0.13 Pa while introducing Ar gas (100 %).

With respect to the information recording medium 30 of Sample No. 12-1 thus obtained, adhesiveness of the dielectric layer and overwrite cyclability of the information recording medium were evaluated similarly to Example 1. However, in this Example, the evaluation of adhesiveness was conducted by investigating whether delamination occurred between the recording layer 4 and the adjacent interface layer, more specifically, between the recording layer 4 and at least one of the first interface layer 3 and the second interface layer 5. The evaluation of overwrite cyclability was conducted not only by groove recording but also by land recording (i.e. by land-groove recording) and measuring numbers of overwrite as to each of the groove recording and the land recording. These results are shown in Table 14. In the purpose of comparison, the result as to the information recording medium in the prior art shown in Figure 10 which was produced in Example 1 is also shown in Table 14.

**Table 14**

| Sample No. | Delamination | Groove Recording | | | Land Recording | | |
|---|---|---|---|---|---|---|---|
| | | Number of Overwrite Cycles | Power (mW) | | Number of Overwrite Cycles | Power (mW) | |
| | | | Pp | Pb | | Pp | Pb |
| 12-1 | No | ≥ 100000 | 10.5 | 4.7 | ≥ 100000 | 11.0 | 4.9 |
| Comparative Sample | No | ≥ 100000 | 11.0 | 5.0 | ≥ 100000 | 11.3 | 5.2 |

As shown in Table 14, in the information recording medium 30 of Sample No. 12-1 of this Example in which a material of (ZrSiO₄)₄₃(Cr₂O₃)₅₇ (mol %) was used for the interface layers, the performance thereof was in a substantially equal level of the information recording medium 31 in the prior art of Comparative Sample.

In this Example, a Zr-Cr-O based material-layer was used as the interface layer. The number of layers of the information recording medium was the same as that in the prior art and was not reduced. However, such interface layer consisting of a Zr-Cr-O based material can be formed by a sputtering in the atmosphere of Ar gas, without the need of a reactive sputtering which was required for forming an interface layer of, for example, Ge-Cr-N in the prior art. According to this Example, therefore, the variations in composition and in thickness of the interface layer become smaller than of the interface layer of Ge-Cr-N in the prior art. Thus, the readiness and the stability of production can be improved.

In the information recording medium 30 of Sample No. 12-1 of this Example, the layer of which material had the composition of (ZrSiO₄)₄₃(Cr₂O₃)₅₇ (mol %) (a Zr-Cr-O based material-layer) was used for both of the first interface layer 3 and the second interface layer 5. However, such composition is an example. A Zr-Cr-O based material-layer other than this or a Zr-Cr-Zn-O based material-layer can be used. Additionally, the first interface layer 3 and the second interface layer 5 can be layers having a different composition from each other which are selected from the Zr-Cr-O based material and the Zr-Cr-Zn-O based material.

### (Example 17)

Though the information recording mediums for recording an information by optical means were produced in above Examples 1-16, an information recording medium 207 for recording an information by electric means shown in Figure 8 was produced in Example 17. The information recording medium 207 of this Example was a so-called memory.

The information recording medium 207 of this Example was produced as follows. Firstly, a Si substrate 201 having a length of 5 mm, a width of 5 mm, and a thickness of 1 mm of which surface was subjected to a nitriding treatment was prepared. On this substrate 201, a lower electrode 202 of Au in an area of 1.0 mm x 1.0 mm with a thickness of 0.1 µm, a phase-change part 205 of Ge₃₈Sb₁₀Te₅₂ (which is expressed as Ge₈Sb₂Te₁₁ as a compound) in a circular area of a diameter of 0.2 mm with a thickness of 0.1 µm, a thermal insulating part 206 of (ZrO₂)₅₆(Cr₂O₃)₃₀(SiO₂)₁₄ in a area of 0.6 mm x 0.6 mm (excluding the phase-change part 205) with the same thickness as the phase-change part 205, and an upper electrode 204 of Au in an area of 0.6 mm x 0.6 mm with a thickness of 0.1 µm were formed into films in order by a sputtering method.

In a process for forming the phase-change part 205, a sputtering target (a diameter of 100 mm, a thickness of 6 mm) made of a Ge-Sb-Te based material was attached to a film-forming device, and then a DC sputtering was carried out with a power of 100 W while introducing Ar gas (100 %). A pressure during the sputtering was set at about 0.13 Pa. In a process for forming the thermal insulating part 206, a sputtering target (a diameter of 100 mm, a thickness of 6 mm) which material had a composition of (ZrO₂)₅₆(Cr₂O₃)₃₀(SiO₂)₁₄ was attached to the film-forming device, and then a high frequency sputtering was carried out with a power of 500 W under a pressure of about 0.13 Pa while introducing Ar gas (100 %). Each sputtering in these processes was conducted while covering an area excluding the surface to be sputtered with a mask so that these layers did not overlap. Please note that the order for carrying out the processes for forming the phase-change part 205 and the thermal insulating part 206 is not specified, and each of these processes could be conducted as described above.

The phase-change part 205 and the thermal insulating part 206 constituted a recording part 203. The phase-change part 205 corresponded to a recording layer according to this invention. The thermal insulating part 206 corresponded to a Zr-Cr-O based material-layer according to this invention.

Please note that the detailed description of processes for forming the lower electrode 202 and the upper electrode 204 is omitted since these processes could be conducted by a general method in the technical field of formation of an electrode with a sputtering method.

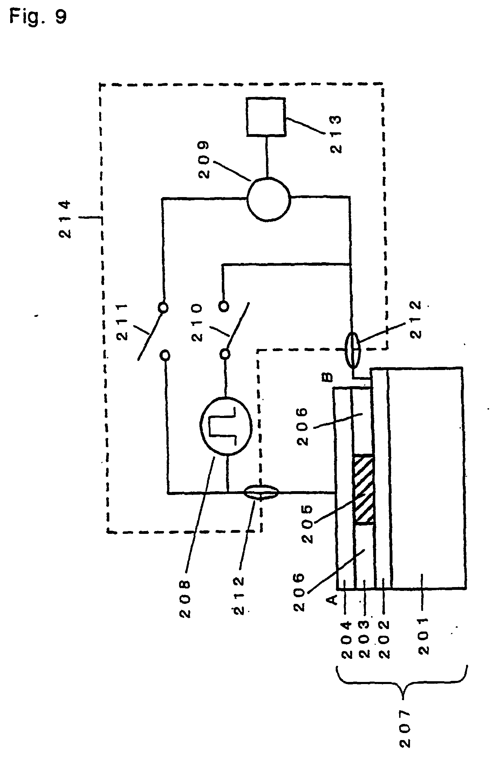

Phase change occurred in the phase-change part 205 by applying an electric energy to the information recording medium 207 of this Example thus produced. This was confirmed by means of a system shown in Figure 9. The cross sectional view of the information recording medium 207 shown in Figure 9 is the cross section of the information recording medium 207 taken along a line A-B in a direction of its thickness shown in Figure 8.

As shown in Figure 9, more specifically, two parts 212 for application were bonded to the lower electrode 202 and the upper electrode 204 respectively with a lead wire of Au. Thus, an electrically recording/reproducing device 214 was connected to the information recording medium (memory) 207 through this application parts 212. Between the application parts 212 which were respectively connected to the lower electrode 202 and the upper electrode 204 in the electrically recording/reproducing device 214, a pulse producing part 208 was connected to the application parts 212 through a switch 210, and a resistance measuring device 209 was also connected to the application parts 212 through a switch 211. The resistance measuring device 209 was connected to a judgment part 213 which judges whether a resistance value measured by the resistance measuring device 209 was high or low. A current pulse was flowed between the upper electrode 204 and the lower electrode 202 by means of the pulse producing part 208 through the application parts 212. A resistance value between the lower electrode 202 and the upper electrode 204 was measured by the resistance measuring device 209. Thus measured resistance value was judged by the judgment part 213 whether it was high or low. Such resistance value generally changes by the phase change of the phase-change part 205. Therefore, the state of a phase of the phase-change part 205 could be told based on the result of this judgment.

In the case of this Example, the melting point of the phase-change part 205 was 630 °C, the crystallization temperature thereof was 170 °C, and the crystallization time thereof was 130 ns. The resistance value between the lower electrode 202 and the upper electrode 204 was 1000 Ω when the phase-change part 205 was in the state of amorphous phase, and was 20 Ω when it was in the state of crystalline phase. A current pulse of 20 mA and 150 ns was applied between the upper electrodes 204 and the lower electrode 202 when the phase-change part 205 was in the state of amorphous phase (i.e. in the level of high resistance), so that the resistance value between the lower electrode 202 and the upper electrode 204 dropped and the phase-change part 205 changed into the state of crystalline phase from the state of amorphous phase. Further, a current pulse of 200 mA and 100 ns was applied between the upper electrodes 204 and the lower electrode 202 when the phase-change part 205 was in the state of crystalline phase (i.e. in the level of low resistance), so that the resistance value between the lower electrode 202 and the upper electrode 204 rose and the phase-change part 205 changed into the state of amorphous phase from the state of crystalline phase.

From the result described above, it was confirmed that a phase change occurred in the phase-change part (a recording layer) by using the layer made of a material having a composition of (ZrO₂)₅₆(Cr₂O₃)₃₀(SiO₂)₁₄ as the thermal insulating part 206 around the phase-change part 205 and by applying an electric energy to it. Therefore, it was also confirmed that the information recording medium 207 had a function of recording an information.

In the case where the thermal insulating part 206 of (ZrO₂)₅₆(Cr₂O₃)₃₀(SiO₂)₁₄ which is a dielectric is provided for the periphery of the phase-change part 205 in a cylindrical shape as in this Example, it effectively prevents a current, which flows into the phase-change part 205 by applying a voltage between the upper electrode 204 and the lower electrode 202, from escaping to the periphery of the phase-change part 205. Therefore, a temperature of the phase-change part 205 can be efficiently raised by the Joule heat generated by the current. Particularly, a process of melting the phase-change part 205 of Ge₃₈Sb₁₀Te₅₂ followed by quenching it is required to change the phase-change part 205 into the state of amorphous phase. By providing the thermal insulating part 206 for the periphery of the phase-change part 205, a temperature of the phase-change part 205 can be raised not less than the melting point thereof with a smaller current.

A material of (ZrO₂)₅₆(Cr₂O₃)₃₀(SiO₂)₁₄ for the thermal insulating part 206 has a high melting point. Moreover, an atomic diffusion by heat hardly takes place in this material. Thus, the material is applicable to an electric memory such as the information recording medium 207. Additionally, in the case where the thermal insulating part 206 is located in the periphery of the phase-change part 205, the thermal insulating part 206 serves to substantially isolate the phase-change part 205 electrically and thermally in the plane of the recording part 203. Therefore, by providing the plural number of phase-change parts 205 for the information recording medium 207 while the phase-change parts 205 are isolated from each other by the thermal insulating part 206, the memory capacity of the information recording medium 207 can be made higher and functions of, for example, accessing and/or switching can be improved. In addition, the plural number of information recording mediums 207 themselves can also be connected to each other.

An information recording medium of this invention has been demonstrated through various Examples thereinbefore. A Zr-Cr-O based material-layer and/or a Zr-Cr-Zn-O based material-layer can be used for both an information recording medium recorded with optical means and an information recording medium recorded with electric means. According to an information recording medium of this invention, excellent effects are obtained compared with the information recording medium in the prior art.

## Claims

1. An information recording medium comprising:
a substrate (1),
a recording layer (4) wherein a phase change between a crystal phase and an amorphous phase is generated by irradiation of light or application of an electric energy; and
a Zr-Cr-O-based material layer (2,6) comprising Zr, Cr, and O wherein the content of Zr is 30 atomic % or less and the content of Cr is in the range of 7 atomic % to 37 atomic %.

2. The information recording medium according to claim 1, wherein the Zr-Cr-O-based material layer consists essentially of a material expressed with the formula (1):
Zr_{Q}Cr_{R}O_{100-Q-R} (atomic %) (1)
wherein Q and R are respectively within the range of 0 < Q ≤ 30, and 7 ≤ R ≤ 37, and satisfy 20 ≤ Q+R ≤ 60.

3. The information recording medium according to claim 1, wherein the Zr-Cr-O-based material layer further contains Si and consists essentially of a material expressed with the formula (2):
Zr_{U}Cr_{V}Si_{T}O_{100-U-V-T} (atomic %) (2)
wherein U, V, and T are respectively in the range of 0 < U ≤ 30, 7 ≤ V ≤ 37, and 0 < T ≤ 14, and satisfy 20 ≤ U+V+T ≤ 60.

4. The information recording medium according to claim 1, wherein the Zr-Cr-O-based material layer consists essentially of a material expressed with the formula (11):
(ZrO₂)_{M}(Cr₂O₃)_{100-M} (mol %) (11)
wherein M is in the range of 20 ≤ M ≤ 80.

5. The information recording medium according to claim 2, wherein the Zr-Cr-O-based material containing Si consists essentially of a material expressed with the formula (21):
(ZrO₂)_{X}(Cr₂O₃)_{Y}(SiO₂)_{100-X-Y} (mol %) (21)
wherein X and Y are respectively within the range of 20 ≤ X ≤ 70, and 20 ≤ Y ≤ 60, and satisfy 60 ≤ X+Y ≤ 90.

6. The information recording medium according to claim 5, wherein the material expressed with the formula (21) contains ZrO₂ and SiO₂ at a substantially equal ratio and is expressed with the formula (22):
(ZrSiO₄)_{Z}(Cr₂O₃)_{100-Z} (mol %) (22)
wherein Z is within the range of 25 ≤ Z ≤ 67.

7. An information recording medium comprising:
a substrate (1);
a recording layer (4) wherein a phase change between a crystal phase and an amorphous phase is generated by irradiation of light or application of an electric energy; and
a layer (2,6) which consists essentially of a Zr-Cr-Zn-O-based material expressed with the formula (3) :
(ZrO₂)_{C}(Cr₂O₃)_{E}(D)_{F}(SiO₂)_{100-C-E-F} (mol %) (3)
wherein D is ZnS, ZnSe or ZnO, C, E and F are respectively in the range of 20 ≤ C ≤ 60, 20 ≤ E ≤ 60, and 10 ≤ F ≤ 40, and satisfy 60 ≤ C+E+F ≤ 90.

8. The information recording medium according to claim 7, wherein the material expressed with the formula (3) contains ZrO₂ and SiO₂ at a substantially equal ratio and is expressed with the formula (31):
(ZrSiO₄)_{A}(Cr₂O₃)_{B}(D)_{100-A-B} (mol %) (31)
wherein D is ZnS, ZnSe or ZnO, A and B are respectively in the range of 25 ≤ A ≤ 54, and 25 ≤ B ≤ 63, and satisfy 50 ≤ A+B ≤ 88.

9. The information recording medium according to claim 1, wherein the phase change is generated reversibly in the recording layer.

10. The information recording medium according to claim 7, wherein the phase change is generated reversibly in the recording layer.

11. The information recording medium according to claim 9, wherein the recording layer (4) comprises a material selected from Ge-Sb-Te, Ge-Sn-Sb-Te, Ge-Bi-Te, Ge-Sn-Bi-Te, Ge-Sb-Bi-Te, Ge-Sn-Sb-Bi-Te, Ag-In-Sb-Te and Sb-Te.

12. The information recording medium according to claim 10, wherein the recording layer (4) comprises a material selected from Ge-Sb-Te, Ge-Sn-Sb-Te, Ge-Bi-Te, Ge-Sn-Bi-Te, Ge-Sb-Bi-Te, Ge-Sn-Sb-Bi-Te, Ag-In-Sb-Te and Sb-Te.

13. The information recording medium according to claim 1, wherein the thickness of the recording layer (4) is 15 nm or less.

14. The information recording medium according to claim 7, wherein the thickness of the recording layer is 15 nm or less.

15. The information recording medium according to claim 1, wherein two or more recording layers are provided.

16. The information recording medium according to claim 7, wherein two or more recording layers are provided.

17. The information recording medium according to claim 1, wherein a first dielectric layer, the recording layer, a second dielectric layer, and a reflective layer are formed in this order on one surface of the substrate, and at least one of the first dielectric layer and the second dielectric layer is the Zr-Cr-O-based material layer which contacts the recording layer.

18. The information recording medium according to claim 7, wherein a first dielectric layer (2), the recording layer (4), a second dielectric layer (6), and a reflective layers (8) are formed in this order on one surface of the substrate (1), and at least one of the first dielectric layer (2) and the second dielectric layer (6) is the layer consisting essentially of the Zr-Cr-Zn-O- based material expressed with the formula (3) which with the recording layer.

19. The information recording medium according to claim 1, wherein a reflective layer (8) a second dielectric layer (6), the recording layer (4) and a first dielectric layer (2) are formed in this order on one surface of the substrate (1), and at least one of the first dielectric layer (2) and the second dielectric layer (6) is the Zr-Cr-O-based material layer which contacts the recording layer (1).

20. The information recording medium according to claim 7, wherein a reflective layer (8), a second dielectric layer (6), the recording layer (4) and a first dielectric layer (2) are formed in this order on one surface of the substrate (1) and at least one of the first dielectric layer (2) and the second dielectric layer (6) is the layer consisting essentially of the Zr-Cr-Zn-O-based material expressed with the formula (3) which contacts the recording layer.

21. A method for producing an information recording medium which comprises a substrate (1), a recording layer (4), and a Zr-Cr-O-based material layer (2,6) comprising Zr, Cr, and O wherein the content of Zr is 30 atomic % or less and the content of Cr is in the range of 7 atomic % to 37 atomic %, the method comprising a process of forming the substrate (1) and the recording layer (4) and a process of forming the Zr-Cr-O- based material layer (2,6) by a sputtering method.

22. The method according to claim 21, wherein a sputtering target consisting essentially of a material expressed with the formula (10):
Zr_{J}Cr_{K}O_{100-J-K} (atomic %) (10)
wherein J and K are respectively within the range of 3 ≤ J ≤ 24, and 11 ≤ K ≤ 36, and satisfy 34 ≤ J+K ≤ 40, is used in the process of forming the Zr-Cr-O-based material layer by the sputtering method.

23. The method according to claim 21, wherein a sputtering target consisting essentially of a material expressed with the formula (20):
Zr_{G}Cr_{H}Si_{L}O_{100-G-H-L} (atomic %) (20)
wherein G, H, and L are respectively within the range of 4 ≤ G ≤ 21, 11 ≤ H ≤ 30, and 2 ≤ L ≤ 12, and satisfy 34 ≤ G+H+L ≤ 40, is used to form a Zr-Cr-O-based material layer containing Si in the process of forming the Zr-Cr-O-based material layer by the sputtering method.

24. The method according to claim 21, wherein a sputtering target consisting essentially of a material expressed with the formula (110):
(ZrO₂)ₘ (Cr₂O₃)₁₀₀₋ₘ (mol %) (110)
wherein m is within the range of 20 ≤ m ≤ 80, is used in the process of forming the Zr-Cr-O-based material layer by the sputtering method.

25. The method according to claim 21, wherein a sputtering target consisting essentially of a material expressed with the formula (210):
(ZrO₂)ₓ(Cr₂O₃)_{y}(SiO₂)_{100-x-y} (mol %) (210)
wherein x and y are respectively within the range of 20 ≤ x ≤ 70, and 20 ≤ y ≤ 60, and satisfy 60 ≤ x+y ≤ 90, is used to form a Zr-Cr-O-based material layer containing Si in the process of forming the Zr-Cr-O-based material layer by the sputtering method.

26. The method according to claim 25, wherein the material expressed with the formula (210) contains ZrO₂ and SiO₂ at a substantially equal ratio and is expressed with the formula (220):
(ZrSiO₄)_{z} (Cr₂O₃)_{100-z} (mol %) (220)
wherein z is within the range of 25 ≤ z ≤ 67.

27. A method for producing an information recording medium which comprises a substrate (1), a recording layer (4), and a layer (2,6) consisting essentially of a Zr-Cr-Zn-O-based material, the method comprising a process of forming the substrate (1), the recording layer (4) and the layer (2,6) consisting essentially of the Zr-Cr-Zn-O-based material by a sputtering method using a sputtering target consisting essentially of a material expressed with the formula (30):
(ZrO₂)_{c}(Cr₂O₃)ₑ(D)_{f}(SiO₂)_{100-c-e-f} (mol %) (30)
wherein, D is ZnS, ZnSe, or ZnO, c, e, and f are respectively within the range of 20 ≤ c ≤ 60, 20 ≤ e ≤ 60, and 10 ≤ f ≤ 40, and satisfy 60 ≤ c+e+f ≤ 90.

28. The method according to claim 27, wherein the material expressed with the formula (30) contains ZrO₂ and SiO₂ at a substantially equal ratio and is expressed with the formula (310):
(ZrSiO₄)ₐ(Cr₂O₃)_{b}(D)_{100-a-b} (mol %) (310)
wherein D is ZnS, ZnSe, or ZnO, a and b are respectively within the range of 25 ≤ a ≤ 54 and 25 ≤ b ≤ 63, and satisfy 50 ≤ a+b ≤ 88.

## Patentansprüche

1. Informationsaufzeichnungsmedium, aufweisend:
ein Substrat (1),
eine Aufzeichnungsschicht (4), in der durch Bestrahlung mit Licht oder Anwendung von elektrischer Energie eine Phasenänderung zwischen einer Kristallphase und einer amorphen Phase erzeugt wird, und
eine Materialschicht (2, 6) auf Basis von Zr-Cr-O, enthaltend Zr, Cr und O, wobei der Gehalt an Zr maximal 30 Atom-% beträgt und der Gehalt an Cr im Bereich von 7 Atom-% bis 37 Atom-% liegt.

2. Informationsaufzeichnungsmedium nach Anspruch 1,
bei dem die Materialschicht auf Zr-Cr-O-Basis im wesentlichen aus einem Material besteht, das durch die Formel (1):
Zr_{Q}Cr_{R}O_{100-Q-R} (Atom-%) (1)
ausgedrückt werden kann, wobei Q und R im Bereich von 0 < Q ≤ 30 bzw. 7 ≤ R ≤ 37 liegen und der Ungleichung 20 ≤ Q+R ≤ 60 genügen.

3. Informationsaufzeichnungsmedium nach Anspruch 1,
bei dem die Materialschicht auf Zr-Cr-O-Basis außerdem Si enthält und im wesentlichen aus einem Material besteht, das durch die Formel (2):
Zr_{U}Cr_{V}Si_{T}O_{100-U-V-T} (Atom-%) (2)
ausgedrückt werden kann, wobei U, V und T im Bereich von 0 < U ≤ 30 bzw. 7 ≤ V ≤ 37 bzw. 0 < T ≤ 14 liegen und der Ungleichung 20 ≤ U+V+T ≤ 60 genügen.

4. Informationsaufzeichnungsmedium nach Anspruch 1,
bei dem die Materialschicht auf Zr-Cr-O-Basis im wesentlichen aus einem Material besteht, das durch die Formel (11):
(ZrO₂)_{M}(Cr₂O₃)_{100-M} (Mol-%) (11)
ausgedrückt werden kann, wobei M im Bereich von 20 ≤ M ≤ 80 liegt.

5. Informationsaufzeichnungsmedium nach Anspruch 2,
bei dem das Si enthaltende Material auf Zr-Cr-O-Basis im wesentlichen aus einem Material besteht, das durch die Formel (21):
(ZrO₂)_{X}(Cr₂O₃)_{Y}(SiO₂)_{100-X-Y} (Mol-%) (21)
ausgedrückt werden kann, wobei X und Y im Bereich von 20 ≤ X ≤ 70 bzw. 20 ≤ Y ≤ 60 liegen und der Ungleichung 60 ≤ X+Y ≤ 90 genügen.

6. Informationsaufzeichnungsmedium nach Anspruch 5,
bei dem das durch die Formel (21) ausgedrückte Material ZrO₂ und SiO₂ zu im wesentlichen gleichen Teilen enthält und durch die Formel (22):
(ZrSiO₄)_{Z}(Cr₂O₃)_{100-Z} (Mol-%) (22)
ausgedrückt werden kann, wobei Z im Bereich von 25 ≤ Z ≤ 67 liegt.

7. Informationsaufzeichnungsmedium, aufweisend:
ein Substrat (1),
eine Aufzeichnungsschicht (4), in der durch Bestrahlung mit Licht oder Anwendung von elektrischer Energie eine Phasenänderung zwischen einer Kristallphase und einer amorphen Phase erzeugt wird, und
eine Schicht (2, 6), die im wesentlichen aus einem Material auf Basis von Zr-Cr-Zn-O besteht, das durch die Formel (3):
(ZrO₂)_{C}(Cr₂O₃)_{E}(D)_{F}(SiO₂)_{100-C-E-F} (Mol-%) (3)
ausgedrückt werden kann, wobei D ZnS, ZnSe oder ZnO ist und C, E und F im Bereich von 20 ≤ C ≤ 60 bzw. 20 ≤ E ≤ 60 bzw. 10 ≤ F ≤ 40 liegen und der Ungleichung 60 ≤ C+E+F ≤ 90 genügen.

8. Informationsaufzeichnungsmedium nach Anspruch 7,
bei dem das durch die Formel (3) ausgedrückte Material ZrO₂ und SiO₂ zu im wesentlichen gleichen Teilen enthält und durch die Formel (31):
(ZrSiO₄)_{A}(Cr₂O₃)_{B}(D)_{100-A-B} (Mol-%) (31)
ausgedrückt werden kann, wobei D ZnS, ZnSe oder ZnO ist und A und B im Bereich von 25 ≤ A ≤ 54 bzw. 25 ≤ B ≤ 63 liegen und der Ungleichung 50 ≤ A+B ≤ 88 genügen.

9. Informationsaufzeichnungsmedium nach Anspruch 1,
bei dem die Phasenänderung in der Aufzeichnungsschicht reversibel bewirkt wird.

10. Informationsaufzeichnungsmedium nach Anspruch 7,
bei dem die Phasenänderung in der Aufzeichnungsschicht reversibel bewirkt wird.

11. Informationsaufzeichnungsmedium nach Anspruch 9,
bei dem die Aufzeichnungsschicht (4) ein Material umfasst, das ausgewählt ist aus Ge-Sb-Te, Ge-Sn-Sb-Te, Ge-Bi-Te, Ge-Sn-Bi-Te, Ge-Sb-Bi-Te, Ge-Sn-Sb-Bi-Te, Ag-In-Sb-Te und Sb-Te.

12. Informationsaufzeichnungsmedium nach Anspruch 10,
bei dem die Aufzeichnungsschicht (4) ein Material umfasst, das ausgewählt ist aus Ge-Sb-Te, Ge-Sn-Sb-Te, Ge-Bi-Te, Ge-Sn-Bi-Te, Ge-Sb-Bi-Te, Ge-Sn-Sb-Bi-Te, Ag-In-Sb-Te und Sb-Te.

13. Informationsaufzeichnungsmedium nach Anspruch 1,
bei dem die Dicke der Aufzeichnungsschicht (4) maximal 15 nm beträgt.

14. Informationsaufzeichnungsmedium nach Anspruch 7,
bei dem die Dicke der Aufzeichnungsschicht maximal 15 nm beträgt.

15. Informationsaufzeichnungsmedium nach Anspruch 1,
bei dem zwei oder mehr Aufzeichnungsschichten vorgesehen sind.

16. Informationsaufzeichnungsmedium nach Anspruch 7,
bei dem zwei oder mehr Aufzeichnungsschichten vorgesehen sind.

17. Informationsaufzeichnungsmedium nach Anspruch 1,
bei dem auf einer Oberfläche des Substrats eine erste dielektrische Schicht, die Aufzeichnungsschicht, eine zweite dielektrische Schicht und eine Reflexionsschicht in dieser Reihenfolge gebildet sind und von der ersten und der zweiten dielektrischen Schicht mindestens eine die Materialschicht auf Zr-Cr-O-Basis ist, die im Kontakt mit der Aufzeichnungsschicht steht.

18. Informationsaufzeichnungsmedium nach Anspruch 7,
bei dem auf einer Oberfläche des Substrats (1) eine erste dielektrische Schicht (2), die Aufzeichnungsschicht (4), eine zweite dielektrische Schicht (6) und eine Reflexionsschicht (8) in dieser Reihenfolge gebildet sind und von der ersten (2) und der zweiten dielektrischen Schicht (6) mindestens eine die Schicht ist, die im wesentlichen aus dem Material auf Zr-Cr-Zn-O-Basis besteht, das durch die Formel (3) ausgedrückt wird, und im Kontakt mit der Aufzeichnungsschicht steht.

19. Informationsaufzeichnungsmedium nach Anspruch 1,
bei dem auf einer Oberfläche des Substrats (1) eine Reflexionsschicht (8), eine zweite dielektrische Schicht (6), die Aufzeichnungsschicht (4) und eine erste dielektrische Schicht (2) in dieser Reihenfolge ausgebildet sind und von der ersten dielektrischen Schicht (2) und der zweiten dielektrischen Schicht (6) mindestens eine die Materialschicht auf Zr-Cr-O-Basis ist, die im Kontakt mit der Aufzeichnungsschicht (4) steht.

20. Informationsaufzeichnungsmedium nach Anspruch 7,
bei dem auf einer Oberfläche des Substrats (1) eine Reflexionsschicht (8), eine zweite dielektrische Schicht (6), die Aufzeichnungsschicht (4) und eine erste dielektrische Schicht (2) in dieser Reihenfolge gebildet sind und von der ersten dielektrischen Schicht (2) und der zweiten dielektrischen Schicht (6) mindestens eine die Schicht ist, die im wesentlichen aus dem Material auf Zr-Cr-Zn-O-Basis besteht, das durch die Formel (3) ausgedrückt wird, und die im Kontakt mit der Aufzeichnungsschicht steht.

21. Verfahren zur Herstellung eines Informationsaufzeichnungsmediums, das ein Substrat (1), eine Aufzeichnungsschicht (4) und eine Materialschicht (2, 6) auf Basis von Zr-Cr-O, die Zr, Cr und O umfasst, wobei der Gehalt an Zr maximal 30 Atom-% beträgt und der Gehalt an Cr im Bereich von 7 Atom-% bis 37 Atom-% liegt, wobei das Verfahren umfasst:
den Schritt des Herstellens des Substrats (1) und der Aufzeichnungsschicht (4) und
den Schritt des Herstellens der Materialschicht (2, 6) auf Basis von Zr-Cr-O nach einem Sputterverfahren.

22. Verfahren nach Anspruch 21,
bei dem im Schritt des Herstellens der Materialschicht auf Zr-Cr-O-Basis nach dem Sputterverfahren ein Sputtertarget verwendet wird, das im wesentlichen aus einem Material besteht, das durch die Formel (10):
Zr_{J}Cr_{K}O_{100-J-K} (Atom-%) (10)
ausgedrückt werden kann, wobei J und K im Bereich von 3 ≤ J ≤ 24 bzw. 11 ≤ K ≤ 36 liegen und der Ungleichung 34 ≤ J+K ≤ 40 genügen.

23. Verfahren nach Anspruch 21,
wobei ein Sputtertarget, das im wesentlichen aus einem Material besteht, das durch die Formel (20):
Zr_{G}Cr_{H}Si_{L}O_{100-G-H-L} (Atom-%) (20)
ausgedrückt werden kann, wobei G, H und L jeweils im Bereich von 4 ≤ G ≤ 21 bzw. 11 ≤ H ≤ 30 bzw. 2 ≤ L ≤ 12 liegen und der Ungleichung 34 ≤ G+H+L ≤ 40 genügen, verwendet wird, um im Schritt des Herstellens der Materialschicht auf Basis von Zr-Cr-O nach dem Sputterverfahren die Si enthaltende Materialschicht auf Basis von Zr-Cr-O zu bilden.

24. Verfahren nach Anspruch 21,
wobei ein Sputtertarget, das im wesentlichen aus einem Material besteht, das durch die Formel (110):
(ZrO₂)ₘ(Cr₂O₃)₁₀₀₋ₘ (Mol-%) (110)
ausgedrückt werden kann, wobei m im Bereich von 20 ≤ m ≤ 80 liegt, im Schritt des Herstellens der Materialschicht auf Zr-Cr-O-Basis nach dem Sputterverfahren verwendet wird.

25. Verfahren nach Anspruch 21,
wobei ein Sputtertarget, das im wesentlichen aus einem Material besteht, das durch die Formel (210):
(ZrO₂)ₓ(Cr₂O₃)_{y}(SiO₂)_{100-x-y} (Mol-%) (210)
ausgedrückt werden kann, wobei x und y im Bereich von 20 ≤ x ≤ 70 bzw. 20 ≤ y ≤ 60 liegen und der Ungleichung 60 ≤ x+y ≤ 90 genügen, verwendet wird, um im Schritt des Herstellens der Materialschicht auf Zr-Cr-O-Basis nach dem Sputterverfahren die Si enthaltende Materialschicht auf Zr-Cr-O-Basis zu bilden.

26. Verfahren nach Anspruch 25,
wobei das durch die Formel (210) ausgedrückte Material ZrO₂ und SiO₂ zu im wesentlichen gleichen Teilen enthält und durch die Formel (220):
(ZrSiO₄)_{z}(Cr₂O₃)_{100-z} (Mol-%) (220)
ausgedrückt werden kann, wobei z im Bereich von 25 ≤ z ≤ 67 liegt.

27. Verfahren zum Herstellen eines Informationsaufzeichnungsmediums, aufweisend ein Substrat (1), eine Aufzeichnungsschicht (4) und eine Schicht (2, 6), die im wesentlichen aus einem Material auf Basis von Zr-Cr-Zn-O besteht, wobei das Verfahren einen Schritt des Herstellens des Substrats (1), der Aufzeichnungsschicht (4) und der Schicht (2, 6), die im wesentlichen aus dem Material auf Basis von Zr-Cr-Zn-O besteht, nach dem Sputterverfahren unter Verwendung eines Sputtertargets, das im wesentlichen aus einem Material besteht, das durch die Formel (30):
(ZrO₂)_{c}(Cr₂O₃)ₑ(D)_{f}(SiO₂)_{100-c-e-f} (Mol-%) (30)
ausgedrückt werden kann, wobei D ZnS, ZnSe oder ZnO ist und c, e und f im Bereich von 20 ≤ c ≤ 60 bzw. 20 ≤ e ≤ 60 bzw. 10 ≤ f ≤ 40 liegen und der Ungleichung 60 ≤ c+e+f ≤ 90 genügen, enthält.

28. Verfahren nach Anspruch 27,
wobei das durch die Formel (30) ausgedrückte Material ZrO₂ und SiO₂ zu im wesentlichen gleichen Teilen enthält und durch die Formel (310):
(ZrSiO₄)ₐ(Cr₂O₃)_{b}(D)_{100-a-b} (Mol-%) (310)
ausgedrückt werden kann, wobei D ZnS, ZnSe oder ZnO ist und a und b im Bereich von 25 ≤ a ≤ 54 bzw. 25 ≤ b ≤ 63 liegen und der Ungleichung 50 ≤ a+b ≤ 88 genügen.

## Revendications

1. Support d'enregistrement d'informations comprenant :
un substrat (1),
une couche d'enregistrement (4) dans laquelle un changement de phase entre une phase cristalline et une phase amorphe est généré par un rayonnement de lumière ou une application d'une énergie électrique, et
une couche de matériau à base de Zr-Cr-O (2, 6) comprenant du Zr, Cr et O, dans lequel la teneur en Zr est de 30 % atomique ou moins et la teneur en Cr est dans la plage de 7 % atomique à 37 % atomique.

2. Support d'enregistrement d'informations selon la revendication 1, dans lequel la couche de matériau à base de Zr-Cr-O est constituée essentiellement d'un matériau représenté par la formule (1) :
Zr_{Q}Cr_{R}O_{100-Q-R} (% atomique) (1)
dans laquelle Q et R sont respectivement dans la plage de 0 < Q ≤ 30, et 7 ≤ R ≤ 37, et satisfont la relation 20 ≤ Q + R ≤ 60.

3. Support d'enregistrement d'informations selon la revendication 1, dans lequel la couche de matériau à base de Zr-Cr-O contient en outre du Si et est constituée essentiellement d'un matériau représenté par la formule (2) :
Zr_{U}Cr_{V}Si_{T}O_{100-U-V-T} (% atomique) (2)
dans laquelle U, V et T sont respectivement dans la plage de 0 < U ≤ 30,7 ≤ V ≤ 37, et 0 < T ≤ 14, et satisfont la relation 20 ≤ U + V + T ≤ 60.

4. Support d'enregistrement d'informations selon la revendication 1, dans lequel la couche de matériau à base de Zr-Cr-O est constituée essentiellement d'un matériau représenté par la formule (11) :
(ZrO₂)_{M}(Cr₂O₃)_{100-M} (% molaire) (11)
dans laquelle M est dans la plage de 20 ≤ M ≤ 80.

5. Support d'enregistrement d'informations selon la revendication 2, dans lequel le matériau à base de Zr-Cr-O contenant du Si est constitué essentiellement d'un matériau représenté par la formule (21) :
(Z_{R}O₂)_{X}(Cr₂O₃)_{Y}(SiO₂)_{100-X-Y} (% molaire) (21)
dans laquelle X et Y sont respectivement dans la plage de 20 ≤ X ≤ 70, et 20 ≤ Y ≤ 60 et satisfont la relation 60 ≤ X + Y ≤ 90.

6. Support d'enregistrement d'informations selon la revendication 5, dans lequel le matériau représenté par la formule (21) contient du ZrO₂ et du SiO₂ à un rapport sensiblement égal et est représenté par la formule (22) :
(ZrSiO₄)_{Z}(Cr₂O₃)_{100-Z} (% molaire) (22)
dans laquelle Z est dans la plage de 25 ≤ Z ≤ 67.

7. Support d'enregistrement d'informations comprenant :
un substrat (1),
une couche d'enregistrement (4), dans laquelle un changement de phase entre une phase cristalline et une phase amorphe est généré par un rayonnement de lumière ou une application d'une énergie électrique, et
une couche (2, 6) qui est constituée essentiellement à base de Zr-Cr-Zn-O représenté par la formule (3) :
(ZrO₂)_{C}(Cr₂O₃)_{E}(D)_{F}(SiO₂)_{100-C-E-F} (% molaire) (3)
dans laquelle D représente ZnS, ZnSe ou ZnO, C, E et F sont respectivement dans la plage de 20 ≤ C ≤ 60, 20 ≤ E ≤ 60, et 10 ≤ F ≤ 40 et satisfont la relation 60 ≤ C + E + F ≤ 90.

8. Support d'enregistrement d'informations selon la revendication 7, dans lequel le matériau représenté par la formule (3) contient du ZrO₂ et du SiO₂ à un rapport sensiblement égal et est représenté par la formule (31) :
(ZrSiO₄)_{A}(Cr₂O₃)_{B}(D)_{100-A-B} (% molaire) (31)
dans laquelle D représente ZnS, ZnSe ou ZnO, A et B sont respectivement dans la plage de 25 ≤ A ≤ 54, et 25 ≤ B ≤ 63 et satisfont la relation 50 ≤ A + B ≤ 88.

9. Support d'enregistrement d'informations selon la revendication 1, dans lequel le changement de phase est engendré de façon réversible dans la couche d'enregistrement.

10. Support d'enregistrement d'informations selon la revendication 7, dans lequel le changement de phase est engendré de façon réversible dans la couche d'enregistrement.

11. Support d'enregistrement d'informations selon la revendication 9, dans lequel la couche d'enregistrement (4) comprend un matériau choisi à partir de Ge-Sb-Te, Ge-Sn-Sb-Te, Ge-Bi-Te, Ge-Sn-Bi-Te, Ge-Sb-Bi-Te, Ge-Sn-Sb-Bi-Te, Ag-In-Sb-Te et Sb-Te.

12. Support d'enregistrement d'informations selon la revendication 10, dans lequel la couche d'enregistrement (4) comprend un matériau choisi parmi Ge-Sb-Te, Ge-Sn-Sb-Te, Ge-Bi-Te, Ge-Sn-Bi-Te, Ge-Sb-Bi-Te, Ge-Sn-Sb-Bi-Te, Ag-In-Sb-Te et Sb-Te.

13. Support d'enregistrement d'informations selon la revendication 1, dans lequel l'épaisseur de la couche d'enregistrement (4) est de 15 nm ou moins.

14. Support d'enregistrement d'informations selon la revendication 7, dans lequel l'épaisseur de la couche d'enregistrement est de 15 nm ou moins.

15. Support d'enregistrement d'informations selon la revendication 1, dans lequel deux ou plusieurs couches d'enregistrement sont prévues.

16. Support d'enregistrement d'informations selon la revendication 7, dans lequel deux couches d'enregistrement ou plus sont prévues.

17. Support d'enregistrement d'informations selon la revendication 1, dans lequel une première couche de diélectrique, la couche d'enregistrement, une seconde couche de diélectrique, et une couche de réflexion sont formées dans cet ordre sur une surface du substrat, et au moins l'une de la première couche de diélectrique et de la seconde couche de diélectrique est une couche de matériau à base de Zr-Cr-O qui est en contact avec la couche d'enregistrement.

18. Support d'enregistrement d'informations selon la revendication 7, dans lequel une première couche de diélectrique (2), la couche d'enregistrement (4), une seconde couche de diélectrique (6), et une couche de réflexion (8) sont formées dans cet ordre sur une surface du substrat (1) et au moins l'une de la première couche de diélectrique (2) et de la seconde couche de diélectrique (6) est la couche constituée essentiellement du matériau à base de Zr-Cr-Zn-O représenté par la formule (3) qui est en contact avec la couche d'enregistrement.

19. Support d'enregistrement d'informations selon la revendication 1, dans lequel une couche de réflexion (8), une seconde couche de diélectrique (6), la couche d'enregistrement (4) et une première couche de diélectrique (2) sont formées dans cet ordre sur une surface du substrat (1), et au moins l'une de la première couche de diélectrique (2) et de la seconde couche de diélectrique (6) est la couche de matériau à base de Zr-Cr-O qui est en contact avec la couche d'enregistrement (1).

20. Support d'enregistrement d'informations selon la revendication 7, dans lequel une couche de réflexion (8), une seconde couche de diélectrique (6), la couche d'enregistrement (4) et une première couche de diélectrique (2) sont formées dans cet ordre sur une surface du substrat (1) et au moins l'une de la première couche de diélectrique (2) et de la seconde couche de diélectrique (6) est la couche constituée essentiellement du matériau à base de Zr-Cr-Zn-O représenté par la formule (3) qui est en contact avec la couche d'enregistrement.

21. Procédé de fabrication d'un support d'enregistrement d'informations qui comprend un substrat (1), une couche d'enregistrement (4) et une couche de matériau à base de Zr-Cr-O (2, 6) comprenant Zr, Cr et 0, dans laquelle la teneur de Zr est de 30 % atomique ou moins et la teneur de Cr est dans la plage de 7% atomique à 37 % atomique, le procédé comprenant un processus consistant à former le substrat (1) et la couche d'enregistrement (4) et un processus consistant à former la couche de matériau à base Zr-Cr-O (2, 6) par un procédé de pulvérisation.

22. Procédé selon la revendication 21, dans lequel une cible de pulvérisation constituée essentiellement d'un matériau représenté par la formule (10) :
Zr_{J}Cr_{K}O_{100-J-K} (% atomique) (10)
dans laquelle J et K sont respectivement dans la plage de 3 ≤ J ≤ 24, et 11 ≤ K ≤ 36, et satisfont la relation 34 ≤ J + K ≤ 40, est utilisée dans le processus de formation de la couche de matériau à base de Zr-Cr-O par le procédé de pulvérisation.

23. Procédé selon la revendication 21, dans lequel une cible de pulvérisation constituée essentiellement d'un matériau représenté par la formule (20) :
Zr_{G}Cr_{H}Si_{L}O_{100-G-H-L} (% atomique) (20)
dans laquelle G, H et L sont respectivement dans la plage de 4 ≤ G ≤ 21, 11 ≤ H ≤ 30, et 2 ≤ L ≤ 12, et satisfont la relation 34 ≤ G + H + L ≤ 40, est utilisée pour former une couche de matériau à base de Zr-Cr-O contenant du Si dans le processus de formation de la couche de matériau à base de Zr-Cr-O par le procédé de pulvérisation.

24. Procédé selon la revendication 21, dans lequel une cible de pulvérisation constituée essentiellement d'un matériau représenté par la formule (110) :
(ZrO₂)ₘ(Cr₂O₃)₁₀₀₋ₘ, (% atomique) (110)
dans laquelle m est dans la plage de 20 ≤ m ≤ 80, est utilisée dans le processus de formation de la couche de matériau à base de Zr-Cr-O par le procédé de pulvérisation.

25. Procédé selon la revendication 21, dans lequel une cible de pulvérisation constituée essentiellement d'un matériau représenté par la formule (210) :
(ZrO₂)ₓ(Cr₂O₃)_{y}(SiO₂)_{100-x-y} (% atomique) (210)
dans laquelle x et y sont respectivement dans la plage de 20 ≤ x ≤ 70, et 20 ≤ y ≤ 60, et satisfont la relation 60 ≤ x + y ≤ 90, est utilisée pour former une couche de matériau à base de Zr-Cr-O contenant du Si dans le processus de formation de la couche de matériau à base de Zr-Cr-O par le procédé de pulvérisation.

26. Procédé selon la revendication 25, dans lequel le matériau représenté par la formule (210) contient du ZrO₂ et du SiO₂ à un rapport sensiblement égal et est représenté par la formule (220) :
(ZrSiO₄)_{z}(Cr₂O₃)_{100-z} (% atomique) (220)
dans laquelle z est dans la plage de 25 ≤ z ≤ 67.

27. Procédé de fabrication d'un support d'enregistrement d'informations qui comprend un substrat (1), une couche d'enregistrement (4) et une couche (2, 6) constituée essentiellement d'un matériau à base de Zr-Cr-Zn-O, le procédé comprenant un processus consistant à former le substrat (1), la couche d'enregistrement (4) et la couche (2, 6) constituée essentiellement du matériau à base de Zr-Cr-Zn-O par un procédé de pulvérisation en utilisant une cible de pulvérisation constituée essentiellement d'un matériau représenté par la formule (30) :
(ZrO₂)_{c}(Cr₂O₃)ₑ(D)_{f}(SiO₂)_{100-c-e-f} (% atomique) (30)
dans laquelle D représente ZnS, ZnSe ou ZnO, c, e et f sont respectivement dans la plage de 20 ≤ c ≤ 60, 20 ≤ e ≤ 60, et 10 ≤ f ≤ 40, et satisfont la relation 60 ≤ c + e + f ≤ 90.

28. Procédé selon la revendication 27, dans lequel le matériau représenté par la formule (30) contient du ZrO₂ et du SiO₂ à un rapport sensiblement égal et est représenté par la formule (310) :
(ZrSiO₄)ₐ(Cr₂O₃)_{b} (D) _{100-a-b} (% atomique) (310)
dans laquelle D représente ZnS, ZnSe ou ZnO, a et b sont respectivement dans la plage de 25 ≤ a ≤ 54 et 25 ≤ b ≤ 63, et satisfont la relation 50 ≤ a + n ≤ 88.
